# EUROPEAN PATENT APPLICATION

(11) **EP 4 336 556 A1**
(43) Date of publication of application: **13.03.2024**
(21) Application number: 23195048.6
(22) Date of filing: 04.09.2023
(51) Int. Cl.: H01L 25/075, H01L 23/00

(54) **DISPLAY DEVICE**

(30) Priority: 05.09.2022 KR 20220112427
(71) Applicant: Samsung Display Co., Ltd., Yongin-si, Gyeonggi-do 17113 (KR)
(72) Inventor: KIM, Geun Tak, Yongin-si, 17113 (KR)
(74) Representative: Marks & Clerk LLP

(57) **Abstract**

A display device includes an organic layer, a first electrode and a second electrode disposed on the organic layer and spaced apart from each other, a first insulating layer disposed on the first electrode and the second electrode, and first light emitting elements disposed on the first insulating layer and disposed between the first electrode and the second electrode. An opening is formed by passing through the first insulating layer and at least one of the first electrode and the second electrode and exposes the organic layer.

## Description

### BACKGROUND

### 1. Technical Field

Embodiments relate to a display device.

### 2. Description of the Related Art

As interest in information display increases and a demand to use portable information media increases, a demand for commercialization of a display device has been increased.

### SUMMARY

Embodiments provide a display device capable of reducing a luminance deviation by uniformly arranging light emitting elements.

However, embodiments of the disclosure are not limited to those set forth herein. The above and other embodiments will become more apparent to one of ordinary skill in the art to which the disclosure pertains by referencing the detailed description of the disclosure given below.

In an embodiment, a display device includes an organic layer, a first electrode and a second electrode disposed on the organic layer and spaced apart from each other, a first insulating layer disposed on the first electrode and the second electrode, and first light emitting elements disposed on the first insulating layer and disposed between the first electrode and the second electrode, and an opening is formed by passing through the first insulating layer and at least one of the first electrode and the second electrode and exposes the organic layer.

The opening passing through the first insulating layer and the at least one of the first electrode and the second electrode may extend between the first electrode and the second electrode (e.g. in a plan view).

The display device may further include a first contact electrode covering first end portions of the first light emitting elements, and a second contact electrode covering second end portions of the first light emitting elements.

A surface of the organic layer exposed by the opening may be liquid repellant.

The surface of the organic layer may include a fluoro group.

The display device may further include a bank defining an emission area, and the opening may divide the emission area into a plurality of sub-areas.

The opening may include: a first opening formed in the second electrode and exposing the organic layer, and a second opening formed in the first insulating layer and overlapping the first opening.

A side surface of the second electrode and a side surface of the first insulating layer may be aligned with each other in the opening.

The display device may further include a second insulating pattern layer disposed on the first light emitting elements, and the second insulating pattern layer may contact the organic layer in the opening.

A width of the second opening of the first insulating layer may be smaller than a width of the first opening of the second electrode, and the first insulating layer may cover a side surface of the second electrode in the opening.

The second electrode may be partially exposed by the second opening of the first insulating layer.

The first light emitting elements may be arranged along an extension direction of the first and second electrodes, and the first opening of the second electrode may include at least one slit that extends in a direction intersecting the extension direction of the first and second electrodes and is formed by partially cutting the second electrode (e.g. partially cuts the second electrode).

The at least one slit of the second electrode may be disposed on a side of the second electrode facing the first electrode.

The opening may include a plurality of slits formed in the second electrode along the extension direction.

The organic layer may further include a first bank pattern layer disposed between a protective layer and the first electrode, and a second bank pattern layer disposed between the protective layer and the second electrode, and at least one of the first and second bank pattern layers may be further exposed by the opening.

A surface of at least one of the first and second bank pattern layers exposed by the opening may be liquid repellant.

The display device may further include a third electrode disposed on the organic layer and spaced apart from the second electrode, and second light emitting elements disposed between the second electrode and the third electrode.

The opening may include a second slit extending along an extension direction of the first to third electrodes and passing through the second electrode.

The display device may further include a color conversion layer disposed on the first light emitting elements and emitting light by converting a wavelength band of light incident from the first light emitting elements, and a color filter disposed on the color conversion layer.

In an embodiment, a display device includes a bank defining an emission area, a first electrode and a second electrode spaced apart from each other in the emission area, an auxiliary bank disposed across the first electrode and the second electrode and dividing the emission area into at least two sub-areas, first light emitting elements disposed between the first electrode and the second electrode, a first contact electrode covering first end portions of the first light emitting elements in the at least two sub-areas, and a second contact electrode covering second end portions of the first light emitting elements in the at least two sub-areas.

A height of an upper surface of the auxiliary bank may be equal to a height of an upper surface of the bank.

A height of an upper surface of the auxiliary bank may be different from a height of an upper surface of the bank.

The height of the upper surface of the auxiliary bank may be lower than the height of the upper surface of the bank.

The auxiliary bank may be disposed on the bank.

In an embodiment, a display device may include an organic layer, a first electrode, a second electrode, a third electrode, and a fourth electrode disposed on the organic layer, extending in a first direction, and sequentially arranged in a second direction intersecting the first direction, a first insulating layer disposed on the first electrode, the second electrode, the third electrode, and the fourth electrode, first light emitting elements disposed on the first insulating layer and disposed between the first electrode and the second electrode, and second light emitting elements disposed on the first insulating layer and disposed between the third electrode and the fourth electrode, and an opening may be formed by passing through the first insulating layer, may expose the organic layer, and may extend between the second electrode and the third electrode in a plan view.

At least some of the above and other features of the invention are set out in the claims.

The display device according to embodiments may include an opening passing through an alignment electrode (and an inorganic layer) in an emission area of a sub-pixel to expose an organic layer thereunder, and the organic layer (or a surface of the organic layer) exposed by the opening may be liquid repellant, and the emission area may be divided into a plurality of sub-areas by the opening or by the organic layer having liquid repellancy. Therefore, light emitting elements may be additionally supplied only to a specific sub-area in which the number of the light emitting elements is insufficient among the sub-areas, and the number of the light emitting elements may be uniformly adjusted for each sub-area. Furthermore, the number of the light emitting elements may be uniform for each sub-pixel. Therefore, a luminance deviation due to a deviation in the number of the light emitting elements may be reduced.

An effect according to embodiments is not limited by the contents above, and more various effects are included in the descriptions.

### BRIEF DESCRIPTION OF THE DRAWINGS

The above and other features of the disclosure will become more apparent by describing in further detail embodiments thereof with reference to the accompanying drawings, in which:
FIG. 1 is a schematic perspective view illustrating a light emitting element according to an embodiment;
FIG. 2 is a schematic cross-sectional view illustrating a light emitting element according to an embodiment;
FIG. 3 is a schematic plan view illustrating a display device according to an embodiment;
FIGS. 4A and 4B are schematic diagrams of equivalent circuits of a pixel included in the display device of FIG. 3;
FIG. 5 is a schematic plan view illustrating an embodiment of a first sub-pixel included in the display device of FIG. 3;
FIG. 6 is a schematic plan view illustrating an embodiment of the first sub-pixel included in the display device of FIG. 3;
FIG. 7A is a schematic cross-sectional view illustrating an embodiment of the first sub-pixel taken along a line I-I' of FIG. 6;
FIG. 7B is a schematic cross-sectional view illustrating an embodiment of the first sub-pixel taken along a line I-I" of FIG. 6;
FIGS. 8A to 8D are schematic cross-sectional views illustrating an embodiment of the first sub-pixel taken along the line I-I' of FIG. 6;
FIGS. 9A to 9C are schematic cross-sectional views illustrating an embodiment of the first sub-pixel taken along the line I-I' of FIG. 6;
FIGS. 10A to 10I are schematic diagrams illustrating a process of manufacturing the display device of FIG. 3;
FIG. 11 is a schematic diagram illustrating an embodiment of a first insulating layer;
FIG. 12 is a schematic diagram illustrating an image obtained by capturing the display device of FIG. 3;
FIG. 13A is a schematic plan view illustrating an embodiment of electrodes included in the first sub-pixel of FIG. 5;
FIG. 13B is a schematic plan view illustrating an embodiment of the first sub-pixel included in the display device of FIG. 3;
FIG. 13C is a schematic cross-sectional view illustrating an embodiment of the first sub-pixel taken along a line II-II' of FIG. 13B;
FIGS. 14A and 14B are schematic plan views illustrating an embodiment of the first sub-pixel included in the display device of FIG. 3;
FIG. 15A is a schematic plan view illustrating an embodiment of the first sub-pixel included in the display device of FIG. 3;
FIG. 15B is a schematic plan view illustrating an embodiment of the first sub-pixel of FIG. 15A;
FIGS. 16A and 16B are schematic cross-sectional views illustrating an embodiment of the first sub-pixel taken along a line IV-IV' of FIG. 15B;
FIG. 17 is a schematic plan view illustrating an embodiment of the first sub-pixel included in the display device of FIG. 3;
FIG. 18 is a cross-sectional view illustrating an embodiment of the first sub-pixel taken along a line V-V' of FIG. 17;
FIGS. 19A to 19C are schematic plan views illustrating an embodiment of the first sub-pixel included in the display device of FIG. 3;
FIG. 20 is a schematic plan view illustrating an embodiment of the first sub-pixel included in the display device of FIG. 3;
FIG. 21 is a schematic plan view illustrating an embodiment of the first sub-pixel included in the display device of FIG. 3;
FIG. 22 is a schematic plan view illustrating an embodiment of the first sub-pixel included in the display device of FIG. 3;
FIG. 23A is a schematic plan view illustrating an embodiment of the first sub-pixel included in the display device of FIG. 3;
FIG. 23B is a schematic plan view illustrating an embodiment of the first sub-pixel included in the display device of FIG. 3;
FIGS. 24A to 24C are schematic plan views illustrating an embodiment of the first sub-pixel included in the display device of FIG. 3;
FIGS. 25A and 25B are schematic plan views illustrating an embodiment of the first sub-pixel included in the display device of FIG. 3;
FIGS. 26A and 26B are schematic plan views illustrating an embodiment of the first sub-pixel included in the display device of FIG. 3;
FIGS. 27A to 27C are schematic plan views illustrating an embodiment of the first sub-pixel included in the display device of FIG. 3; and
FIG. 28 is a schematic plan view illustrating an embodiment of the first sub-pixel included in the display device of FIG. 3.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are nonlimiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, a display device according to an embodiment of the disclosure is described with reference to drawings related to embodiments of the disclosure.

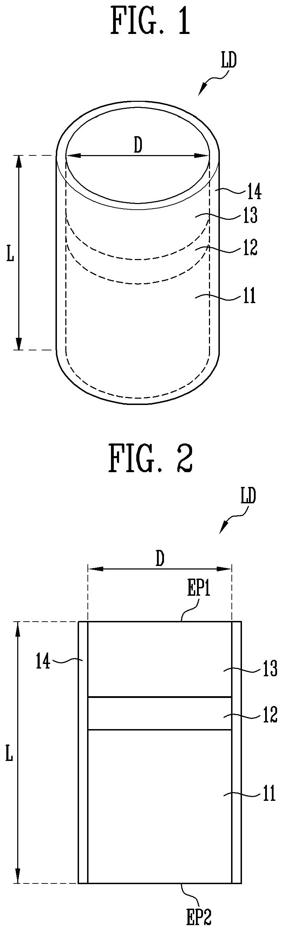

FIG. 1 is a schematic perspective view illustrating a light emitting element according to an embodiment. FIG. 2 is a schematic cross-sectional view illustrating a light emitting element according to an embodiment. FIGS. 1 and 2 show a column shape light emitting element LD, but a type and/or a shape of the light emitting element LD are/is not limited thereto.

Referring to FIGS. 1 and 2, the light emitting element LD may include a first semiconductor layer 11, an active layer 12, and a second semiconductor layer 13. In case that an extension direction of the light emitting element LD is a length direction, the first semiconductor layer 11, the active layer 12, and the second semiconductor layer 13 may be sequentially stacked along the length direction.

The light emitting element LD may be provided in a column shape extending along a direction. The light emitting element LD may have a first end portion EP1 and a second end portion EP2. One of the first and second semiconductor layers 11 and 13 may be disposed at the first end portion EP1 of the light emitting element LD. The other of the first and second semiconductor layers 11 and 13 may be disposed at the second end portion EP2 of the light emitting element LD.

According to an embodiment, the light emitting element LD may be a light emitting element manufactured in a column shape through an etching method or the like. In the descriptions, the column shape may include a rod-like shape or a bar-like shape that is long in the length direction (e.g., an aspect ratio is greater than 1), such as a circular column or a polygonal column, and a shape of a cross-section thereof is not limited thereto. For example, a length L of the light emitting element LD may be greater than a diameter D (or a width in the cross-section).

The light emitting element LD may have a size as small as a nanometer scale to a micrometer scale. For example, each light emitting element LD may have the diameter D (or width) and/or the length L of a nanometer scale to micrometer scale range. However, a size of the light emitting element LD is not limited thereto, and the size of the light emitting element LD may be variously changed according to a design condition of various devices, e.g., a display device including a light emitting device with the light emitting element LD as a light source.

The first semiconductor layer 11 may be a semiconductor layer of a first conductivity type. For example, the first semiconductor layer 11 may include an n-type semiconductor layer. For example, the first semiconductor layer 11 may include any one of InAlGaN, GaN, AlGaN, InGaN, AIN, and InN, and may include an n-type semiconductor layer doped with a first conductivity type dopant such as Si, Ge, and Sn. However, the material of the first semiconductor layer 11 is not limited thereto, and the first semiconductor layer 11 may be formed of various other materials.

The active layer 12 may be disposed on the first semiconductor layer 11 and may be formed in a single quantum well structure or a multi-quantum well structure. A position of the active layer 12 may be variously changed according to the type of the light emitting element LD. The active layer 12 may include GaN, InGaN, InAlGaN, AlGaN, or AIN, and the active layer 12 may be formed of various other materials. According to an embodiment, a clad layer doped with a conductive dopant may be formed on and/or under the active layer 12. For example, the clad layer may be formed of AlGaN or InAlGaN.

The second semiconductor layer 13 may be disposed on the active layer 12 and may include a semiconductor layer of a type different from that of the first semiconductor layer 11. For example, the second semiconductor layer 13 may include a p-type semiconductor layer. For example, the second semiconductor layer 13 may include at least one semiconductor material among InAlGaN, GaN, AlGaN, InGaN, AIN, and InN, and may include a p-type semiconductor layer doped with a second conductivity type dopant such as Mg. However, the material of the second semiconductor layer 13 is not limited thereto, and the second semiconductor layer 13 may be formed of various other materials.

In case that a voltage equal to or greater than a threshold voltage is applied to end portions (e.g., opposite end portions) of the light emitting element LD, an electron-hole pair may be combined in the active layer 12 and thus the light emitting element LD may emit light. By controlling light emission of the light emitting element LD by such a principle, the light emitting element LD may be used as a light source of various light emitting devices including a pixel of a display device.

The light emitting element LD may further include an insulating layer 14 disposed on a surface. The insulating layer 14 may be formed on the surface of the light emitting element LD to surround an outer circumferential surface of at least active layer 12, and may further surround an area of the first and second semiconductor layers 11 and 13.

According to an embodiment, the insulating layer 14 may expose the end portions (e.g., opposite end portions) of the light emitting element LD having different polarities. For example, the insulating layer 14 may expose an end portion of each of the first and second semiconductor layers 11 and 13 positioned at the first and second end portions EP1 and EP2 of the light emitting element LD. In another example, the insulating layer 14 may expose a side portion of the first and second semiconductor layers 11 and 13 adjacent to the first and second end portions EP1 and EP2 of the light emitting element LD having different polarities.

According to an embodiment, the insulating layer 14 may include at least one insulating material among silicon oxide (SiOₓ), silicon nitride (SiNₓ), silicon oxynitride (SiOₓN_{y}), aluminum oxide (AlOₓ), and titanium oxide (TiOₓ), and may be formed as a single layer or multiple layers (for example, a double layer formed of aluminum oxide (AlOₓ) and silicon oxide (SiOₓ)), but embodiments are not limited thereto. In another example, the insulating layer 14 may be omitted.

In case that the insulating layer 14 is provided to cover a surface of the light emitting element LD, e.g., an outer circumferential surface of the active layer 12, a short circuit occurred between the active layer 12 and a first contact electrode, a second contact electrode, or the like to be described below may be prevented. Accordingly, electrical stability of the light emitting element LD may be ensured or implemented.

For example, in case that the insulating layer 14 is disposed on the surface of the light emitting element LD, a surface defect of the light emitting element LD may be prevented or minimized, thereby improving life and efficiency. For example, also in a case where light emitting elements LD are disposed in close contact with each other, an unwanted short circuit occurred between the light emitting elements LD may be prevented.

In an embodiment, the light emitting element LD may further include an additional component in addition to the first semiconductor layer 11, the active layer 12, the second semiconductor layer 13, and/or the insulating layer 14 surrounding them. For example, the light emitting element LD may further include at least one phosphor layer, active layer, semiconductor layer, and/or electrode layer disposed on one end side of the first semiconductor layer 11, the active layer 12, and/or the second semiconductor layer 13. For example, a contact electrode layer may be disposed at each of first and second end portions EP1 and EP2. Although the column shape light emitting element LD is shown in FIGS. 1 and 2, the type, structure, shape, and/or the like of the light emitting element LD may be variously changed. For example, the light emitting element LD may be formed in a core-shell structure having a polygonal cone shape.

A light emitting device including the light emitting element LD described above may be used in various types of devices that require a light source, including a display device. For example, light emitting elements LD may be disposed in each pixel of a display panel, and the light emitting elements LD may be used as a light source of each pixel. However, an application field of the light emitting element LD is not limited to the above-described example. For example, the light emitting element LD may also be used in other types of devices that require a light source, such as a lighting device.

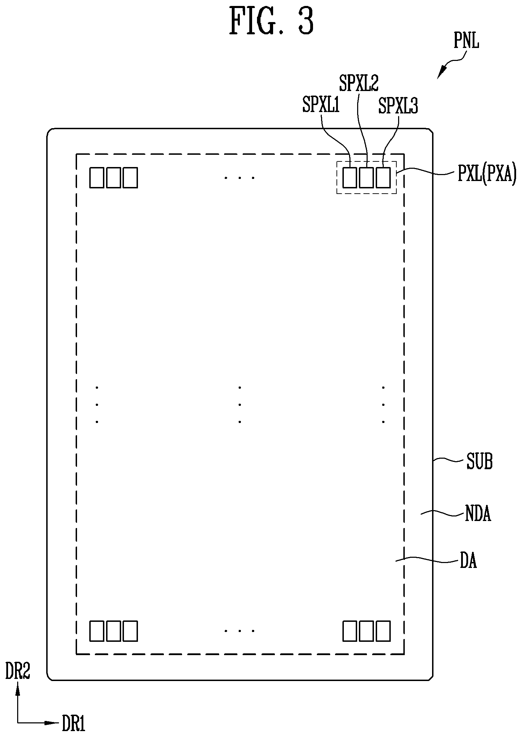

FIG. 3 is a schematic plan view illustrating a display device according to an embodiment. In FIG. 3, as an example of an electronic device that may use the light emitting element LD described in the embodiments of FIGS. 1 and 2 as a light source, a display device, e.g., a display panel PNL provided in the display device is shown.

For convenience of description, in FIG. 3, a structure of the display panel PNL is briefly shown based on a display area DA. However, according to an embodiment, at least one driving circuit unit (for example, at least one of a scan driver and a data driver), lines, and/or pads may be further disposed on the display panel PNL.

In case that the display device is an electronic device in which a display surface is applied to at least one surface, such as a smartphone, a television, a tablet PC, a mobile phone, a video phone, an e-book reader, a desktop PC, a laptop PC, a netbook computer, a workstation, a server, a PDA, a portable multimedia player (PMP), an MP3 player, a medical device, a camera, or a wearable device.

Referring to FIG. 3, the display panel PNL may include a substrate SUB and a pixel PXL.

The substrate SUB may form a base member of the display panel PNL, and may be a rigid or flexible substrate or film. For example, the substrate SUB may be a rigid substrate formed of glass or tempered glass, a flexible substrate (or a thin film) of a plastic or metal material, or an insulating layer of at least one layer. The material and/or a material property of the substrate SUB are/is not limited thereto.

In an embodiment, the substrate SUB may be substantially transparent. Here, "substantially transparent" may mean that light may be transmitted at a certain transmittance or more. In another example, the substrate SUB may be translucent or opaque. For example, the substrate SUB may include a reflective material according to an embodiment.

The display panel PNL (or the substrate SUB of the display panel PNL) may include the display area DA for displaying an image and a non-display area NDA except for the display area DA.

The pixel PXL may be disposed in the display area DA. Various lines, pads, and/or a built-in circuit unit connected to the pixel PXL of the display area DA may be disposed in the non-display area NDA.

The pixel PXL may include sub-pixels SPXL1 to SPXL3, for example, a first sub-pixel SPXL1, a second sub-pixel SPXL2, and a third sub-pixels SPXL3.

Each of the sub-pixels SPXL1 to SPXL3 may emit light of a certain color. According to an embodiment, the sub-pixels SPXL1 to SPXL3 may emit light of different colors. For example, the first sub-pixel SPXL1 may emit light of a first color, the second sub-pixel SPXL2 may emit light of a second color, and the third sub-pixel SPXL3 may emit light of a third color. For example, the first sub-pixel SPXL1 may be a red pixel emitting red light, the second sub-pixel SPXL2 may be a green pixel emitting green light, and the third sub-pixel SPXL3 may be a blue pixel emitting blue light, but embodiments are not limited thereto.

In an embodiment, the first sub-pixel SPXL1, the second sub-pixel SPXL2, and the third sub-pixel SPXL3 may include a light emitting element of the first color, a light emitting element of the second color, and a light emitting element of the third color as a light source, to emit light of the first color, the second color, and the third color, respectively. In another example, the first sub-pixel SPXL1, the second sub-pixel SPXL2, and the third sub-pixel SPXL3 may include light emitting elements that emit light of the same color, and may include a color conversion layer and/or a color filter of different colors disposed on each light emitting element, to emit light of the first color, the second color, and the third color, respectively. However, the color, type, number, and/or the like of the sub-pixels SPXL1 to SPXL3 of each pixel PXL are/is not limited thereto. For example, the color of light emitted by each pixel PXL may be variously changed.

The sub-pixels SPXL1 to SPXL3 may be arranged according to a stripe or PENTILE^{™} arrangement structure, or the like. For example, the first, second, and third sub-pixels SPXL1, SPXL2, and SPXL3 may be sequentially and repeatedly disposed along a first direction DR1 and may be repeatedly disposed along a second direction DR2. At least one of the first, second, and third sub-pixels SPXL1, SPXL2, and SPXL3 disposed adjacent to each other may form a pixel PXL capable of emitting light of various colors. However, an arrangement structure of the sub-pixels SPXL1 to SPXL3 is not limited thereto, and the sub-pixels SPXL1 to SPXL3 may be arranged in the display area DA in various structures and/or methods.

In an embodiment, each of the sub-pixels SPXL1 to SPXL3 may be formed as an active type pixel. For example, each of the sub-pixels SPXL1 to SPXL3 may include at least one light source (for example, light emitting element) driven by a control signal (for example, a scan signal and a data signal) and/or power (for example, first power and second power). However, a type, a structure, and/or a driving method of the sub-pixels SPXL1 to SPXL3 applicable to the display device are not limited thereto.

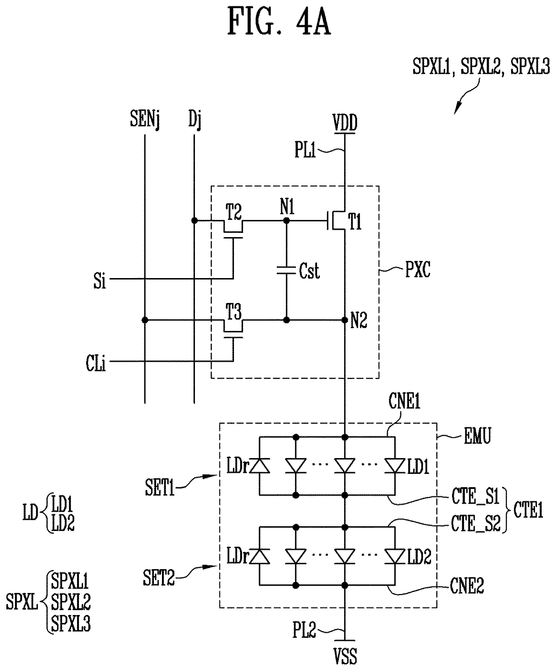

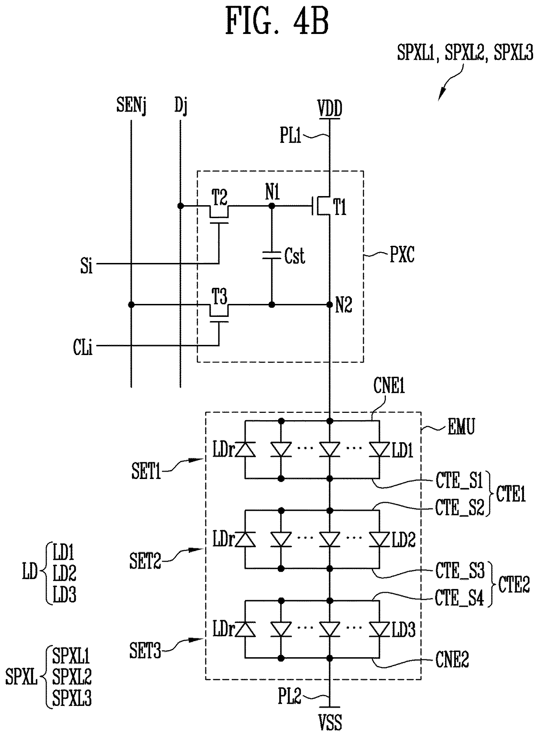

FIGS. 4A and 4B are schematic diagrams of equivalent circuits of the pixel included in the display device of FIG. 3.

For example, FIGS. 4A and 4B show an electrical connection relationship between components included in each of the sub-pixels SPXL1 to SPXL3 applicable to an active matrix type display device according to an embodiment. However, the connection relationship between the components of each of the sub-pixels SPXL1 to SPXL3 is not limited thereto. In the following embodiment, in case that the first sub-pixel SPXL1, the second sub-pixel SPXL2, and the third sub-pixel SPXL3 are collectively referred to, the first sub-pixel SPXL1, the second sub-pixel SPXL2, and the third sub-pixel SPXL3 are be referred to as a sub-pixel SPXL or sub-pixels SPXL.

Referring to FIGS. 3, 4A, and 4B, the sub-pixel SPXL may include a light emitting unit EMU that generates light of a luminance corresponding to a data signal. For example, the sub-pixel SPXL may selectively further include a pixel circuit PXC for driving the light emitting unit EMU.

According to an embodiment, the light emitting unit EMU may include light emitting elements LD connected in parallel between a first power line PL1 and a second power line PL2. The first power line PL1 may be connected to first driving power VDD and thus a voltage of the first driving power VDD may be applied to the first power line PL1. The second power line PL2 may be connected to second driving power VSS and thus a voltage of the second driving power VSS may be applied to the second power line PL2.

For example, the light emitting unit EMU may include a first contact electrode CNE1 (or a first pixel electrode) connected to the first driving power VDD via the pixel circuit PXC and the first power line PL1, a second contact electrode CNE2 (or a second pixel electrode) connected to the second driving power VSS through the second power line PL2, and the light emitting elements LD connected in parallel in the same direction between the first contact electrode CNE1 and the second contact electrode CNE2. In an embodiment, the first contact electrode CNE1 may be an anode, and the second contact electrode CNE2 may be a cathode.

Each of the light emitting elements LD included in the light emitting unit EMU may include a first end portion connected to the first driving power VDD through the first contact electrode CNE1 and a second end portion connected to the second driving power VSS through the second contact electrode CNE2. The first driving power VDD and the second driving power VSS may have different potentials. For example, the first driving power VDD may be set to high potential power, and the second driving power VSS may be set to low potential power. For example, a potential difference between the first and second driving powers VDD and VSS may be set to be greater than or equal to a threshold voltage of the light emitting elements LD during an emission period of each sub-pixel SPXL.

As described above, each light emitting element LD connected in parallel in the same direction (for example, a forward direction) between the first contact electrode CNE1 and the second contact electrode CNE2 to which voltages of different power are supplied may form each effective light source.

The light emitting elements LD of the light emitting unit EMU may emit light with a luminance corresponding to a driving current supplied through a corresponding pixel circuit PXC. For example, the pixel circuit PXC may supply a driving current corresponding to a grayscale value of a corresponding frame data of the pixel circuit PXC to the light emitting unit EMU during each frame period. The driving current supplied to the light emitting unit EMU may be divided and may flow through each of the light emitting elements LD. Accordingly, the light emitting unit EMU may emit light of the luminance corresponding to the driving current in case that each light emitting element LD emits light with a luminance corresponding to a current flowing therethrough.

An embodiment in which the end portions (e.g., opposite end portions) of the light emitting elements LD are connected in the same direction between the first and second driving powers VDD and VSS is described, but embodiments are not limited thereto. According to an embodiment, the light emitting unit EMU may further include at least one ineffective light source, for example, a reverse light emitting element LDr, in addition to the light emitting elements LD of each effective light source. The reverse light emitting element LDr may be connected in parallel between the first and second contact electrodes CNE1 and CNE2 together with the light emitting elements LD of the effective light sources, and may be connected to the first and second contact electrodes CNE1 and CNE2 in a direction opposite to the light emitting elements LD. The reverse light emitting element LDr may maintain an inactive state in case that though a driving voltage (for example, a driving voltage of a forward direction) is applied between the first and second contact electrodes CNE1 and CNE2, and thus a current may not substantially flow through the reverse light emitting element LDr.

The pixel circuit PXC may be connected to a scan line Si and a data line Dj of the sub-pixel SPXL. For example, the pixel circuit PXC may be connected to a control line CLi and a sensing line SENj of the sub-pixel SPXL. For example, in case that the sub-pixel SPXL is disposed in an i-th row and a j-th column of the display area DA, the pixel circuit PXC of the sub-pixel SPXL may be connected to an i-th scan line Si, a j-th data line Dj, an i-th control line CLi, and a j-th sensing line SENj.

The pixel circuit PXC may include transistors T (e.g., T1, T2, and T3) and a storage capacitor Cst.

The first transistor T1 may be a driving transistor for controlling the driving current applied to the light emitting unit EMU, and may be connected between the first driving power VDD and the light emitting unit EMU. For example, a first terminal (or a first transistor electrode) of the first transistor T1 may be electrically connected to the first driving power VDD through the first power line PL1, a second terminal (or a second transistor electrode) of the first transistor T1 may be electrically connected to a second node N2, and a gate electrode of the first transistor T1 may be electrically connected to a first node N1. The first transistor T1 may control an amount of the driving current applied from the first driving power VDD to the light emitting unit EMU through the second node N2, according to a voltage applied to the first node N1. In an embodiment, the first terminal of the first transistor T1 may be a drain electrode, and the second terminal of the first transistor T1 may be a source electrode, but embodiments are not limited thereto. According to an embodiment, the first terminal may be a source electrode and the second terminal may be a drain electrode.

The second transistor T2 may be a switching transistor that selects the sub-pixel SPXL in response to a scan signal and activates the pixel PXL, and may be connected between the data line Dj and the first node N1. A first terminal of the second transistor T2 may be connected to the data line Dj, a second terminal of the second transistor T2 may be connected to the first node N1, and a gate electrode of the second transistor T2 may be connected to the scan line Si. The first terminal and the second terminal of the second transistor T2 may be different terminals. For example, in case that the first terminal is a drain electrode, the second terminal may be a source electrode.

The second transistor T2 may be turned on in case that a scan signal of a gate-on voltage (for example, a high level voltage) is supplied from the scan line Si, to electrically connect the data line Dj and the first node N1. The first node N1 may be a point where the second terminal of the second transistor T2 and the gate electrode of the first transistor T1 are connected, and the second transistor T2 may transfer a data signal to the gate electrode of the first transistor T1.

The third transistor T3 may connect the first transistor T1 to the sensing line SENj. Therefore, a sensing signal through the sensing line SENj may be obtained or sensed, and a characteristic of the sub-pixel SPXL including a threshold voltage and the like of the first transistor T1 may be detected by using the sensing signal. Information on the characteristic of the sub-pixel SPXL may be used to convert image data so that a characteristic deviation between the sub-pixels SPXL may be compensated. A second terminal of the third transistor T3 may be connected to the second terminal of the first transistor T1, a first terminal of the third transistor T3 may be connected to the sensing line SENj, and a gate electrode of the third transistor T3 may be connected to the control line CLi. For example, the first terminal of the third transistor T3 may be connected to initialization power. The third transistor T3 may be an initialization transistor capable of initializing the second node N2, and may be turned on in case that a sensing control signal is supplied from the control line CLi, to transfer a voltage of the initialization power to the second node N2. Accordingly, a second storage electrode of the storage capacitor Cst electrically connected to the second node N2 may be initialized.

The storage capacitor Cst may include a first storage electrode (or a lower electrode) and a second storage electrode (or an upper electrode). The first storage electrode may be electrically connected to the first node N1, and the second storage electrode may be electrically connected to the second node N2. The storage capacitor Cst may charge a data voltage corresponding to the data signal supplied to the first node N1 during one frame period. Accordingly, the storage capacitor Cst may store a voltage corresponding to a voltage difference between a voltage of the gate electrode of the first transistor T1 and a voltage of the second node N2.

The light emitting unit EMU may be formed to include at least one series stage (or stage) including light emitting elements LD electrically connected in parallel to each other. In an embodiment, the light emitting unit EMU may be formed in a series/parallel mixed structure as shown in FIGS. 4A and 4B. For example, as shown in FIG. 4A, the light emitting unit EMU may be formed to include a first series stage SET1 and a second series stage SET2. In another example, as shown in FIG. 4B, the light emitting unit EMU may be formed to include a first series stage SET1, a second series stage SET2, and a third series stage SET3. The number of the series stages included in the light emitting unit EMU may be variously changed. For example, the light emitting unit EMU may include three, four, five or more series stages. In another example, the light emitting unit EMU may include only a single series stage.

Referring to FIG. 4A, the light emitting unit EMU may include the first and second series stages SET1 and SET2 sequentially connected between the first driving power VDD and the second driving power VSS. Each of the first and second series stages SET1 and SET2 may include two electrodes CNE1 and CTE_S1, and two electrodes CTE_S2 and CNE2 of an electrode pair of a corresponding series stage, and light emitting elements LD connected in parallel in the same direction between the two electrodes CNE1 and CTE_S1, and between the two electrodes CTE_S2 and CNE2.

The first series stage SET1 (or a first stage) may include a first contact electrode CNE1 (or a first pixel electrode) and a first sub-intermediate electrode CTE_S1, and at least one first light emitting element LD1 connected between the first contact electrode CNE1 and the first sub-intermediate electrode CTE_S1. For example, the first series stage SET1 may include a reverse light emitting element LDr connected in a direction opposite to the first light emitting element LD1 between the first contact electrode CNE1 and the first sub-intermediate electrode CTE_S1.

The second series stage SET2 (or a second stage) may include a second sub-intermediate electrode CTE_S2 and a second contact electrode CNE2 (or a second pixel electrode), and at least one second light emitting element LD2 connected between the second sub-intermediate electrode CTE_S2 and the second contact electrode CNE2 (or the second pixel electrode). For example, the second series stage SET2 may include a reverse light emitting element LDr connected in a direction opposite to the second light emitting element LD2 between the second sub-intermediate electrode CTE_S2 and the second contact electrode CNE2 (or the second pixel electrode).

The first sub-intermediate electrode CTE_S1 of the first series stage SET1 and the second sub-intermediate electrode CTE_S2 of the second series stage SET2 may be integral with each other to be connected to each other. For example, the first sub-intermediate electrode CTE_S1 and the second sub-intermediate electrode CTE_S2 may form a first intermediate electrode CTE1 (or a contact electrode) electrically connecting the successive first series stage SET1 and second series stage SET2. In case that the first sub-intermediate electrode CTE_S1 and the second sub-intermediate electrode CTE_S2 are integral with each other, the first sub-intermediate electrode CTE_S1 and the second sub-intermediate electrode CTE_S2 may be different areas of the first intermediate electrode CTE1.

In an embodiment, the first contact electrode CNE1 may be an anode of the light emitting unit EMU, and the second contact electrode CNE2 may be a cathode of the light emitting unit EMU.

Referring to FIG. 4B, the light emitting unit EMU may include the first, second, and third series stages SET1, SET2, SET3 sequentially connected between the first driving power VDD and the second driving power VSS. Each of the first, second, and third series stages SET1, SET2, and SET3 may include two electrodes CNE1 and CTE_S1, two electrodes CTE_S2 and CTE_S3, and two electrodes CTE_S4 and CNE2 of an electrode pair of a corresponding series stage, and light emitting elements LD connected in parallel in the same direction between the two electrodes CNE1 and CTE_S1, between the two electrodes CTE_S2 and CTE_S3, and between the two electrodes CTE_S4 and CNE2.

The first series stage SET1 of FIG. 4B may be substantially the same as the first series stage SET1 of FIG. 4A.

The second series stage SET2 (or a second stage) of FIG. 4B may include a second sub-intermediate electrode CTE_S2 and a third sub-intermediate electrode CTE_S3, and at least one second light emitting element LD2 electrically connected between the second sub-intermediate electrode CTE_S2 and the third sub-intermediate electrode CTE_S3.

The third series stage SET3 (or a third stage) may include a fourth sub-intermediate electrode CTE_S4 and a second contact electrode CNE2 (or a second pixel electrode), and at least one third light emitting element LD3 connected between the fourth sub-intermediate electrode CTE_S4 and the second contact electrode CNE2 (or the second pixel electrode).

The third sub-intermediate electrode CTE_S3 of the second series stage SET2 and the fourth sub-intermediate electrode CTE_S4 of the third series stage SET3 may be integral with each other to be connected to each other. In case that the third sub-intermediate electrode CTE_S3 and the fourth sub-intermediate electrode CTE_S4 are integral with each other, the third sub-intermediate electrode CTE_S3 and the fourth sub-intermediate electrode CTE_S4 may be different areas of the second intermediate electrode CTE2.

As described above, the light emitting unit EMU of the sub-pixel SPXL including the series stages SET1 to SET3 (or the light emitting elements LD) connected in a series/parallel mixed structure may easily adjust a driving current/voltage condition according to an applied product specification.

For example, the light emitting unit EMU of the sub-pixel SPXL including the series stages SET1 to SET3 (or the light emitting elements LD) connected in the series/parallel mixed structure may reduce a driving current compared to a light emitting unit of a structure in which the light emitting elements LD are connected only in parallel. For example, the light emitting unit EMU of the sub-pixel SPXL including the series stages SET1 to SET3 connected in the series/parallel mixed structure may reduce a driving voltage applied to end portions (e.g., opposite end portions) of the light emitting unit EMU compared to a light emitting unit of a structure in which all of the same number of light emitting elements LD are connected in series. Furthermore, the light emitting unit EMU of the sub-pixel SPXL including the series stages SET1 to SET3 (or the light emitting elements LD) connected in the series/parallel mixed structure may include a larger number of light emitting elements LD may be included between the same number of contact electrodes CNE1, CTE_S1, CTE_S2, CTE_S3, CTE_S4, and CNE2 as compared to a light emitting unit of a structure in which all series stages (or stages) are connected in series. For example, light output efficiency of the light emitting elements LD may be improved, and although a defect occurs in a specific series stage (or stage), a ratio of the light emitting elements LD that do not emit light due to the defect may be relatively reduced, and thus a decrease of the light output efficiency of the light emitting elements LD may be alleviated or minimized.

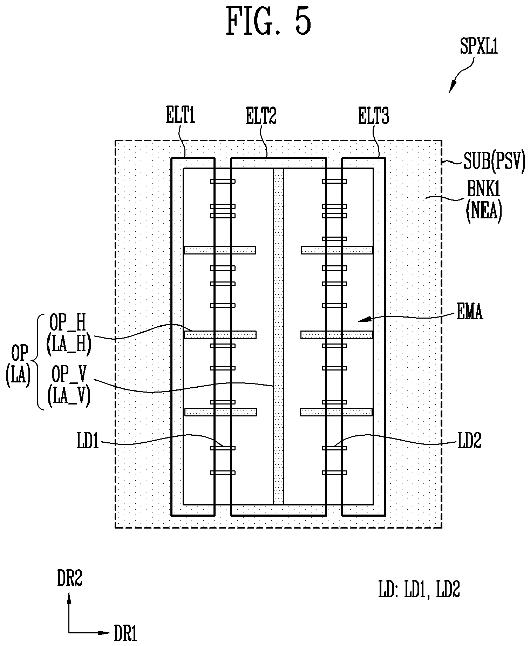

FIG. 5 is a schematic plan view illustrating an embodiment of the first sub-pixel included in the display device of FIG. 3. In FIG. 5, the first sub-pixel SPXL1 of FIG. 3 is briefly shown based on the light emitting unit EMU (refer to FIGS. 4A and 4B). The sub-pixels SPXL1 to SPXL3 of FIG. 3 may have substantially the same light emitting unit EMU.

Referring to FIGS. 3 and 5, the first sub-pixel SPXL1 may be formed in a sub-pixel area (or a pixel area) disposed on the substrate SUB. The sub-pixel area (or the first sub-pixel SPXL1) may include an emission area EMA and a non-emission area NEA except for the emission area EMA. The non-emission area NEA may be an area surrounding the emission area EMA.

The first sub-pixel SPXL1 may include a first bank BNK1, electrodes ELT1 to ELT3 (or alignment electrodes), and a light emitting element LD. The electrodes ELT1 to ELT3 may include a first electrode ELT1, a second electrode ELT2, and a third electrode ELT3, but embodiments are not limited thereto.

The first bank BNK1 may be positioned in the non-emission area NEA. The first bank BNK1 may be a structure defining (or dividing) the emission area EMA of each sub-pixel between the sub-pixels SPXL1 to SPXL3 (refer to FIG. 3). The first bank BNK1 may be a pixel defining layer or a dam structure that defines an area to which the light emitting elements LD are to be supplied in a process of supplying (or injecting) the light emitting elements LD to each of the sub-pixels SPXL1 to SPXL3. For example, the emission area EMA of each of the sub-pixels SPXL1 to SPXL3 may be divided by the first bank BNK1, and thus a mixed solution (for example, an ink) including a certain amount and/or type of light emitting elements LD may be supplied (or input) to the emission area EMA. The first bank BNK1 may be liquid repellant.

Each of the electrodes ELT1 to ELT3 may extend in the second direction DR2, and the electrodes ELT1 to ELT3 may be spaced apart from each other in the first direction DR1. A portion extending in the second direction DR2 of each of the electrodes ELT1 to ELT3 may overlap the first bank BNK1, but embodiments are not limited thereto. For example, at least one of the electrodes ELT1 to ELT3 may not overlap the first bank BNK1.

For example, the electrodes ELT1 to ELT3 of the first sub-pixel SPXL1 may be separated (or spaced apart) from the electrodes ELT1 to ELT3 included in the sub-pixels adjacent to each other in the second direction DR2, respectively, but embodiments are not limited thereto. For example, at least one of the electrodes ELT1 to ELT3 of the first sub-pixel SPXL1 may be connected to a corresponding electrode of a sub-pixel adjacent in the second direction DR2.

The second electrode ELT2 may be spaced apart from the first electrode ELT1 in the first direction DR1. The third electrode ELT3 may be spaced apart from the second electrode ELT2 in the first direction DR1.

The electrodes ELT1 to ELT3 may be used as alignment electrodes by applying an alignment voltage after the mixed solution (for example, the ink) including the light emitting element LD is input to the emission area EMA. The first electrode ELT1 may be a first alignment electrode, the second electrode ELT2 may be a second alignment electrode, and the third electrode ELT3 may be a third alignment electrode. For example, the first light emitting element LD1 may be aligned in a certain direction and/or position by an electric field formed between the first alignment electrode and the second alignment electrode. For example, the second light emitting element LD2 may be aligned in a certain direction and/or position by an electric field formed between the second alignment electrode and the third alignment electrode. According to an embodiment, the electrodes ELT1 to ELT3 may also be used as driving electrodes for driving the light emitting elements LD after the light emitting elements LD are aligned. For example, one of the electrodes ELT1 to ELT3 may form an anode of the light emitting unit EMU, and another one among the electrodes ELT1 to ELT3 may form a cathode of the light emitting unit EMU. For example, the first electrode ELT1 may form the anode of the light emitting unit EMU and may be connected to the first transistor T1 of FIG. 4A through a contact hole or the like. For example, the second electrode ELT2 may form the cathode of the light emitting unit EMU and may be connected to the second power line PL2 of FIG. 4A through a contact hole or the like.

The electrodes ELT1 to ELT3 may have a bar shape extending along the second direction DR2 in a plan view, but embodiments are not limited thereto. The shape of the electrodes ELT1 to ELT3 may be variously changed.

The light emitting elements LD may be disposed between adjacent electrodes among the electrodes ELT1 to ELT3 so that each length direction (refer to FIG. 1) may be substantially parallel to the first direction DR1. For example, the first light emitting element LD1 may be disposed between the first electrode ELT1 and the second electrode ELT2, and the second light emitting element LD2 may be disposed between the second electrode ELT2 and the third electrode ELT3.

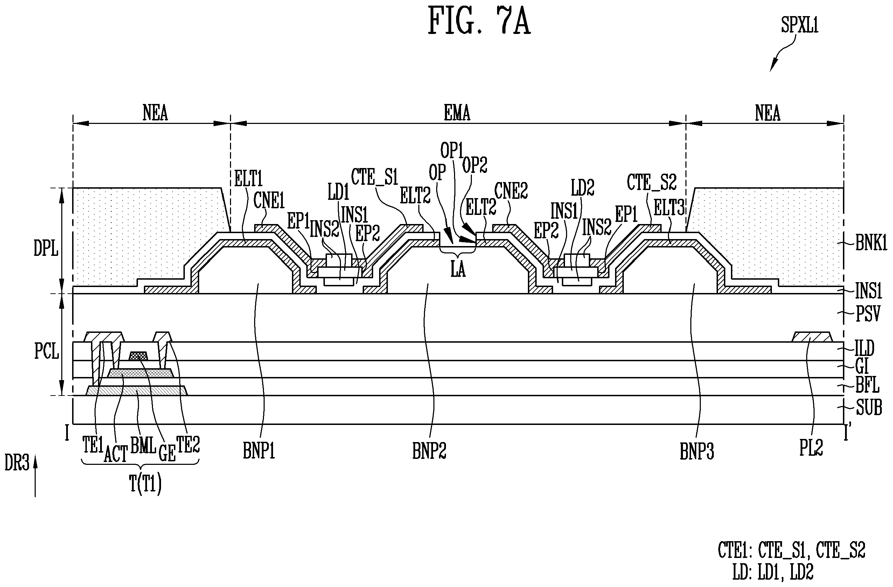

In embodiments, the first sub-pixel SPXL1 may include an opening OP. The opening OP may pass through at least a portion of the electrodes ELT1 to ELT3 to expose lower members (for example, a lower organic insulating layer and/or a lower organic layer). An area LA (for example, a surface of the organic insulating layer) exposed through the opening OP may be liquid repellant. For example, a contact angle of the organic insulating layer and/or organic layer (for example, the protective layer PSV and/or the bank pattern layers BNP1 to BNP3) may be about 60 degrees (e.g. 60 degrees or greater). The area LA is described below with reference to FIG. 7A.

In an embodiment, the opening OP may include a horizontal opening OP_H (or a first sub-opening) and a vertical opening OP_V (or a second sub-opening). The horizontal opening OP_H may have a slit shape extending in the first direction DR1 (or a direction intersecting an extension direction of the electrodes ELT1 to ELT3). The horizontal opening OP_H may be positioned on at least one side of each of the electrodes ELT1 to ELT3, and may partially cut each of the electrodes ELT1 to ELT3. The horizontal opening OP_H may contact at least one side (left/right sides defining the emission area EMA) of the first bank BNK1. A first exposed area LA_H (for example, the surface of the organic insulating layer) exposed by the horizontal opening OP_H may be liquid repellant.

The vertical opening OP_V may have a slit shape extending in the second direction DR2 (or in a direction in which the electrodes ELT1 to ELT3 extend). The vertical opening OP_V may be positioned at a center portion of the second electrode ELT2, and the vertical opening OP_V may contact at least one side of the first bank BNK1 (upper/lower sides defining the emission area EMA). A second exposed area LA_V (for example, the surface of the organic insulating layer) exposed by the vertical opening OP_V may be liquid repellant.

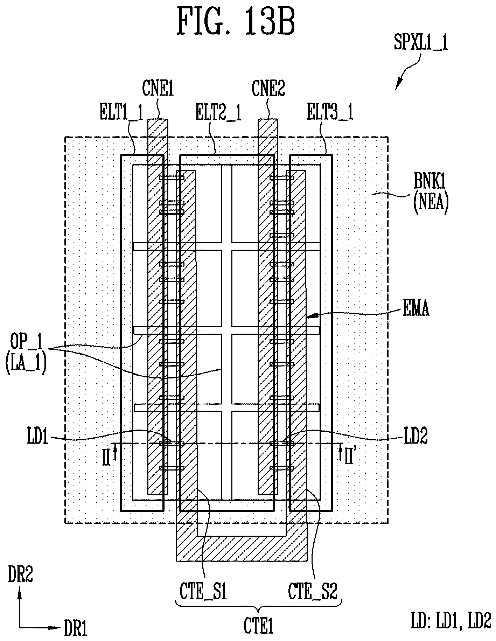

The horizontal opening OP_H (or the first exposed area LA_H) and the vertical opening OP_V (or the second exposed area LA_V) may be spaced apart from each other, but embodiments are not limited thereto. For example, the horizontal opening OP_H and the vertical opening OP_V may be connected (refer to FIG. 13B).

The horizontal opening OP_H and the vertical opening OP_V may divide the emission area EMA into sub-areas. As shown in FIG. 5, the emission area EMA may be divided into eight sub-areas by six horizontal openings OP_H and one vertical opening OP_V. The vertical opening OP_V may divide the first and second series stages SET1 and SET2 (refer to FIG. 4A), and the horizontal opening OP_H may divide each of the first and second series stages SET1 and SET2 into sub-areas. A size or an area of the sub-areas may be the same as each other, but embodiments are not limited thereto.

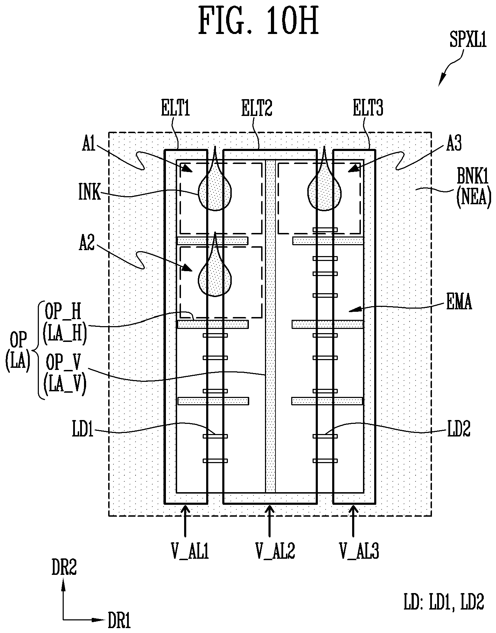

In case that the area LA exposed by the opening OP is liquid repellant, in a process of additionally supplying the light emitting elements LD to one of the sub-areas, a solution including the light emitting elements LD may be prevented from flowing into an adjacent sub-area. The light emitting elements LD may be additionally supplied only to a sub-area in which the number of the light emitting elements LD is insufficient, and thus the number of the light emitting elements LD for each sub-area and, further, the number of the light emitting elements LD for each sub-pixel may be uniformly adjusted. A function of the area LA is described below with reference to FIG. 10H.

As described above, the first sub-pixel SPXL1 may include the opening OP passing through at least a portion of the electrodes ELT1 to ELT3 to expose the lower organic insulating layer (or organic layer), and a partial area LA of the organic insulating layer (or the surface of the organic insulating layer) exposed through the opening OP may be liquid repellant. The area LA may divide the emission area EMA into the sub-areas, and in the process of supplying the light emitting elements LD to one of the sub-areas, the solution including the light emitting elements LD may be prevented from flowing into the adjacent sub-area.

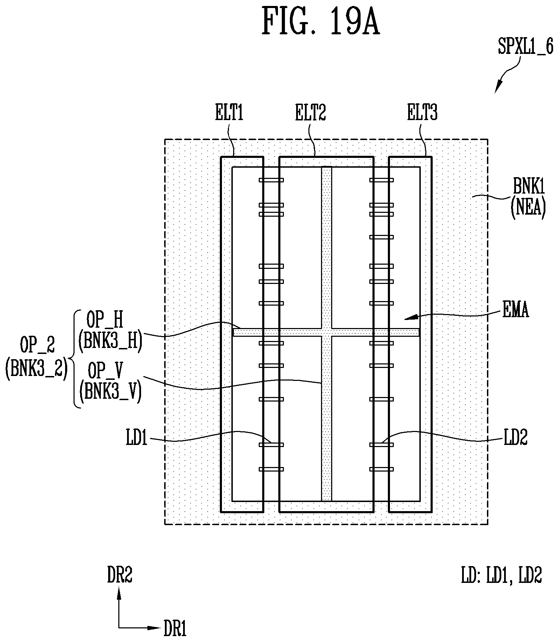

In FIG. 5, the opening OP may include six horizontal openings OP_H and one vertical opening OP_V, but embodiments are not limited thereto. The number of the horizontal openings OP_H and the number of the vertical openings OP_V included in the opening OP may be variously changed (refer to FIGS. 19A to 19C).

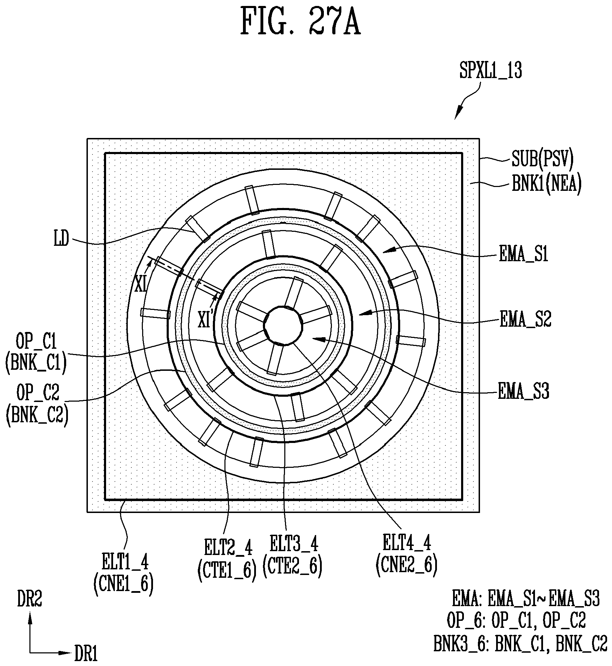

For example, in FIG. 5, the horizontal opening OP_H may extend in the first direction DR1 and the vertical opening OP_V may extend in the second direction DR2, but embodiments are not limited thereto. An extension direction and/or a shape of the horizontal opening OP_H and/or the vertical opening OP_V may be variously changed according to a shape of the sub-areas dividing the emission area EMA (refer to FIG. 27A).

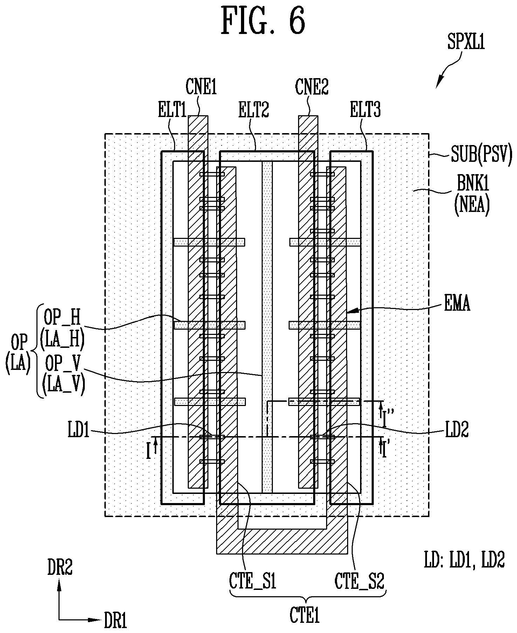

FIG. 6 is a schematic plan view illustrating an embodiment of the first sub-pixel included in the display device of FIG. 3.

Referring to FIGS. 5 and 6, the first sub-pixel SPXL1 may further include the first contact electrode CNE1, the first intermediate electrode CTE1, and the second contact electrode CNE2. For example, the first sub-pixel SPXL1 may have the pixel structure (or two series stages) shown in FIG. 4A. The terms of the contact electrode and the intermediate electrode are used to distinguish the contact electrode and the intermediate electrode from an electrode (or an alignment electrode), and a corresponding element (e.g., an electrode) is not limited by the terms.

The first contact electrode CNE1 may overlap a first end portion of each of the first light emitting elements LD1 and the first electrode ELT1. According to an embodiment, the first contact electrode CNE1 may physically and/or electrically connect the first end portion of the first light emitting element LD1 and the first electrode ELT1. However, embodiments are not limited thereto. For example, the first contact electrode CNE1 may be electrically separated from the first electrode ELT1. The first contact electrode CNE1 may form the anode of the light emitting unit EMU (refer to FIG. 4A) and may be connected to the first transistor T1 of FIG. 4A through a contact hole or the like. The first contact electrode CNE1 may extend in the second direction DR2 in correspondence with the first electrode ELT1.

The first intermediate electrode CTE1 may overlap a second end portion of each of the first light emitting elements LD1 and the second electrode ELT2, and may overlap a first end portion of each of the second light emitting elements LD2 and the third electrode ELT3. The first intermediate electrode CTE1 may physically and/or electrically connect the second end portion of the first light emitting element LD1 and the first end portion of the second light emitting element LD2.

For example, the first sub-intermediate electrode CTE_S1 of the first intermediate electrode CTE1 may overlap the second end portion of each of the first light emitting elements LD1 and the second electrode ELT2, and the second sub-intermediate electrode CTE_S2 of the first intermediate electrode CTE1 may overlap the first end portion of each of the second light emitting elements LD2 and the third electrode ELT3. The first intermediate electrode CTE1 may extend to bypass the second contact electrode CNE2, the first sub-intermediate electrode CTE_S1 may extend in the second direction DR2 in correspondence with the second electrode ELT2, and the second sub-intermediate electrode CTE_S2 may extend in the second direction DR2 in correspondence with the third electrode ELT3.

The second contact electrode CNE2 may overlap a second end portion of each of the second light emitting elements LD2 and the second electrode ELT2. According to an embodiment, the second contact electrode CNE2 may physically and/or electrically connect the second end portion of the second light emitting element LD2 and the second electrode ELT2. However, embodiments are not limited thereto. For example, the second contact electrode CNE2 may be electrically separated from the second electrode ELT2. The second contact electrode CNE2 may form the cathode of the light emitting unit EMU (refer to FIG. 4A) and may be connected to the second power line PL2 of FIG. 4A through a contact hole or the like. The second contact electrode CNE2 may extend in the second direction DR2 in correspondence with the second electrode ELT2.

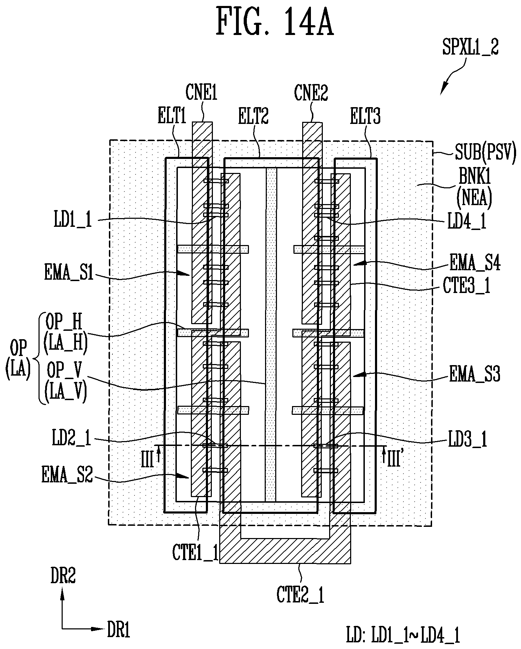

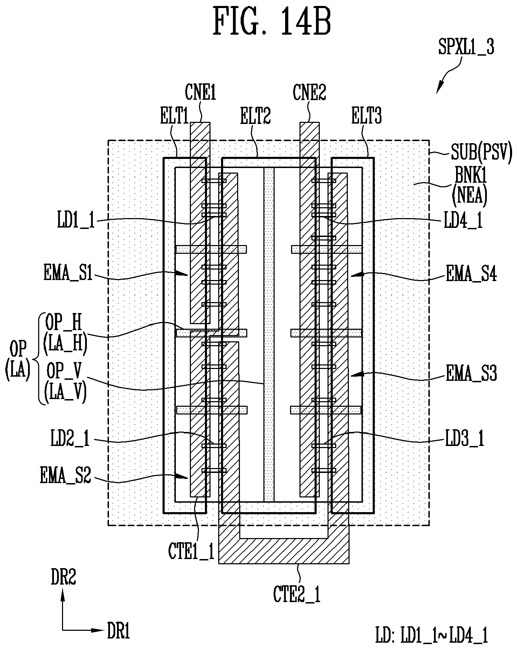

The first contact electrode CNE1, the second contact electrode CNE2, the first sub-intermediate electrode CTE_S1 of the first intermediate electrode CTE1, and the second sub-intermediate electrode CTE_S2 of the first intermediate electrode CTE1 may have a bar shape extending along the second direction DR2 in a plan view, but embodiments are not limited thereto. According to an embodiment, a shape of the first contact electrode CNE1, the second contact electrode CNE2, and the first intermediate electrode CTE1 may be variously changed in case that the first contact electrode CNE1, the second contact electrode CNE2, and the first intermediate electrode CTE1 are electrically and stably connected to each of the light emitting elements LD. For example, the shape of the first contact electrode CNE1, the first intermediate electrode CTE1, and the second contact electrode CNE2 may be variously changed according to a shape of the electrodes ELT1 to ELT3 and/or a pixel structure (or a series/parallel mixed structure, for example, the number of the series stages included in the first sub-pixel SPXL1 (refer to FIGS. 14A and 14B).

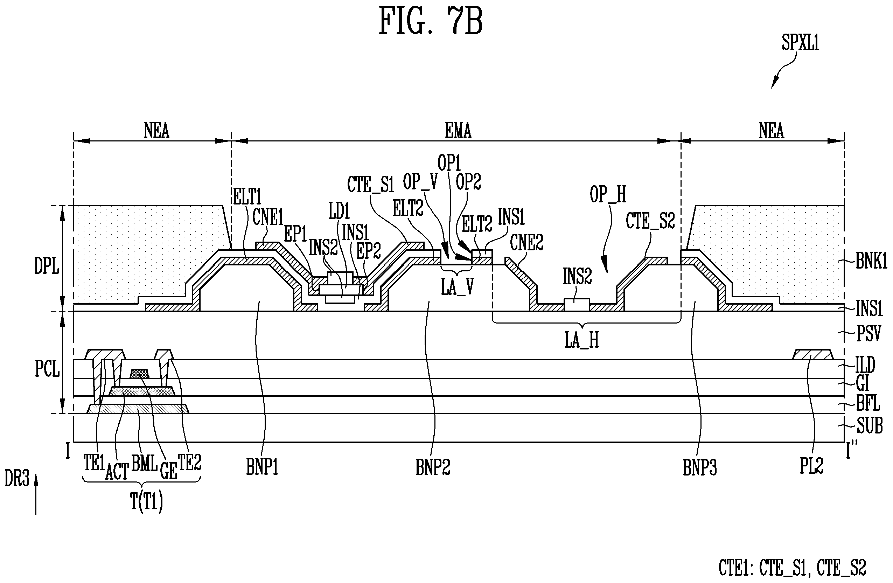

FIG. 7A is a schematic cross-sectional view illustrating an embodiment of the first sub-pixel taken along a line I-I' of FIG. 6. FIG. 7B is a schematic cross-sectional view illustrating an embodiment of the first sub-pixel taken along a line I-I" of FIG. 6.

In FIGS. 7A and 7B, the first sub-pixel SPXL1 (or the sub-pixel) is simplified, such as showing each electrode as a single layer of electrode and each insulating layer as only a single layer of insulating layer, but embodiments are not limited thereto.

Referring to FIGS 5, 6, 7A, and 7B, the first sub-pixel SPXL1 may include a pixel circuit layer PCL and a display element layer DPL disposed on the substrate SUB.

The substrate SUB may form a base member, and may be a rigid or flexible substrate or film. For example, the substrate SUB may be a rigid substrate formed of glass or tempered glass, a flexible substrate (or a thin film) of a plastic or metal material, or an insulating layer of at least one layer. In an embodiment, the substrate SUB may be substantially transparent. Here, "substantially transparent" may mean that light is transmitted at a certain transmittance or more. In another example, the substrate SUB may be translucent or opaque. For example, the substrate SUB may include a reflective material according to an embodiment.

The pixel circuit layer PCL may include a transistor T (e.g., the first transistor T1) and the second power line PL2. For example, the pixel circuit layer PCL may include insulating layers BFL, GI, ILD, and PSV. The first transistor T1 may include a lower conductive layer BML, a semiconductor pattern layer ACT, a gate electrode GE, and first and second transistor electrodes TE1 and TE2.

The lower conductive layer BML may be disposed on the substrate SUB. The lower conductive layer BML may overlap a semiconductor pattern layer ACT of the first transistor T1, and may form a back gate electrode (or lower shielding electrode) of the first transistor T1.

The lower conductive layer BML may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof.

A buffer layer BFL may be disposed on the lower conductive layer BML. The buffer layer BFL may prevent an impurity from diffusing (or permeating) into a circuit element. The buffer layer BFL may be formed as a single layer, but may be formed as multiple layers of at least double or more layers. In case that the buffer layer BFL is formed as multiple layers, each of the multiple layers may be formed of the same material or may be formed of different materials.

The semiconductor pattern layer ACT may be disposed on the buffer layer BFL. For example, each semiconductor pattern layer ACT may include a first region that is in contact with a first transistor electrode TE1, a second region that is in contact with a second transistor electrode TE2, and a channel region positioned between the first and second regions. According to an embodiment, one of the first and second regions may be a source region and the other may be a drain region.

According to an embodiment, the semiconductor pattern layer ACT may be formed of polysilicon, amorphous silicon, oxide semiconductor, or the like. For example, the channel region of the semiconductor pattern layer ACT may be an intrinsic semiconductor as a semiconductor pattern layer that is not doped with an impurity, and each of the first and second regions of the semiconductor pattern layer ACT may be a semiconductor doped with an impurity.

A gate insulating layer GI may be disposed on the buffer layer BFL and the semiconductor pattern layer ACT. For example, the gate insulating layer GI may be disposed between the semiconductor pattern layer ACT and the gate electrode GE. The gate insulating layer GI may be formed as a single layer or multiple layers, and may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The gate electrode GE of the first transistor T1 may be disposed on the gate insulating layer GI. The gate electrode GE may overlap the semiconductor pattern layer ACT in the third direction DR3.

The gate electrode GE may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof. For example, each gate electrode GE may be formed as multiple layers in which titanium (Ti), copper (Cu), and/or indium tin oxide (ITO) are sequentially or repeatedly stacked.

An interlayer insulating layer ILD may be disposed on the gate insulating layer GI and the gate electrode GE. For example, the interlayer insulating layer ILD may be disposed between the gate electrode GE and the first and second transistor electrodes TE1 and TE2.

The interlayer insulating layer ILD may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The first and second transistor electrodes TE1 and TE2 of the first transistor T1 and the second power line PL2 may be disposed on the interlayer insulating layer ILD. The first and second transistor electrodes TE1 and TE2 and the second power line PL2 may be disposed on the same layer (e.g., the interlayer insulating layer ILD). For example, the first and second transistor electrodes TE1 and TE2 and the second power line PL2 may be simultaneously formed by the same process and may be formed of the same conductive material, but embodiments are not limited thereto.

The first and second transistor electrodes TE1 and TE2 may overlap the semiconductor pattern layer ACT in the third direction DR3. The first and second transistor electrodes TE1 and TE2 may be connected (e.g., electrically connected) to the semiconductor pattern layer ACT. For example, the first transistor electrode TE1 may be connected (e.g., electrically connected) to the first region of the semiconductor pattern layer ACT through a contact hole passing through the interlayer insulating layer ILD. For example, the first transistor electrode TE1 may be connected (e.g., electrically connected) to the lower conductive layer BML through a contact hole passing through the interlayer insulating layer ILD and the buffer layer BFL. The second transistor electrode TE2 may be connected (e.g., electrically connected) to the second region of the semiconductor pattern layer ACT through a contact hole passing through the interlayer insulating layer ILD. According to an embodiment, one of the first and second transistor electrodes TE1 and TE2 may be a source electrode, and the other may be a drain electrode.

The second power line PL2 may form the second power line PL2 described with reference to FIG. 4A.

The first and second transistor electrodes TE1 and TE2 may be formed as a single layer or multiple layers formed of molybdenum (Mo), copper (Cu), aluminum (Al), chromium (Cr), gold (Au), titanium (Ti), nickel (Ni), neodymium (Nd), indium (In), tin (Sn), and an oxide or an alloy thereof.

A protective layer PSV (or a via layer) may be disposed on the interlayer insulating layer ILD, the first and second transistor electrodes TE1 and TE2, and the second power line PL2.

The protective layer PSV may be formed of an organic material to planarize a lower step difference. For example, the protective layer PSV may include an organic material such as acrylates resin, epoxy resin, phenolic resin, polyamides resin, polyimides resin, polyester resin, polyphenylenesulfides resin, or benzocyclobutene (BCB). However, embodiments are not limited thereto, and the protective layer PSV may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ). In another example, the insulating layer including the inorganic material may be disposed between the protective layer PSV including the organic material and the first and second transistor electrodes TE1 and TE2.

A display element layer DPL may be disposed on the protective layer PSV. The display element layer DPL may include bank pattern layers BNP1 to BNP3, electrodes ELT1 to ELT3, a first insulating layer INS1, the light emitting element LD, a second insulating layer INS2 (or a second insulating pattern layer), the first and second contact electrodes CNE1 and CNE2, and the first intermediate electrode CTE1.

The bank pattern layers BNP1 to BNP3 may be disposed on the protective layer PSV. The bank pattern layers BNP1 to BNP3 may serve to form a step difference to easily align the light emitting elements LD in the emission area EMA. For example, the bank pattern layers BNP1 to BNP3 may be a support member supporting the electrodes ELT1 to ELT3 to change a surface profile (e.g., a shape or outline) of the electrodes ELT1 to ELT3, so as to guide light emitted from the light emitting elements LD in an image display direction (for example, the third direction DR3) of the display device.

The bank pattern layers BNP1 to BNP3 may have various shapes according to an embodiment. In an embodiment, the bank pattern layers BNP1 to BNP3 may have a shape protruding in the third direction DR3 on the substrate SUB. For example, the bank pattern layers BNP1 to BNP3 may be formed to have an inclined surface (or inclined side surface) inclined at a certain angle with respect to the substrate SUB. However, embodiments are not limited thereto, and the bank pattern layers BNP1 to BNP3 may have a sidewall of a curved surface, a stepped shape, or the like. For example, the bank pattern layers BNP1 to BNP3 may have a cross-section of a semi-circle shape, a semi-ellipse shape, or the like.

The bank pattern layers BNP1 to BNP3 may include at least one organic material and/or inorganic material. For example, the bank pattern layers BNP1 to BNP3 may include an organic material such as acrylates resin, epoxy resin, phenolic resin, polyamides resin, polyimides resin, polyester resin, polyphenylenesulfides resin, or benzocyclobutene (BCB). However, embodiments are not limited thereto, and the bank pattern layers BNP1 to BNP3 may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The electrodes ELT1 to ELT3 may be disposed on the protective layer PSV and the bank pattern layers BNP1 to BNP3. For example, a first electrode ELT1 may be disposed on a first bank pattern layer BNP1, a second electrode ELT2 may be disposed on a second bank pattern layer BNP2, and a third electrode ELT3 may be disposed on a third bank pattern layer BNP3.

The electrodes ELT1 to ELT3 may at least partially cover a side surface and/or an upper surface of the bank pattern layers BNP1 to BNP3. The electrodes ELT1 to ELT3 disposed on the bank pattern layers BNP1 to BNP3 may have a shape corresponding to the bank pattern layers BNP1 to BNP3. For example, the electrodes ELT1 to ELT3 disposed on the bank pattern layers BNP1 to BNP3 may include an inclined surface or a curved surface having a shape corresponding to a shape of the bank pattern layers BNP1 to BNP3. For example, since the bank pattern layers BNP1 to BNP3 and the electrodes ELT1 to ELT3 may guide the light emitted from the light emitting elements LD in a front surface direction of the first sub-pixel SPXL1, e.g., the third direction DR3 by reflecting the light emitted from the light emitting elements LD as a reflective member, the light output efficiency of the display device may be improved.

The electrodes ELT1 to ELT3 may include at least one conductive material. For example, the electrodes ELT1 to ELT3 may include at least one metal among various metal materials including silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), and copper (Cu), an alloy including the same, a conductive oxide such as indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and a conductive polymer such as poly(3,4-ethylenedioxythiophene) (PEDOT), but embodiments are not limited thereto.

The first insulating layer INS1 may be disposed on the protective layer PSV and the electrodes ELT1 to ELT3. The first insulating layer INS1 may be formed as a single layer or multiple layers, and may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The first bank BNK1 may be disposed on the first insulating layer INS1. The first bank BNK1 may include an opening overlapping the emission area EMA. The opening of the first bank BNK1 may provide a space where the light emitting elements LD may be provided in a step (or process) of supplying the light emitting elements LD to the first sub-pixel SPXL1. For example, a certain type and/or amount of ink (for example, the mixed solution including the light emitting element LD) may be supplied to a space divided by the opening of the first bank BNK1.

The first bank BNK1 may include an organic material such as acrylates resin, epoxy resin, phenolic resin, polyamides resin, polyimides resin, polyester resin, polyphenylenesulfides resin, or benzocyclobutene (BCB). However, embodiments are not limited thereto, and the first bank BNK1 may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

In embodiments, the opening OP may pass through the first insulating layer INS1 and the electrodes ELT1 to ELT3 to expose a partial area LA (or the surface) of the organic insulating layer (or an organic layer, e.g., the protective layer PSV and/or the bank pattern layers BNP1 to BNP3). As shown in FIG. 7B, the horizontal opening OP_H formed between the second and third bank pattern layers BNP2 and BNP3 may pass through the first insulating layer INS1 and the second and third electrodes ELT2 and ELT3 to expose a partial area (e.g., the first exposed area LA_H) of the organic insulating layer (e.g., the second and third bank pattern layers BNP2 and BNP3 and/or the protective layer PSV). For example, the vertical opening OP_V formed on the second bank pattern layer BNP2 may pass through the first insulating layer INS1 and the second electrode ELT2 to expose a partial area (e.g., the second exposed area LA_V) of the organic insulating layer (e.g., the second bank pattern layer BNP2).

In embodiments, a surface of the partial area LA (for example, the first and second exposed areas LA_H and LA_V) of the organic insulating layer (e.g., the protective layer PSV and/or the bank pattern layers BNP1 to BNP3) exposed by the opening OP may be liquid repellant. For example, the partial area LA may include a fluoro group. For example, after the opening OP passing through the first insulating layer INS1 and the electrodes ELT1 to ELT3 is formed, an upper surface of a panel may be surface-treated (or etched) by using plasmized fluorinated gas. For example, fluorine may be bonded to at least a portion of an organic material of the partial area LA, and the surface of the partial area LA may have a lower surface tension through the fluoro group. For example, the partial area LA may be liquid repellant.

In embodiments, a side surface of the first insulating layer INS1 and a side surface of the electrodes ELT1 to ELT3 may be aligned with each other in the opening OP. For example, the side surface of the first insulating layer INS1 and the side surface of the electrodes ELT1 to ELT3 may be positioned on the same line (or on the same plane) in the opening OP. For example, in case that the first insulating layer INS1 and the electrodes ELT1 to ELT3 are simultaneously etched through dry etching, the side surface of the first insulating layer INS1 and the side surface of the electrodes ELT1 to ELT3 may coincide. In another example, although the first insulating layer INS1 and the electrodes ELT1 to ELT3 are individually etched, the side surface of the first insulating layer INS1 and the side surface of the electrodes ELT1 to ELT3 may coincide with each other. However, embodiments are not limited thereto.

The light emitting elements LD may be disposed on the first insulating layer INS1. The light emitting elements LD may be provided in an opening of the first bank BNK1 to be disposed between the bank pattern layers BNP1 to BNP3 and/or between the electrodes ELT1 to ELT3. According to an embodiment, the light emitting elements LD may partially overlap the electrodes ELT1 to ELT3 in the third direction DR3.

The light emitting elements LD may be prepared in a form dispersed in a light emitting element ink, and may be supplied to the first sub-pixel SPXL1 through an inkjet printing method or the like. For example, the light emitting elements LD may be dispersed in a volatile solvent and provided to the first sub-pixel SPXL1. In case that an alignment signal is supplied to the electrodes ELT1 to ELT3 as described above, an electric field may be formed between the electrodes ELT1 to ELT3, and thus the light emitting elements LD may be aligned between the electrodes ELT1 to ELT3. After the light emitting elements LD are aligned, the solvent may be evaporated or removed by another method to stably arrange the light emitting elements LD.

The second insulating layer INS2 may be disposed on the light emitting elements LD. For example, the second insulating layer INS2 may be partially disposed on the light emitting elements LD and may expose the first and second end portions EP1 and EP2 of the light emitting elements LD. In case that the second insulating layer INS2 is formed on the light emitting elements LD after alignment of the light emitting elements LD is completed, the light emitting elements LD may be prevented from being separated from an aligned position. In case that a separation space is formed between the first insulating layer INS1 and the light emitting elements LD before formation of the second insulating layer INS2, the space may be filled by the second insulating layer INS2. Accordingly, the light emitting elements LD may be more stably supported or fixed. In another example, the second insulating layer INS2 may be omitted.

In an embodiment, the second insulating layer INS2 may contact the protective layer PSV in the opening OP. For example, as shown in FIG. 7B, the second insulating layer INS2 may be disposed (e.g., directly disposed) on the protective layer PSV in the horizontal opening OP_H.

The second insulating layer INS2 may include an organic material such as acrylic resin, epoxy resin, phenolic resin, polyamide resin, polyimide resin, polyester resin, polyphenylenesulfides resin, or benzocyclobutene (BCB). However, embodiments are not limited thereto, and the second insulating layer INS2 may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The first contact electrode CNE1, the second contact electrode CNE2, and the first intermediate electrode CTE1 may be disposed on the first and second end portions EP1 and EP2 of the light emitting elements LD exposed by the second insulating layer INS2.

The first contact electrode CNE1 may be disposed (e.g., directly disposed) on the first end portion EP1 of the first light emitting element LD1 to contact the first end portion EP1 of the first light emitting element LD1. The first contact electrode CNE1 may be connected (e.g., electrically connected) to the first transistor electrode TE1 of the first transistor T1 through a contact hole or the like passing through the protective layer PSV.

The first sub-intermediate electrode CTE_S1 of the first intermediate electrode CTE1 may be disposed (e.g., directly disposed) on the second end portion EP2 of the first light emitting element LD1 to contact the second end portion EP2 of the first light emitting element LD1. The second sub-intermediate electrode CTE_S2 of the first intermediate electrode CTE1 may be disposed (e.g., directly disposed) on the first end portion EP1 of the second light emitting element LD2 to contact the first end portion EP1 of the second light emitting element LD2. For example, the first intermediate electrode CTE1 may connect (e.g., electrically connect) the second end portion EP2 of the first light emitting element LD1 and the first end portion EP1 of the second light emitting element LD2.

The second contact electrode CNE2 may be disposed (e.g., directly disposed) on the second end portion EP2 of the second light emitting element LD2 to contact the second end portion EP2 of the second light emitting element LD2. The second contact electrode CNE2 may be connected (e.g., electrically connected) to the second power line PL2 through a contact hole or the like passing through the protective layer PSV.

In an embodiment, the first contact electrode CNE1, the second contact electrode CNE2, and the first intermediate electrode CTE1 may contact the protective layer PSV and the bank pattern layers BNP1 to BNP3 in the opening OP. For example, as shown in FIG. 7B, the second contact electrode CNE2 and the first intermediate electrode CTE1 (or the second sub-intermediate electrode CTE_S2) may be disposed (e.g., directly disposed) on the protective layer PSV and the second and third bank pattern layers BNP2 and BNP3 in the horizontal opening OP_H.

The first contact electrode CNE1, the second contact electrode CNE2, and the first intermediate electrode CTE1 may be formed of various transparent conductive materials. Accordingly, the light emitted from the first and second end portions EP1 and EP2 of the light emitting elements LD may be emitted to the outside of the third direction DR3 through the first contact electrode CNE1, the second contact electrode CNE2, and the first intermediate electrode CTE1. An example of the transparent conductive material may include a conductive oxide such as indium tin oxide (ITO), indium zinc oxide (IZO), zinc oxide (ZnOₓ), indium gallium zinc oxide (IGZO), and indium tin zinc oxide (ITZO), a conductive polymer such as poly(3,4-ethylenedioxythiophene) (PEDOT), and the like.

In an embodiment, the first contact electrode CNE1, the second contact electrode CNE2, and the first intermediate electrode CTE1 may be formed of the same conductive layer. For example, the first contact electrode CNE1, the second contact electrode CNE2, and the first intermediate electrode CTE1 may be simultaneously formed by the same process. For example, the number of the masks may be reduced and a manufacturing process may be simplified.

An overcoat layer may be disposed on the first contact electrode CNE1, the second contact electrode CNE2, and the first intermediate electrode CTE1. The overcoat layer may be an inorganic insulating layer including an inorganic material or an organic insulating layer including an organic material. For example, the overcoat layer may have a structure in which at least one inorganic insulating layer or at least one organic insulating layer is alternately stacked. The overcoat layer may cover (e.g., entirely cover) the display element layer DPL, and may prevent water, moisture, or the like from flowing (or permeating) into the display element layer DPL including the light emitting element LD from the outside. The overcoat layer may planarize an upper surface of the display element layer DPL.

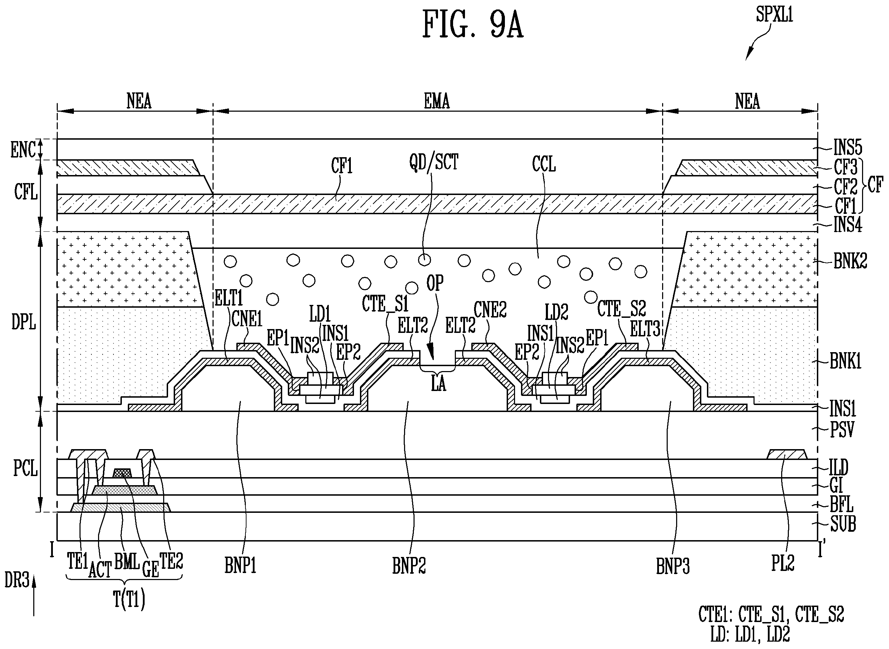

According to an embodiment, the display element layer DPL may selectively further include an optical layer, or an optical layer may be further disposed on the display element layer DPL. For example, the display element layer DPL may further include a color conversion layer including color conversion particles that convert the light emitted from the light emitting elements LD into light of a specific color. For example, the display element layer DPL may further include a color filter that transmits only light of a specific wavelength band. The color conversion layer is described below with reference to FIGS. 9A to 9C.

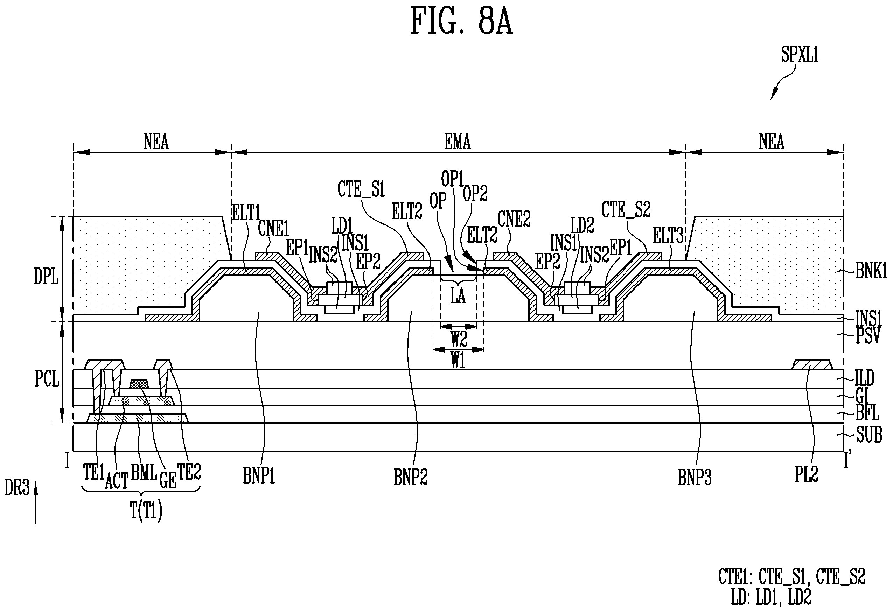

FIGS. 8A to 8D are schematic cross-sectional views illustrating an embodiment of the first sub-pixel taken along the line I-I' of FIG. 6.

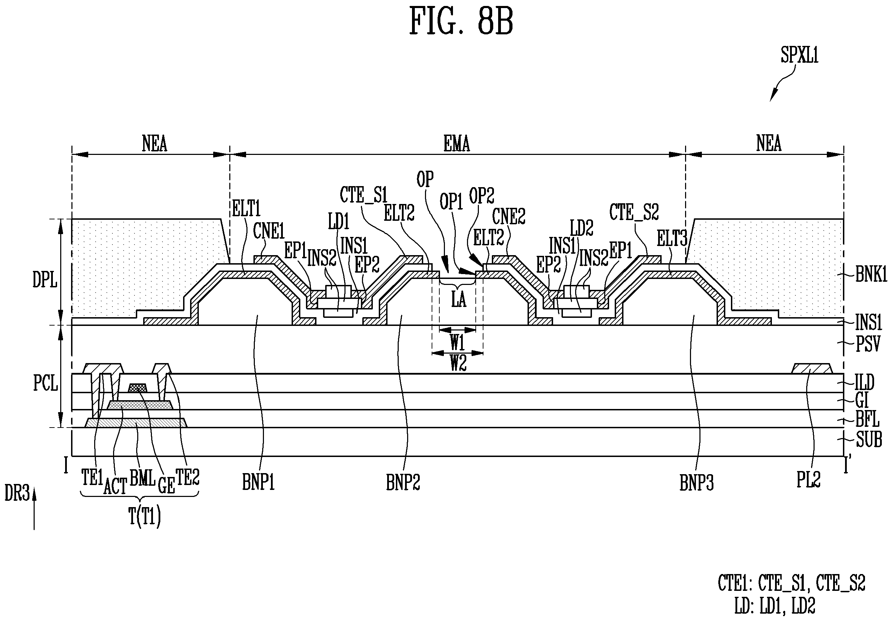

First, referring to FIGS. 6, 7A, 8A, and 8B, except for a disposition relationship of the first insulating layer INS1 and the electrodes ELT1 to ELT3 in the opening OP, the first sub-pixel SPXL1 of FIGS. 8A and 8B may be substantially the same as or similar to the first sub-pixel SPXL1 of FIG. 7A. Therefore, a redundant description is omitted for descriptive convenience.

In an embodiment, the first insulating layer INS1 may cover the electrodes ELT1 to ELT3 in the opening OP. For example, the opening OP may be formed or defined by overlapping a first opening OP1 formed in the electrodes ELT1 to ELT3 and a second opening OP2 formed in the first insulating layer INS1. For example, the width W2 of the second opening OP2 of the first insulating layer INS1 may be less than the width W1 of the first opening OP1 of the electrodes ELT1 to ELT3 (see, e.g., FIG. 8A). For example, as shown in FIG. 8A, the first insulating layer INS1 may cover the side surface (or the end portion) and the upper surface of the second electrode ELT2 in the opening OP. For example, the first insulating layer INS1 may prevent contact between the electrodes ELT1 to ELT3 and the first and second contact electrodes CNE1 and CNE2 and/or between the electrodes ELT1 to ELT3 and the first intermediate electrode CTE1.

In another example, the electrodes ELT1 to ELT3 may be exposed in the third direction DR3 by the first insulating layer INS1 in the opening OP. For example, the width W2 of the second opening OP2 of the first insulating layer INS1 may be greater than the width W1 of the first opening OP1 of the electrodes ELT1 to ELT3 (see, e.g., FIG. 8B). For example, as shown in FIG. 8B, the side surface (or the end portion) and the upper surface of the second electrode ELT2 may be exposed by the first insulating layer INS1 in the opening OP. For example, the electrodes ELT1 to ELT3 may contact the first and second contact electrodes CNE1 and CNE2 and/or the first intermediate electrode CTE1 in the opening OP.

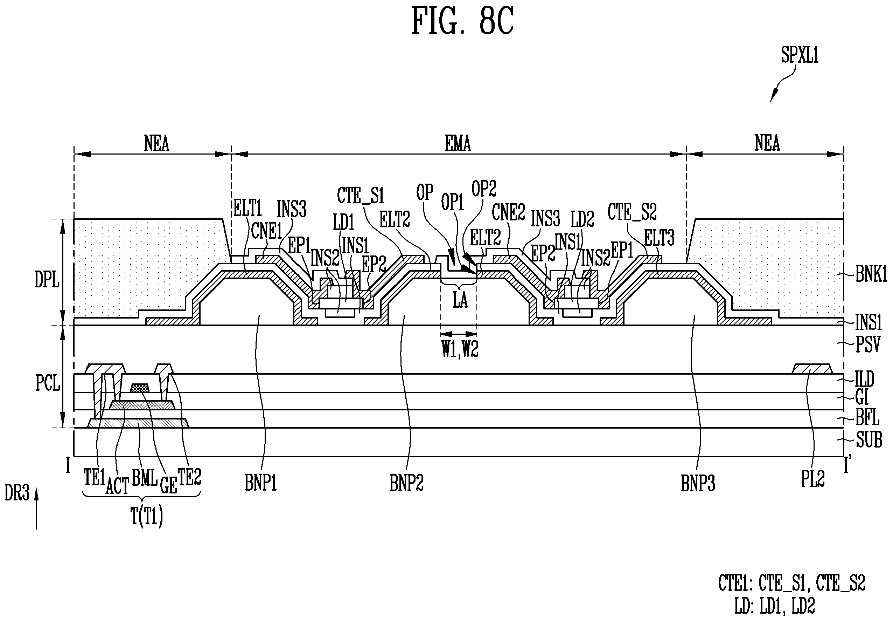

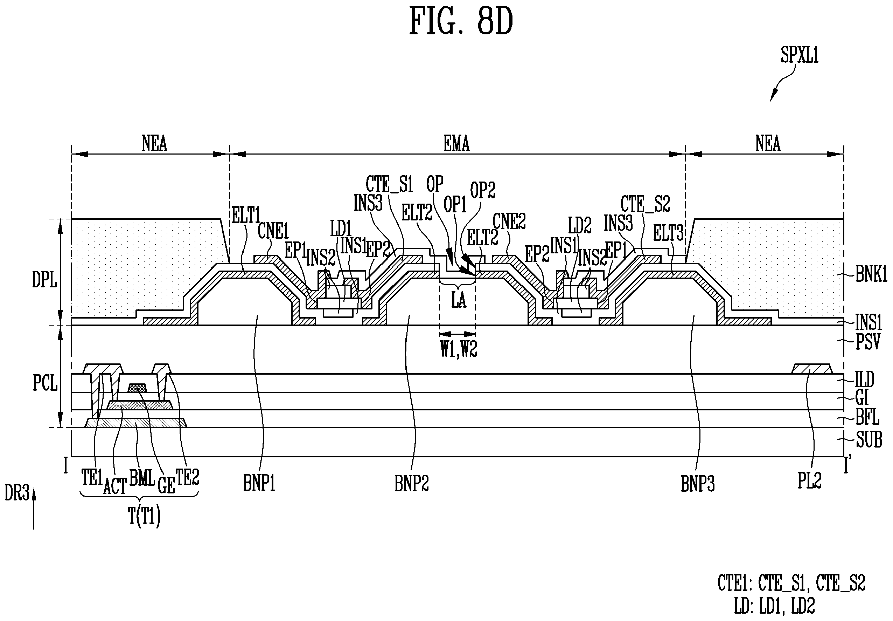

Referring to FIGS. 6, 7A, 8C, and 8D, except for the third insulating layer INS3, the first sub-pixel SPXL1 of FIGS. 8C and 8D may be substantially the same as or similar to the first sub-pixel SPXL1 of FIG. 7A. Therefore, a redundant description is omitted for descriptive convenience.

In an embodiment, a third insulating layer INS3 may be disposed between the first and second contact electrodes CNE1 and CNE2 and the first intermediate electrode CTE1. For example, the first and second contact electrodes CNE1 and CNE2 and the first intermediate electrode CTE1 may be disposed on different layers.

For example, the width W2 of the second opening OP2 of the first insulating layer INS1 may be substantially equal to the width W1 of the first opening OP1 of the electrodes ELT1 to ELT3 (see, e.g., FIGS. 8C and 8D). For example, as shown in FIG. 8C, the third insulating layer INS3 may be disposed on the first and second contact electrodes CNE1 and CNE2, and the first intermediate electrode CTE1 may be disposed on the third insulating layer INS3. For example, the third insulating layer INS3 may cover the side surfaces of the first and second electrodes ELT1 and ELT2, and may contact (e.g., directly contact) the second bank pattern layer BNP2.

In another example, as shown in FIG. 8D, the third insulating layer INS3 may be disposed on the first intermediate electrode CTE1, and the first and second contact electrodes CNE1 and CNE2 may be disposed on the third insulating layer INS3. For example, the third insulating layer INS3 may cover the side surfaces of the first and second electrodes ELT1 and ELT2, and may contact (e.g., directly contact) the second bank pattern layer BNP2.

As described above, in case that the third insulating layer INS3 is disposed between the first and second contact electrodes CNE1 and CNE2 and the first intermediate electrode CTE1, the first and second contact electrodes CNE1 and CNE2 and the first intermediate electrode CTE1 may be stably separated by the third insulating layer INS3, and thus electrical stability between the first and second end portions EP1 and EP2 of the light emitting elements LD may be ensured or implemented.

FIGS. 9A to 9C are schematic cross-sectional views illustrating an embodiment of the first sub-pixel taken along the line I-I' of FIG. 6.

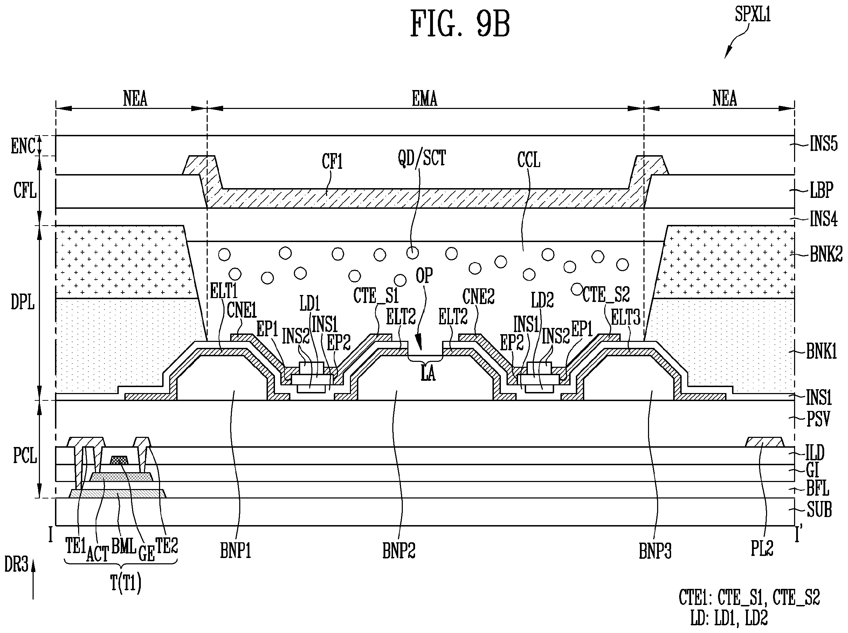

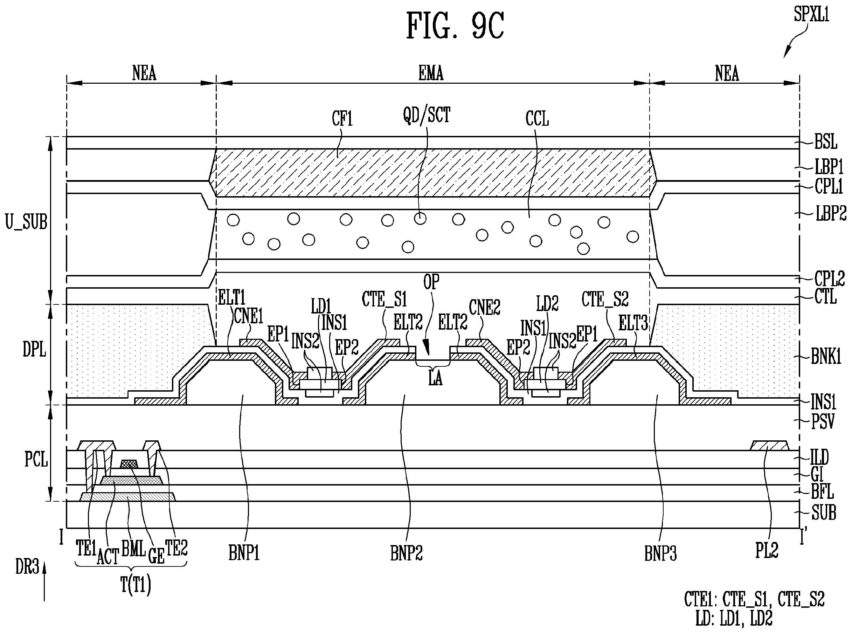

FIGS. 9B and 9C illustrate a modified example of FIG. 9A in relation to a position of the color conversion layer CCL. For example, FIG. 9B illustrates an embodiment in which the color conversion layer CCL is positioned on the display element layer DPL through a continuous process, and FIG. 9C illustrates an embodiment in which an upper substrate U_SUB including the color conversion layer CCL is positioned on the display element layer DPL through an adhesion process by using the intermediate layer CTL. In relation to an embodiments of FIGS. 9A to 9C, a point different from that of the above-described embodiments (for example, the embodiment of FIG. 7A) is described in order to avoid a redundant description. The embodiments of FIGS. 9A to 9C are shown as including the display element layer DPL of FIG. 7A, but embodiments are not limited thereto. For example, the embodiments of FIGS. 9A to 9C may also be applied to FIGS. 8A to 8D.

Referring to FIGS. 7A, 8A to 8D, and 9A, the first sub-pixel SPXL1 may include the color conversion layer CCL positioned in the emission area EMA and a second bank BNK2 positioned in the non-emission area NEA.

The second bank BNK2 may be disposed on the first bank BNK1 in the non-emission area NEA of the first sub-pixel SPXL1. In a plan view, the second bank BNK2 may be a structure that surrounds the emission area EMA and finally defines the emission area EMA by defining a position where the color conversion layer CCL is required to be supplied. For example, the second bank BNK2 may be a structure that finally sets (or defines) the emission area EMA by defining a deposition position of the color conversion layer CCL to the first sub-pixel SPXL1.

The second bank BNK2 may include a light blocking material. For example, the second bank BNK2 may be a black matrix. According to an embodiment, the second bank BNK2 may be formed to include at least one light blocking material and/or reflective material so as to transmit (or guide) light emitted from the color conversion layer CCL in the image display direction (or the third direction DR3) of the display device, thereby improving light output efficiency of the color conversion layer CCL.

The color conversion layer CCL may be disposed on (or above) the first contact electrode CNE1, the first intermediate electrode CTE1, and the second contact electrode CNE2 in the emission area EMA surrounded by the second bank BNK2.

The color conversion layer CCL may include color conversion particles QD (or wavelength conversion particles) corresponding to a specific color. For example, the color conversion layer CCL may include the color conversion particles QD that convert light of a first color (or a first wavelength band) emitted from the light emitting elements LD into light of a second color (e.g., a specific color, or a second wavelength band).

In case that the first sub-pixel SPXL1 is a red pixel (or a red sub-pixel), the color conversion layer CCL may include a red quantum dot of color conversion particles QD that convert the light of the first color emitted from the light emitting elements LD into the light of the second color, for example, red light.

In case that the first sub-pixel SPXL1 is a green pixel (or a green sub-pixel), the color conversion layer CCL may include a green quantum dot of color conversion particles QD that convert the light of the first color emitted from the light emitting elements LD into the light of the second color, for example, green light.

In case that the first sub-pixel SPXL1 is a blue pixel (or a blue sub-pixel), the color conversion layer CCL may include a blue quantum dot of color conversion particles QD that convert the light of the first color emitted from the light emitting elements LD into the light of the second color, for example, blue light

According to an embodiment, in case that the first sub-pixel SPXL1 is the blue pixel (or the blue sub-pixel), a light scattering layer including light scattering particles SCT may be provided instead of the color conversion layer CCL including the color conversion particles QD. For example, in case that the light emitting elements LD emit blue-based light, the first sub-pixel SPXL1 may include the light scattering layer including the light scattering particles SCT. In another example, the above-described light scattering layer may be omitted. In another example, in case that the first sub-pixel SPXL1 is the blue pixel (or the blue sub-pixel), a transparent polymer may be formed instead of the color conversion layer CCL.

A fourth insulating layer INS4 may be disposed on the color conversion layer CCL and the second bank BNK2.

The fourth insulating layer INS4 may be formed (e.g., entirely or completely formed) on the substrate SUB to cover the second bank BNK2 and the color conversion layer CCL. The fourth insulating layer INS4 may be disposed (e.g., directly disposed) on the second bank BNK2 and the color conversion layer CCL. The fourth insulating layer INS4 may be an inorganic insulating layer including an inorganic material. The fourth insulating layer INS4 may include at least one of a metal oxide such as silicon nitride (SiNₓ), silicon oxide (SiOₓ), silicon oxynitride (SiOₓN_{y}), and aluminum oxide (AlOₓ). The fourth insulating layer INS4 may cover (e.g., completely cover) the second bank BNK2 and the color conversion layer CCL to prevent water, moisture, or the like from flowing into the display element layer DPL from the outside.

The fourth insulating layer INS4 may have a flat surface with alleviating (or minimizing) a step difference generated by components disposed thereunder. For example, the fourth insulating layer INS4 may include an organic insulating layer including an organic material. The fourth insulating layer INS4 may be a common layer commonly provided to the display area DA, but embodiments are not limited thereto.

A color filter layer CFL may be disposed on the fourth insulating layer INS4.

In the embodiment of FIG. 9A, the color filter layer CFL may include a color filter CF corresponding to each color of adjacent sub-pixels. For example, the color filter layer CFL may include a first color filter CF1 disposed on the color conversion layer CCL of the first sub-pixel SPXL1, a second color filter CF2 disposed on the color conversion layer CCL of one sub-pixel adjacent to the first sub-pixel SPXL1 in the first direction DR1, and a third color filter CF3 disposed on the color conversion layer CCL of another sub-pixel SPXL adjacent to the first sub-pixel in the first direction DR1. In an embodiment, the first, second, and third color filters CF1, CF2, and CF3 may overlap each other in the non-emission area NEA to block light interference between adjacent sub-pixels. Each of the first, second, and third color filters CF1, CF2, and CF3 may include a color filter material that selectively transmits light of a specific color converted by the color conversion layer CCL. For example, the first color filter CF1 may be a red color filter, the second color filter CF2 may be a green color filter, and the third color filter CF3 may be a blue color filter. The above-described color filter CF may be disposed on a surface of the fourth insulating layer INS4 to correspond to the color conversion layer CCL.

In the embodiment of FIG. 9B, the color filter layer CFL may include a first color filter CF1 and a light blocking pattern layer LBP. The first color filter CF1 may be positioned in the emission area of each of the adjacent sub-pixels and disposed on the fourth insulating layer INS4 on the color conversion layer CCL of a corresponding sub-pixel. The light blocking pattern layer LBP may be positioned in the non-emission area NEA and disposed on the fourth insulating layer INS4 on the second bank BNK2 of a corresponding sub-pixel, for example, the first sub-pixel SPXL1. The light blocking pattern layer LBP may be positioned on a surface of the fourth insulating layer INS4 adjacent to the first color filter CF1. The light blocking pattern layer LBP may overlap the first and second banks BNK1 and BNK2. The light blocking pattern layer LBP may include a light blocking material that prevents light leakage between adjacent sub-pixels. For example, the light blocking pattern layer LBP may include a black matrix. The light blocking pattern layer LBP may prevent color mixing of light emitted from each of the adjacent sub-pixels.

An encapsulation layer ENC may be provided and/or formed on the color filter layer CFL.

The encapsulation layer ENC may include a fifth insulating layer INS5. The fifth insulating layer INS5 may be an inorganic insulating layer including an inorganic material or an organic insulating layer including an organic material. The fifth insulating layer INS5 may cover (e.g., entirely cover) elements positioned thereunder to block water, moisture, or the like from flowing into the color filter layer CFL and the display element layer DPL from the outside.

In the display device including the first sub-pixel SPXL1 according to an embodiment, the color conversion layer CCL and the color filter CF may be disposed on the light emitting element LD to emit light having excellent color reproducibility through the color conversion layer CCL and the color filter CF, thereby improving light output efficiency.

In an embodiment, the fifth insulating layer INS5 may be formed as multiple layers. For example, the fifth insulating layer INS5 may include at least two inorganic insulating layers and at least one organic insulating layer interposed between the at least two inorganic insulating layers. However, a material and/or a structure of the fifth insulating layer INS5 may be variously changed. For example, according to an embodiment, at least one layer of overcoat layer, a filler layer, an upper substrate, and/or the like may be further disposed on the fifth insulating layer INS5.

In an embodiment, the color conversion layer CCL may be formed (e.g., directly formed) on the first contact electrode CNE1, the first intermediate electrode CTE1, and the second contact electrode CNE2, but embodiments are not limited thereto. According to an embodiment, as shown in FIG. 9C, the color conversion layer CCL may be formed on a separate substrate, for example, the upper substrate U_SUB, and may be combined with the display element layer DPL including the first contact electrode CNE1, the first intermediate electrode CTE1, and the second contact electrode CNE2 through the intermediate layer CTL or the like.

The intermediate layer CTL may be a transparent adhesive layer (e.g., viscosity layer) for strengthening adhesive force between the display element layer DPL and the upper substrate U_SUB, for example, an optically clear adhesive, but embodiments are not limited thereto. According to an embodiment, the intermediate layer CTL may be a refractive index conversion layer for improving an emission luminance of the pixel PXL by converting a refractive index of light emitted from the light emitting elements LD and proceeding to the upper substrate U_SUB. According to an embodiment, the intermediate layer CTL may include a filler formed of an insulating material having an insulating property and an adhesive property.

The upper substrate U_SUB may form an encapsulation substrate and/or a window member of the display device. The upper substrate U_SUB may include a base layer BSL (or a base substrate), the color conversion layer CCL, the first color filter CF1 (or the color filter CF (refer to FIG. 9A), light blocking pattern layers LBP1 and LBP2, and first and second capping layers CPL1 and CPL2.

The base layer BSL may be a rigid substrate or a flexible substrate, and a material or a property thereof is not limited thereto. The base layer BSL may be formed of the same material as the substrate SUB or may be formed of a material different from that of the substrate SUB.

In FIG. 9C, the color conversion layer CCL and the first color filter CF1 may be disposed on a surface of the base layer BSL to face the display element layer DPL. The first color filter CF1 may be disposed on a surface of the base layer BSL to correspond to the color conversion layer CCL.

The first capping layer CPL1 may be provided and/or formed between the first color filter CF1 and the color conversion layer CCL.

The first capping layer CPL1 may be disposed on the first color filter CF1 to cover the first color filter CF1, thereby protecting the first color filter CF1. The first capping layer CPL1 may be an inorganic layer including an inorganic material or an organic layer including an organic material.

The light blocking pattern layers LBP1 and LBP2 may be positioned adjacent to the color conversion layer CCL and the first color filter CF1. The light blocking pattern layers LBP1 and LBP2 may be disposed on a surface of the base layer BSL to correspond to the non-emission area NEA of the first sub-pixel SPXL1. The light blocking pattern layers LBP1 and LBP2 may include a first light blocking pattern layer LBP1 and a second light blocking pattern layer LBP2.

The first light blocking pattern layer LBP1 may be positioned on a surface of the base layer BSL and may be positioned adjacent to the first color filter CF1.

The first capping layer CPL1 may be disposed on the first light blocking pattern layer LBP1.

The second light blocking pattern layer LBP2 may be disposed on a surface of the first capping layer CPL1 to correspond to the first light blocking pattern layer LBP1. The second light blocking pattern layer LBP2 may be a black matrix. The first light blocking pattern layer LBP1 and the second light blocking pattern layer LBP2 may include the same material. In an embodiment, the second light blocking pattern layer LBP2 may be a structure that finally defines the emission area EMA of the first sub-pixel SPXL1. The second light blocking pattern layer LBP2 may be a dam structure that finally defines the emission area EMA to which the color conversion layer CCL is required to be supplied in a process of supplying the color conversion layer CCL.

The second capping layer CPL2 may be provided and/or formed (e.g., entirely provided and/or formed) on the color conversion layer CCL and the second light blocking pattern layer LBP2.

The second capping layer CPL2 may include at least one of metal oxides such as silicon nitride (SiNₓ), silicon oxide (SiOₓ), and silicon oxynitride (SiOₓN_{y}), or aluminum oxide (AlOₓ), but embodiments are not limited thereto. According to an embodiment, the second capping layer CPL2 may be formed of an organic layer including an organic material. The second capping layer CPL2 may be disposed on the color conversion layer CCL to protect the color conversion layer CCL from external water, moisture, and the like, thereby further improving reliability of the color conversion layer CCL.

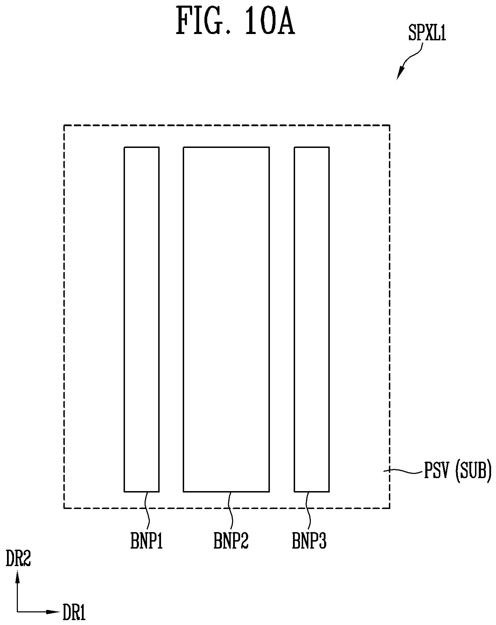

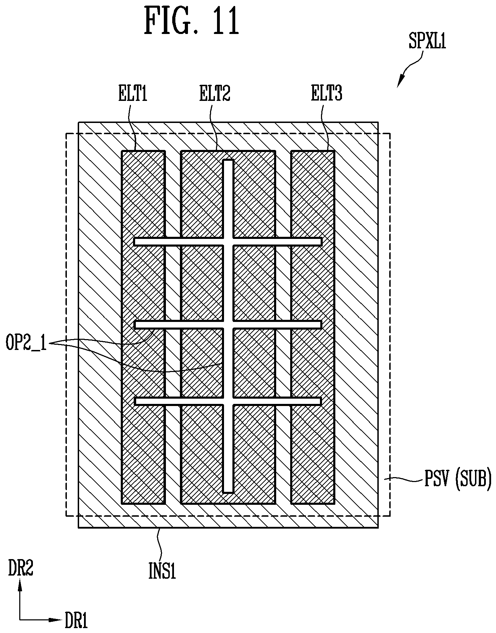

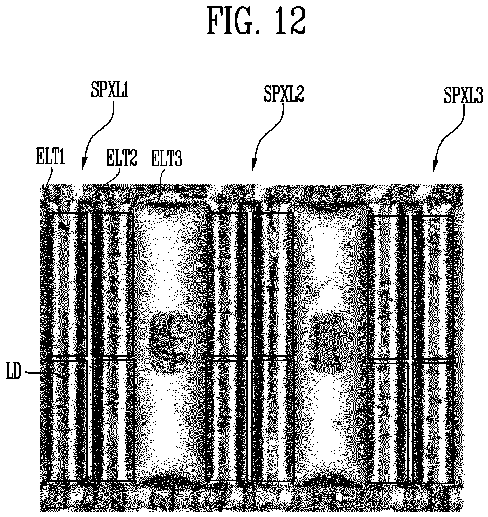

FIGS. 10A to 10I are schematic diagrams illustrating a process of manufacturing the display device of FIG. 3. FIGS. 10A to 10I correspond to FIG. 5. FIG. 11 is a schematic diagram illustrating an embodiment of the first insulating layer. FIG. 12 is a schematic diagram illustrating an image obtained by capturing the display device of FIG. 3.

Referring to FIGS. 5, 7A, 7B, and 10A, the bank pattern layers BNP1 to BNP3 may be formed on the protective layer PSV (or the substrate SUB).

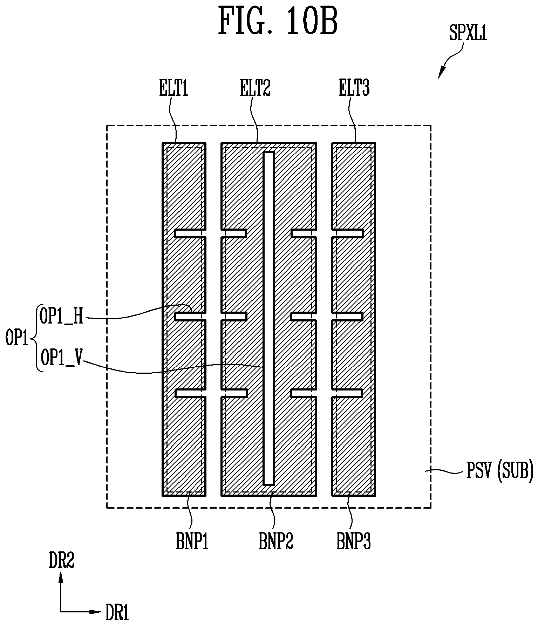

Thereafter, as shown in FIG. 10B, the electrodes ELT1 to ELT3 may be formed on the bank pattern layers BNP1 to BNP3 on the protective layer PSV (or the substrate SUB). The first electrode ELT1 may overlap the first bank pattern layer BNP1, the second electrode ELT2 may overlap the second bank pattern layer BNP2, and the third electrode ELT3 may overlap the third bank pattern layer BNP3.

In embodiments, a first opening OP1 may be formed in the electrodes ELT1 to ELT3. The first opening OP1 may correspond to the opening OP described with reference to FIGS. 5, 7A, and 7B.

In an embodiment, the first opening OP1 may include a first horizontal opening OP1_H (or a first sub-opening) and a first vertical opening OP1_V (or a second sub-opening). The first horizontal opening OP1_H may have a slit shape extending in the first direction DR1. The first horizontal opening OP1_H may be positioned on at least one side of each of the electrodes ELT1 to ELT3, and may partially cut each of the electrodes ELT1 to ELT3 extending in the second direction DR2.

For example, the first vertical opening OP1_V may have a slit shape extending in the second direction DR2. The first vertical opening OP1_V may be positioned at a center portion of the second electrode ELT2.

A lower structure, e.g., the protective layer PSV and/or the bank pattern layers BNP1 to BNP3 may be exposed by the first horizontal opening OP1_H and the first vertical opening OP1_V.

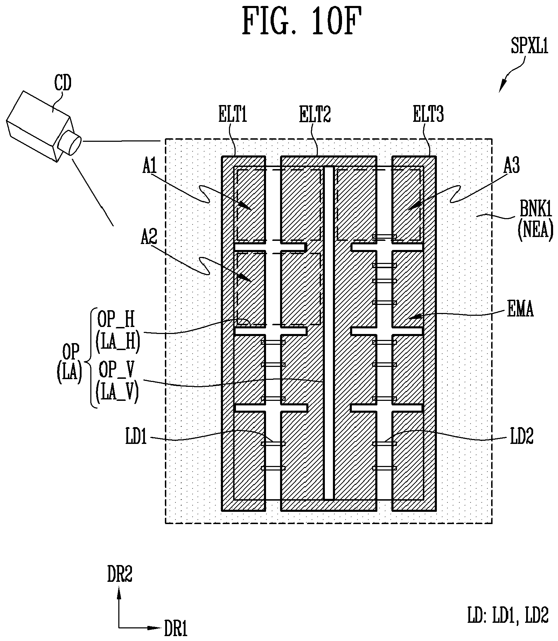

The first horizontal opening OP1_H and the first vertical opening OP1_V may divide an area in which the first sub-pixel SPXL1 is formed (or the emission region EMA in FIG. 5) into sub-areas (refer to FIG. 10F).

In an embodiment, each of the electrodes ELT1 to ELT3 may not be physically separated by the first horizontal opening OP1_H and the first vertical opening OP1_V. For example, the first horizontal opening OP1_H and the first vertical opening OP1_V may extend as long as the electrodes ELT1 to ELT3 are not physically separated. For example, alignment signals may be applied to the entire electrodes ELT1 to ELT3 through an end portion (or a part) of the electrodes ELT1 to ELT3. For example, the first horizontal opening OP1_H may be formed only on a right side of the first electrode ELT1 such that a part of the right side of the first electrode ELT1 may be recessed in a direction opposite to the first direction DR1, and a left side of the first electrode ELT1 may extend along the second direction DR2 without cutting (or without being recessed). The first horizontal opening OP_H may be formed on a left side and a right side of the second electrode ELT2 such that a part of the right side and a part of the left side of the second electrode ELT2 may be recessed, but a center portion of the second electrode ELT2 may continuously extend along the second direction DR2. For example, the first horizontal opening OP_H may not pass through the second electrode ELT2 in the first direction DR1. The first vertical opening OP1_V may be formed in the center portion of the second electrode ELT2, and may be spaced apart from upper/lower end portions of the second electrode ELT2 and the first horizontal opening OP1_H, and a portion between the first vertical opening OP1_V and the first horizontal opening OP1_H may extend along the second direction DR2. The third electrode ELT3 may have a shape symmetrical to the first electrode ELT1 in the first direction DR1. The first horizontal opening OP1_H may be formed at mutually facing sides of the electrodes ELT1 to ELT3 (and portions having a relatively low height with respect to the substrate SUB as shown in FIG. 7B), but embodiments are not limited thereto.

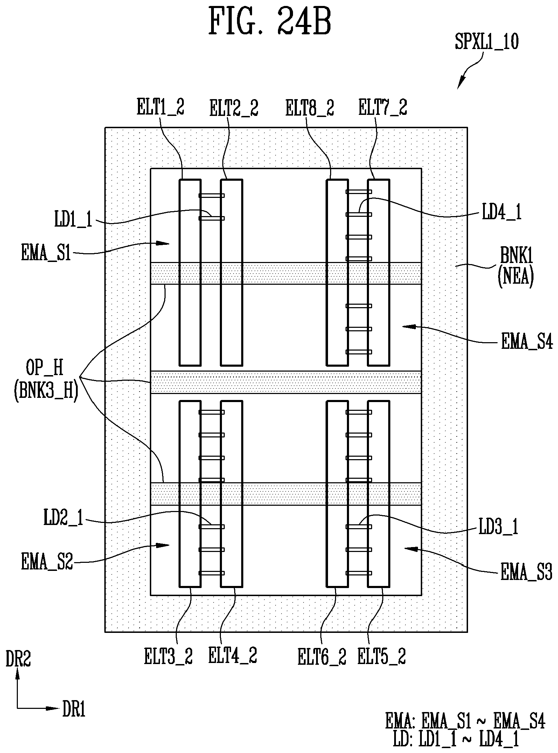

Although it has been described that the electrodes ELT1 to ELT3 are not physically separated by the first horizontal opening OP1_H and the first vertical opening OP1_V, embodiments are not limited thereto. For example, the first horizontal opening OP1_H and the first vertical opening OP1_V may separate each of the electrodes ELT1 to ELT3 into pieces (or pattern layers in FIG. 24B). For example, the pieces may be electrically connected to each other through a separate bridge pattern layer (for example, a conductive pattern layer disposed under the protective layer PSV) and a contact hole (for example, a contact hole passing through the protective layer PSV and exposing a conductive pattern layer).

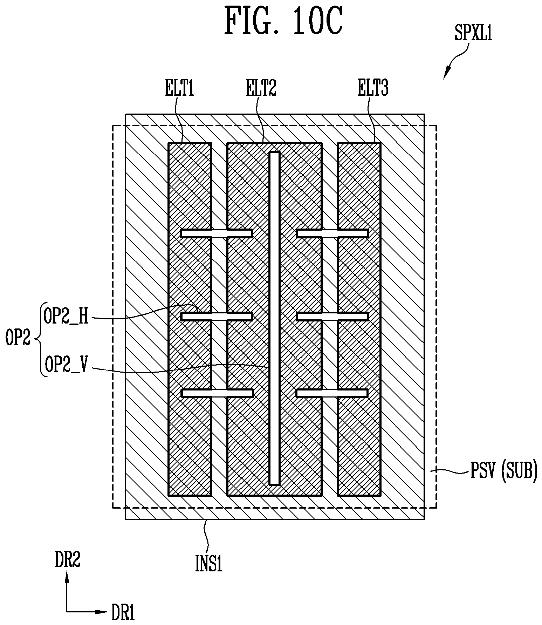

Thereafter, as shown in FIG. 10C, the first insulating layer INS1 may be formed (e.g., entirely formed) on the protective layer PSV (or the substrate SUB) to cover the electrodes ELT1 to ELT3.

In embodiments, a second opening OP2 may be formed in the first insulating layer INS1. The second opening OP2 may correspond to the first opening OP1 of the electrodes ELT1 to ELT3. As shown in FIGS. 7A, 8A, and 8B, the second opening OP2 of the first insulating layer INS1 may overlap the first opening OP1 of the electrodes ELT1 to ELT3, and the second opening OP2 may be greater or less than the first opening OP1.

In an embodiment, the second opening OP2 may include a second horizontal opening OP2_H (or a first sub-opening) and a second vertical opening OP2_V (or a second sub-opening). The second horizontal opening OP2_H may have a slit shape extending in the first direction DR1, and may overlap at least one first horizontal opening OP1_H. For example, the second horizontal opening OP2_H may overlap the first horizontal opening OP1_H of the first electrode ELT1 and the first horizontal opening OP1_H of the second electrode ELT2. The second horizontal opening OP2_H may form the horizontal opening OP_H (refer to FIG. 5) (e.g., an opening exposing the protective layer PSV and/or the bank pattern layers BNP1 to BNP3) together with the first horizontal opening OP1_H.

For example, the second vertical opening OP2_V may have a slit shape extending in the second direction DR2, and may overlap the first vertical opening OP1_V. The second vertical opening OP2_V may form the vertical opening OP_V (refer to FIG. 5) (e.g., an opening exposing the protective layer PSV and/or the bank pattern layers BNP1 to BNP3) together with the first vertical opening OP1_V. For example, the opening OP (refer to FIG. 5) may be defined or formed by overlapping the first opening OP1 and the second opening OP2.

In FIG. 10C, the second horizontal opening OP2_H and the second vertical opening OP2_V may be spaced apart from each other, but embodiments are not limited thereto. For example, as shown in FIG. 11, a second opening OP2_1 of the first sub-pixel SPXL1 may be integral with each other. For example, the second horizontal opening OP2_H and the second vertical opening OP2_V of FIG. 10C may be connected to each other.

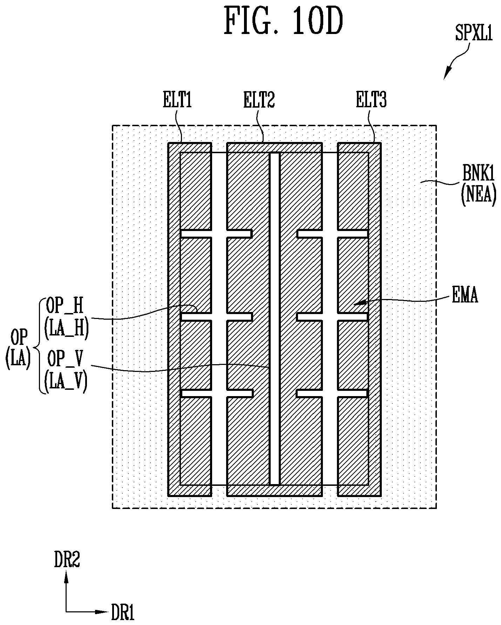

Thereafter, as shown in FIG. 10D, the first bank BNK1 may be formed on the first insulating layer INS1.

In an embodiment, the first bank BNK1 may overlap uncut portions (e.g., portions adjacent to an end portion of the opening OP) of the electrodes ELT1 to ELT3. As the number of the uncut portions of the electrodes ELT1 to ELT3 increases in the emission area EMA, the area LA exposed by the opening OP becomes relatively small, and the emission area EMA in the area LA may not be clearly divided. Thus, since the uncut portions of the electrodes ELT1 to ELT3 are positioned in the non-emission area NEA, the emission area EMA in the area LA may be more clearly divided into the sub-areas.

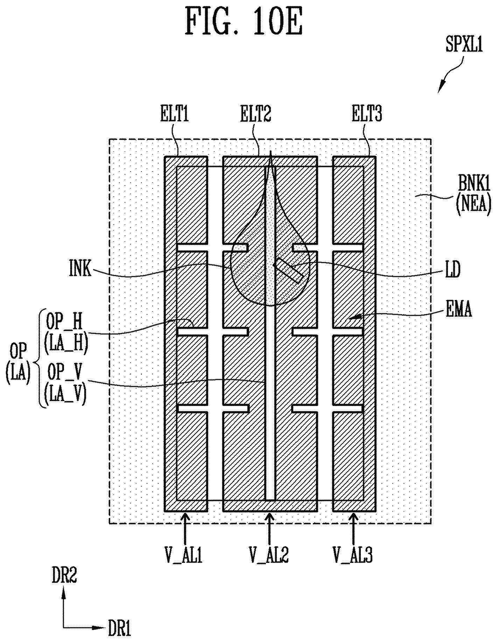

Thereafter, as shown in FIG. 10E, the light emitting element LD may be prepared in a dispersed form (for example, an ink INK) in a solution, and may be supplied to the emission area EMA of the first sub-pixel SPXL1 through an inkjet printing method, a slit coating method, or the like.

Alignment signals V_AL1 to V_AL3 may be applied to the electrodes ELT1 to ELT3 simultaneously with or after supply of the light emitting element LD (or the ink INK). For example, a first alignment signal V_AL1 may be applied to the first electrode ELT1, a second alignment signal V_AL2 may be applied to the second electrode ELT2, and a third alignment signal V_AL3 may be applied to the third electrode ELT3. The first and third alignment signals V_AL1 and V_AL3 may be a ground voltage, and the second alignment signal V_AL2 may be an AC voltage, but embodiments are not limited thereto.

In case that the alignment signals V_AL1 to V_AL3 are applied to the electrodes ELT1 to ELT3, an electric field may be formed between the electrodes ELT1 to ELT3, and thus the light emitting element LD may be self-aligned between the electrodes ELT1 to ELT3 (refer to FIG. 10F).

After the light emitting elements LD are aligned, the light emitting element LD may be stably arranged between the electrodes ELT1 to ELT3 by evaporating the solvent or removing the solvent in another method.

Thereafter, the number of the light emitting elements LD supplied to the first sub-pixel SPXL1 may be detected or measured.

For example, as shown in FIG. 10F, an image of the first sub-pixel SPXL1 may be obtained through an imaging device CD. As shown in FIG. 12, an image of the entire display device including the sub-pixels SPXL1 to SPXL3 may be obtained.

The number of the light emitting elements LD may be detected through analysis of the image. For example, the opening OP (or the area LA exposed by the opening OP) and the light emitting element LD may be detected through image processing or the like, and the number of the light emitting elements LD may be detected for each of the sub-areas divided by the opening OP (and the first bank BNK1).

A weak area among the sub-areas may be determined based on the detected number of light emitting elements LD. The weak area may be an area in which the number of the light emitting elements LD is less than the reference number and an area in which additional supply (or additional injection) of the light emitting element LD is required. For example, a first sub-area A1, a second sub-area A2, and a third sub-area A3 in which the number of the light emitting element LD is relatively small may be determined as the weak area. Information (for example, coordinate information) of the weak area may be generated.

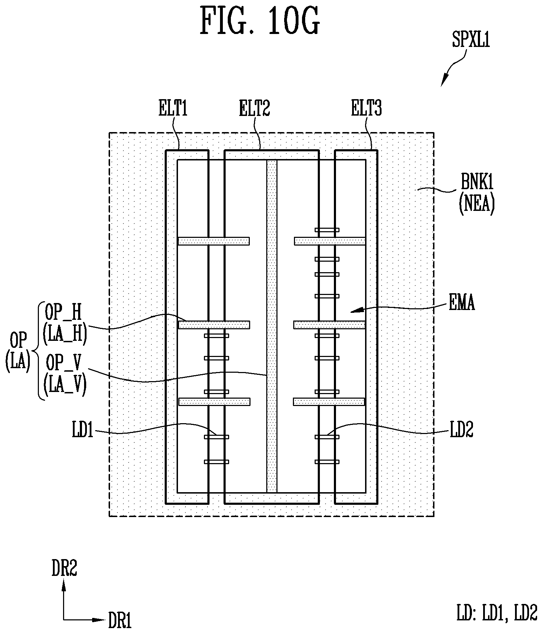

Referring to FIG. 10G, the upper surface of the panel may be surface-treated by using plasmized fluorinated gas. For example, fluorine may be coupled to at least a portion of the organic material of the area LA exposed by the opening OP (e.g., the protective layer PSV and/or the bank pattern layers BNP1 to BNP3), and the surface of the area LA may be liquid repellant. The surface treatment may be performed substantially simultaneously with the detection of the number of the light emitting elements LD, but embodiments are not limited thereto. For example, the surface treatment may be performed after or before the detection of the number of the light emitting elements LD. Furthermore, the surface treatment may be performed before the light emitting element LD is initially (or firstly) supplied, for example, after the second opening OP2 is formed in the first insulating layer INS1, or after the first bank BNK1 is formed.

For example, in case that an inorganic insulating layer (or an inorganic layer), a metal layer, and an organic insulating layer are surface-treated by using a fluorinated gas, a contact angle of the inorganic insulating layer (for example, the first insulating layer INS1) may be less than a contact angle of the metal layer (for example, the alignment electrodes ELT1 to ELT3), a contact angle of the metal layer (for example, the alignment electrodes ELT1 to ELT3) may be less than a contact angle of the organic insulating layer (for example, the protective layer PSV and/or the bank pattern layers BNP1 to BNP3), or a contact angle of the inorganic insulating layer (for example, the first insulating layer INS1) may be less than a contact angle of the metal layer (for example, the alignment electrodes ELT1 to ELT3) and the contact angle of the metal layer (for example, the alignment electrodes ELT1 to ELT3) may be less than a contact angle of the organic insulating layer (for example, the protective layer PSV and/or the bank pattern layers BNP1 to BNP3). For example, a contact angle of the inorganic insulating layer (for example, the first insulating layer INS1) may be about 10 degrees (e.g. 10 degrees to 30 degrees), a contact angle of the metal layer (for example, the alignment electrodes ELT1 to ELT3) may be about 30 degrees (e.g. 30 degrees to 60 degrees), and a contact angle of the organic insulating layer (for example, the protective layer PSV and/or the bank pattern layers BNP1 to BNP3) may be about 60 degrees (e.g. 60 degrees or greater). For example, the contact angle may be an angle formed by a tangent between a corresponding layer and the ink, and the greater the liquid repellancy of the surface, the greater the contact angle may be.

Thereafter, as shown in FIG. 10H, the ink INK (or the light emitting element LD) may be additionally (or secondly) supplied to the first sub-area A1, the second sub-area A2, and the third sub-area A3 which are weak areas. For example, the light emitting elements LD may be additionally supplied to only the weak area based on the information (for example, the coordinate information) of the weak area, which is previously generated in a process of detecting the number of the light emitting elements LD.

For example, in case that the ink INK is additionally supplied to the second sub-area A2, the ink INK may be positioned only in the second sub-area A2 without advancing (or overflowing) to another sub-area due to the LA having liquid repellancy. For example, the light emitting element LD may be additionally supplied only to the weak area, and the number of the light emitting elements LD may be uniformly adjusted for each sub-area.

An amount of ink INK discharged through a head of an inkjet printer may be preset. Accordingly, different heads may be used for first supply and second supply of the ink INK.

The alignment signals V_AL1 to V_AL3 may be applied to the electrodes ELT1 to ELT3 simultaneously with or after additional supply of the ink INK. For example, an electric field may be formed between the electrodes ELT1 to ELT3, and thus the additionally supplied light emitting element LD may be self-aligned between the electrodes ELT1 to ELT3.

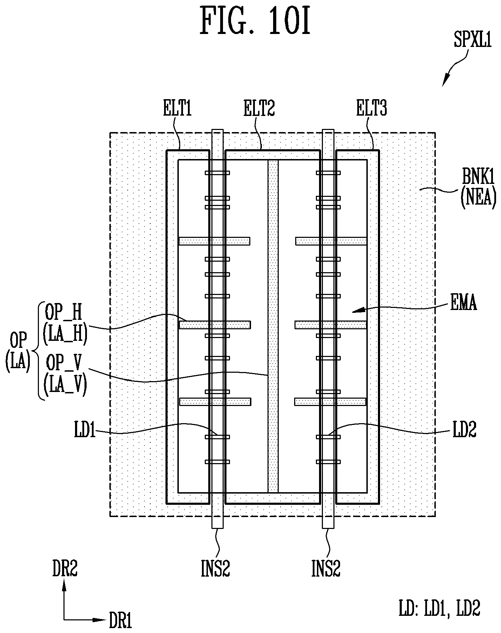

Thereafter, as shown in FIG. 10I, the second insulating layer INS2 may be formed on the light emitting element LD. The second insulating layer INS2 may fix the light emitting element LD and may extend in the second direction DR2 between the electrodes ELT1 to ELT3, and may expose the first and second end portions EP1 and EP2 of the light emitting element LD.

Thereafter, as shown in FIGS. 6 and 7A, the first contact electrode CNE1, the second contact electrode CNE2, and the first intermediate electrode CTE1 may be formed on the first and second end portions EP1 and EP2 of the light emitting element LD exposed by the second insulating layer INS2.

As described above, the first sub-pixel SPXL1 may include the opening OP passing through at least a portion of the electrodes ELT1 to ELT3 to expose the lower organic insulating layer (or organic layer), and the partial area LA of the organic layer exposed through the opening OP may be liquid repellant. The emission area EMA may be divided into the sub-areas by the area LA, and the light emitting element LD may be supplied only to the weak area among the sub-areas using the area LA having liquid repellancy.

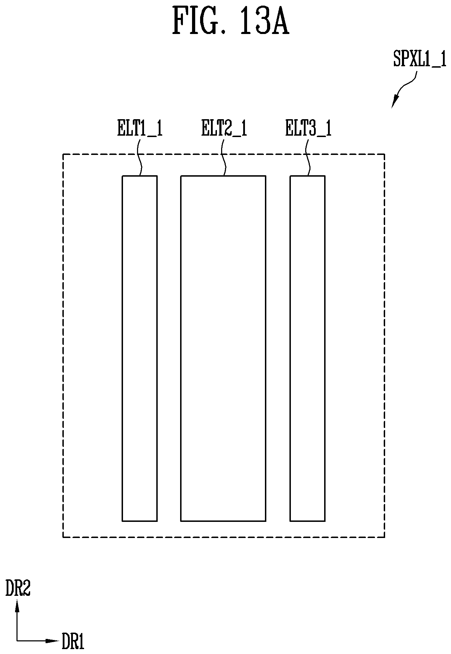

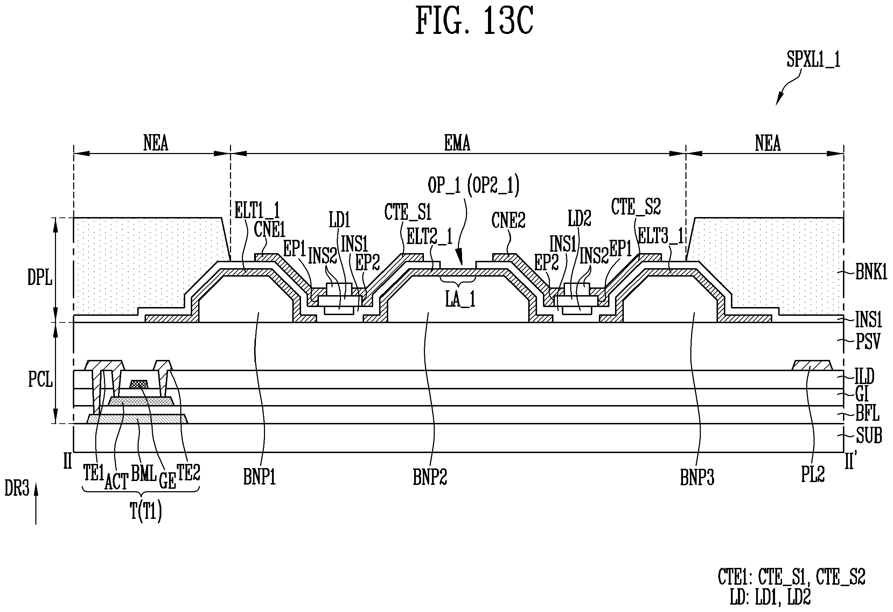

FIG. 13A is a schematic plan view illustrating an embodiment of electrodes included in the first sub-pixel of FIG. 5. FIG. 13A may correspond to FIG. 10B. FIG. 13B is a schematic plan view illustrating an embodiment of the first sub-pixel included in the display device of FIG. 3. The first sub-pixel SPXL1_1 of FIG. 13B may include electrodes ELT1_1 to ELT3_1 of FIG. 13A. FIG. 13C is a schematic cross-sectional view illustrating an embodiment of the first sub-pixel taken along a line II-II' of FIG. 13B. FIG. 13C may correspond to FIG. 7A.

Referring to FIGS. 5, 7A, 10B, and 13A to 13C, except for the electrodes ELT1_1 to ELT3_1, the first sub-pixel SPXL1_1 of FIGS. 13A to 13C may be substantially the same as or similar to the first sub-pixel SPXL1 of FIGS. 5 and 7A. Therefore, a redundant description is omitted for descriptive convenience.

The electrodes ELT1_1 to ELT3_1 of the first sub-pixel SPXL1_1 may not include the second opening OP2 (FIG. 10C). For example, an opening OP_1 formed in the first sub-pixel SPXL1_1 may be substantially the same as a second opening OP2_1 of the first insulating layer INS1 of FIG. 11, but embodiments are not limited thereto. A partial area LA_1 of the electrodes ELT1_1 to ELT3_1 (and the protective layer PSV in FIG. 13C) may be exposed by the opening OP_1. As shown in FIG. 13C, the partial area LA_1 of a second electrode ELT2_1 may be exposed, instead of the second bank pattern layer BNP2, by the opening OP_1 (or the second opening OP2_1 of the first insulating layer INS1).

FIGS. 14A and 14B are schematic plan views illustrating an embodiment of the first sub-pixel included in the display device of FIG. 3. FIGS. 14A and 14B may correspond to FIG. 6.

Referring to FIGS. 5, 6, 14A, and 14B, except for the first and second contact electrodes CNE1 and CNE2 and the intermediate electrodes CTE1_1 to CTE3_1, each of the first sub-pixel SPXL1_2 and the first sub-pixel SPXL1_3 of FIG. 14B may be substantially the same as or similar to the first sub-pixel SPXL1 of FIGS. 5 and 6. Therefore, a redundant description is omitted for descriptive convenience.

For convenience of description, the emission area EMA may be defined as first to fourth sub-emission areas EMA_S1 to EMA_S4 based on the vertical opening OP_V and the horizontal opening OP_H (a second horizontal opening OP_H in the second direction DR2). For example, light emitting elements LD disposed in the respective first to fourth sub-emission areas EMA_S1 to EMA_S4 are referred to as first to fourth light emitting elements LD1_1 to LD4_1.

Referring to FIGS. 5 and 14A, the first sub-pixel SPXL1_2 may further include a first contact electrode CNE1, a first intermediate electrode CTE1_1, a second intermediate electrode CTE2_1, a third intermediate electrode CTE3_1, and a second contact electrode CNE2. For example, the first sub-pixel SPXL1_2 may include four series stages. Since the first and second contact electrodes CNE1 and CNE2 are described with reference to FIG. 6, a redundant description is omitted for descriptive convenience.

The first contact electrode CNE1 may overlap a first end portion of a first light emitting element LD1_1 and the first electrode ELT1 in the first sub-emission area EMA_S1.

The first intermediate electrode CTE1_1 may overlap a second end portion of the first light emitting element LD1_1 and the second electrode ELT2 in the first sub-emission area EMA_S1. For example, the first intermediate electrode CTE1_1 may overlap a first end portion of a second light emitting element LD2_1 and the first electrode ELT1 in the second sub-emission area EMA_S2. For example, a portion of the first intermediate electrode CTE1_1 may have a curved shape (or a bent shape) between the first and second sub-emission areas EMA_S1 and EMA_S2. The first intermediate electrode CTE1_1 may physically and/or electrically connect the second end portion of the first light emitting element LD1_1 and the first end portion of the second light emitting element LD2_1.

The second intermediate electrode CTE2_1 may overlap a second end portion of the second light emitting element LD2_1 and the second electrode ELT2 in the second sub-emission area EMA_S2. For example, the second intermediate electrode CTE2_1 may overlap a first end portion of a third light emitting element LD3_1 and the third electrode ELT3 in the third sub-emission area EMA_S3. The second intermediate electrode CTE2_1 may have a shape bypassing the third intermediate electrode CTE3_1. The second intermediate electrode CTE2_1 may physically and/or electrically connect the second end portion of the second light emitting element LD2_1 and the first end portion of the third light emitting element LD3_1.

The third intermediate electrode CTE3_1 may overlap a second end portion of the third light emitting element LD3_1 and the second electrode ELT2 in the third sub-emission area EMA_S3. For example, the third intermediate electrode CTE3_1 may overlap a first end portion of the fourth light emitting element LD4_1 and the third electrode ELT3 in the fourth sub-emission area EMA_S4. For example, a portion of the third intermediate electrode CTE3_1 may have a curved shape (or a bent shape) between the third and fourth sub-emission areas EMA_S3 and EMA_S4. The third intermediate electrode CTE3_1 may physically and/or electrically connect the second end portion of the third light emitting element LD3_1 and the first end portion of the fourth light emitting element LD4_1.

The second contact electrode CNE2 may overlap a second end portion of the fourth light emitting element LD4_1 and the second electrode ELT2 in the fourth sub-emission area EMA_S4.

The first, second, third, and fourth light emitting elements LD1_1, LD2_1, LD3_1, and LD4_1 may be connected to each other in series between the first and second contact electrodes CNE1 and CNE2 through the intermediate electrodes CTE1_1 to CTE3_1. The first light emitting element LD1_1 may form a first series stage, a second light emitting element LD2_1 may form a second series stage, the third light emitting element LD3_1 may form a third series stage, and the fourth light emitting element LD4_1 may form a fourth series stage.

The first to fourth series stages may be separated from each other by the opening OP (and the partial area LA of the organic insulating layer exposed by the opening OP). Therefore, the light emitting element LD may be independently supplied to each of the first to fourth series stages by using the opening OP (and the partial area LA), and the number of the light emitting elements LD may be uniformly controlled for each of the first to fourth series stages.

Since a cross-section of the first sub-pixel SPXL1_2 taken along a line III-III' of FIG. 14A is substantially the same as or similar to the cross-section of at least one of FIGS. 7A, 7B, 8A to 8D, 9A, 9B, and 13C, a description of the cross-section (or a stack structure) of the first sub-pixel SPXL1_2 is omitted for descriptive convenience.

Referring to FIGS. 5 and 14B, the first sub-pixel SPXL1_3 may further include the first contact electrode CNE1, the first intermediate electrode CTE1_1, the second intermediate electrode CTE2_1, and the second contact electrode CNE2. Compared to the first sub-pixel SPXL1_2 of FIG. 14A, the first sub-pixel SPXL1_3 of FIG. 14B may not include the third intermediate electrode CTE3_1.

For example, as shown in FIG. 14B, the second intermediate electrode CTE2_1 may also overlap the first end portion of the fourth light emitting element LD4_1 in the fourth sub-emission area EMA_S4. For example, the second intermediate electrode CTE2_1 may physically and/or electrically connect the second end portion of the second light emitting element LD2_1 and the first end portion of the third and fourth light emitting elements LD3_1 and LD4_1. The second contact electrode CNE2 may also overlap the second end portion of the third light emitting element LD3_1 of the third sub-emission area EMA_S3. For example, the first light emitting element LD1_1, the second light emitting element LD2_1, and the third and fourth light emitting elements LD3_1 and LD4_1 may be connected to each other in series between the first and second contact electrodes CNE1 and CNE2 through the first and second intermediate electrodes CTE1_1 and CTE2_1. The first sub-pixel SPXL1_3 may have the pixel structure (or three series stages) shown in FIG. 4B. For example, the third and fourth light emitting elements LD3_1 and LD4_1 may form one series stage (for example, a third series stage).

As described above, a pixel structure of a sub-pixel may be variously changed according to a shape and a disposition of the intermediate electrodes CTE1_1 to CTE3_1 (two series stages of FIG. 6, four series stages of FIG. 14A, and three series stages of FIG. 14B), and the opening OP (and the area LA of the organic insulating layer exposed by the opening OP) may be applied to various pixel structures.

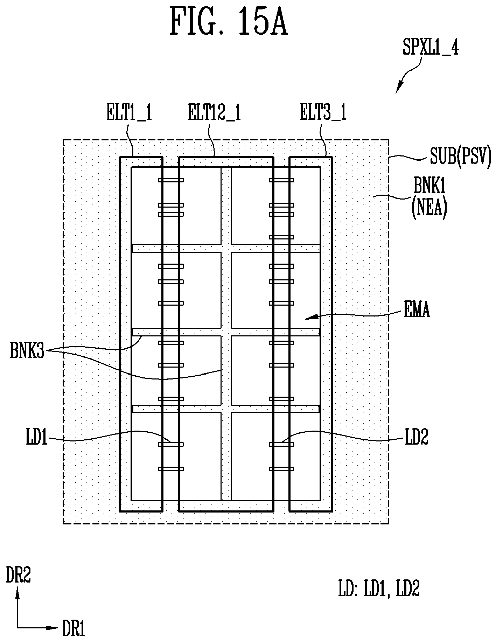

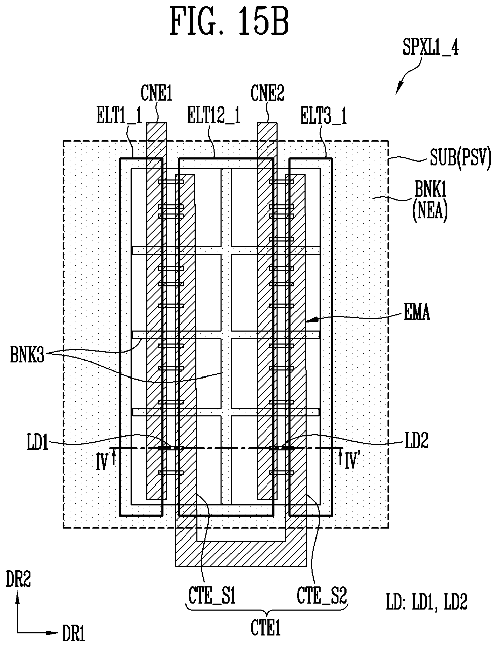

FIG. 15A is a schematic plan view illustrating an embodiment of the first sub-pixel included in the display device of FIG. 3. FIG. 15A may correspond to FIG. 5. FIG. 15B is a schematic plan view illustrating an embodiment of the first sub-pixel of FIG. 15A. FIG. 15B may correspond to FIG. 6. In FIG. 15A, the first sub-pixel SPXL1_4 may include two series stages, but this is an example, and embodiments are not limited thereto. The embodiments described with reference to FIGS. 14A and 14B may be applied to the first sub-pixel SPXL1_4 of FIG. 15A, and the first sub-pixel SPXL1_4 may have various pixel structures (e.g., various numbers of series stages).

Referring to FIGS. 5, 6, 15A, and 15B, the first sub-pixel SPXL1_4 may include a third bank BNK3 (or an auxiliary bank) instead of the opening OP. Except for the third bank BNK3, the first sub-pixel SPXL1_4 of FIGS. 15A and 15B may be substantially the same as or similar to the first sub-pixel SPXL1 of FIGS. 5 and 6. Therefore, a redundant description is omitted for descriptive convenience.

Since the opening OP is not formed, the electrodes ELT1_1 to ELT3_1 may not include a first opening. Referring to FIG. 13A, for example, each of the electrodes ELT1_1 to ELT3_1 may have a bar shape on a plane. However, embodiments are not limited thereto.

The third bank BNK3 may be disposed within the emission area EMA (e.g., the emission area EMA defined by the first bank BNK1), and may include a portion extending in the first direction DR1 (a portion corresponding to the horizontal opening OP_H of FIG. 5) and a portion extending in the second direction DR2 (a portion corresponding to the vertical opening OP_V of FIG. 5). An area in which the third bank BNK3 is positioned may be defined as the non-emission area NEA, but a width of the portions of the third bank BNK3 (the width in the first direction DR1 or the second direction DR2) may be relatively narrow compared to that of the first bank BNK1, and thus the description is given based on an embodiment in which the third bank BNK3 is disposed in the emission area EMA.

The third bank BNK3 may divide the emission area EMA into sub-areas. As shown in FIG. 15A, the third bank BNK3 may divide the emission area EMA into eight sub-areas, but embodiments are not limited thereto. The third bank BNK3 may have substantially the same function as the opening OP of FIG. 5 (and FIG. 10G).

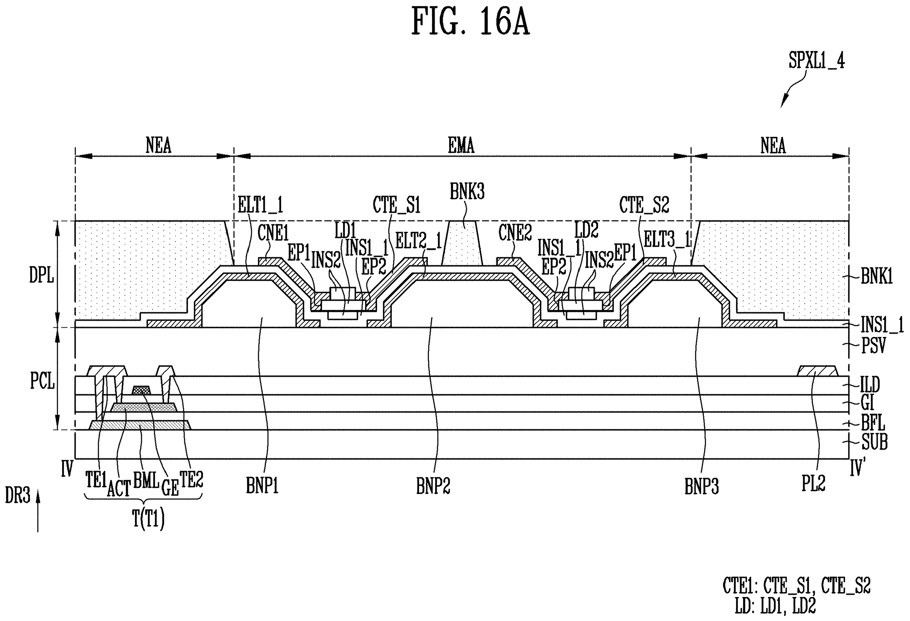

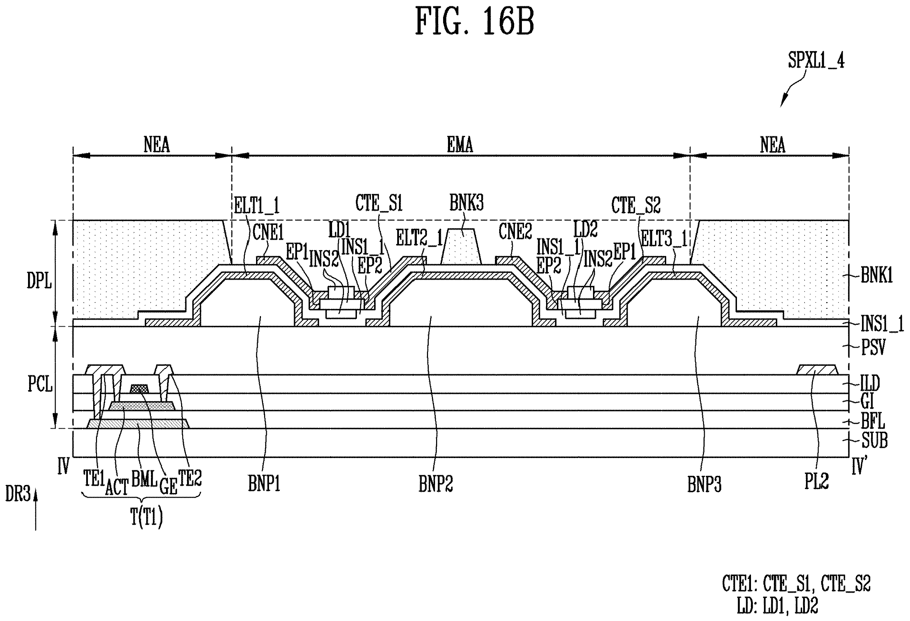

FIGS. 16A and 16B are schematic cross-sectional views illustrating an embodiment of the first sub-pixel taken along a line IV-IV' of FIG. 15B. FIGS. 16A and 16B may correspond to FIG. 7A. The above-described embodiment (for example, the embodiments of FIGS. 8C, 8D, 9A, 9B, and 13C) may be applied to the first sub-pixel SPXL1_4 of FIGS. 16A and 16B.

Referring to FIGS. 7A, 14, 15A, 15B, 16A, and 16B, except for the electrodes ELT1_1 to ELT3_1, the first insulating layer INS1_1, and the third bank BNK3, the first sub-pixel SPXL1_4 may be substantially the same as or similar to the first sub-pixel SPXL1 of FIG. 7A. Therefore, a redundant description is omitted for descriptive convenience.

Since the opening OP of FIG. 7A is not formed, the electrodes ELT1_1 to ELT3_1 may substantially cover the bank pattern layers BNP1 to BNP3, and the first insulating layer INS1_1 may also cover the electrodes ELT1_1 to ELT1_1 to ELT3_1 and the protective layer PSV. For example, the protective layer PSV and the bank pattern layers BNP1 to BNP3 may not be substantially exposed by the first insulating layer INS1_1 in the emission area EMA.

The third bank BNK3 may be positioned on the first insulating layer INS1_1.

The third bank BNK3 may be a structure that divides (or defines) the emission area EMA into sub-areas. The third bank BNK3 may be a pixel defining layer or a dam structure that defines a sub-area to which the light emitting element LD is required to be supplied in a process of supplying (or secondary supplying) the light emitting element LD to each of the sub-areas. According to an embodiment, the third bank BNK3 may be liquid repellant.

The third bank BNK3 may include an organic material such as acrylates resin, epoxy resin, phenolic resin, polyamides resin, polyimides resin, polyester resin, polyphenylenesulfides resin, or benzocyclobutene (BCB). However, embodiments are not limited thereto, and the third bank BNK3 may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

According to an embodiment, the third bank BNK3 may be formed by a process different from a process for forming the first bank BNK1. For example, a process of forming the third bank BNK3 may be performed substantially simultaneously with the detection of the number of the light emitting elements LD (refer to FIG. 10F), similar to a process of forming the opening OP described with reference to FIG. 10G. However, embodiments are not limited thereto. For example, the third bank BNK3 may be simultaneously formed by the same process as the first bank BNK1.

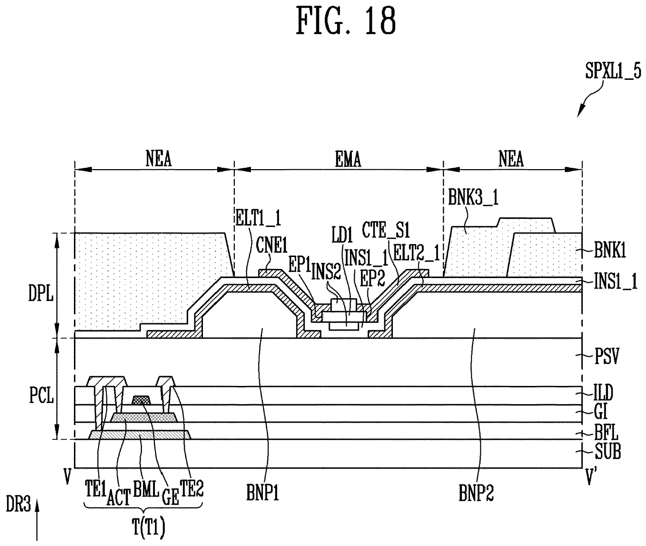

In an embodiment, as shown in FIG. 16A, with respect to the substrate SUB (or the protective layer PSV), a height (or a height of an upper surface) of the third bank BNK3 may be the same as a height of the first bank BNK1. In another example, as shown in FIG. 16B, the height of the third bank BNK3 may be lower than the height of the first bank BNK1 (refer to FIG. 16B). For example, an amount of ink (or an amount per unit area) additionally (or secondly) supplied may be less than an amount of ink initially (or firstly) supplied. Accordingly, the height of the third bank BNK3 may be lower than the height of the first bank BNK1. However, embodiments are not limited thereto. For example, the height of the third bank BNK3 may be higher than the height of the first bank BNK1 (refer to FIG. 18).

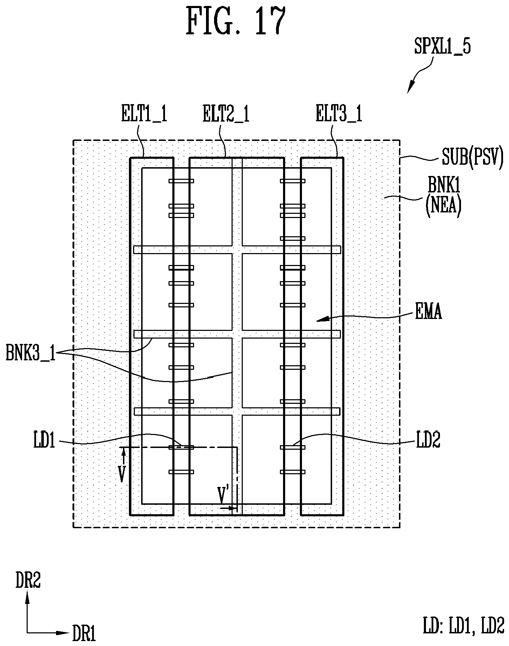

FIG. 17 is a schematic plan view illustrating an embodiment of the first sub-pixel included in the display device of FIG. 3. FIG. 17 may correspond to FIG. 15A. FIG. 18 is a schematic cross-sectional view illustrating an embodiment of the first sub-pixel taken along a line V-V' of FIG. 17.

Referring to FIGS. 15A, 16A, 17, and 18, except for a third bank BNK3_1, the first sub-pixel SPXL1_5 may be substantially the same as or similar to the first sub-pixel SPXL1_4 of FIGS. 15A and 16A. Therefore, a redundant description is omitted for descriptive convenience.

The third bank BNK3_1 may extend to the non-emission area NEA, and the third bank BNK3_1 may partially overlap the first bank BNK1.

As shown in FIG. 18, the third bank BNK3_1 may be disposed on the first bank BNK1. For example, a maximum height of the third bank BNK3_1 may be higher than the height of the first bank BNK1 with respect to the substrate SUB (or the protective layer PSV).

The above-described embodiment (for example, the embodiments of FIGS. 8C, 8D, 9A, 9B, 14A, 14B, and 16A) may be applied to the first sub-pixel SPXL1_5 of FIGS. 17 and 18.

FIGS. 19A to 19C are schematic plan views illustrating an embodiment of the first sub-pixel included in the display device of FIG. 3. FIGS. 19A to 19C may correspond to FIG. 5 or 15A.

Referring to FIGS. 5, 15A, and 19A to 19C, the first sub-pixel SPXL1_6 of FIGS. 19A to 19C may include an opening OP_2 and/or a third bank BNK3_2, a shape of the opening OP_2 and/or a shape of the third bank BNK3_2 may be variously changed. Except for the opening OP_2 and the third bank BNK3_2, since the first sub-pixel SPXL1_6 of FIGS. 19A to 19C is substantially the same as or similar to the first sub-pixel SPXL1 of FIG. 5 or the first sub-pixel SPXL1_4 of FIG. 15A, a redundant description is omitted for descriptive convenience.

In an embodiment, in case that the first sub-pixel SPXL1_6 includes the opening OP_2, as shown in FIG. 19A, the opening OP_2 may include one horizontal opening OP_H and one vertical opening OP_V. For example, the opening OP_2 of the first sub-pixel SPXL1_6 shown in FIG. 19A may divide the emission area EMA into the sub-emission areas EMA_S1 to EMA_S4 described with reference to FIG. 14A (or sub-areas corresponding to four series stages).

In FIG. 19A, the horizontal opening OP_H and the vertical opening OP_V may be connected to each other or may be integral with each other, but embodiments are not limited thereto. For example, similar to the description above with reference to FIG. 5, the horizontal opening OP_H and the vertical opening OP_V may be spaced apart from each other.

In another example, in case that the first sub-pixel SPXL1_6 includes the third bank BNK3_2, as shown in FIG. 19A, the third bank BNK3_2 may include one horizontal bank BNK3_H (or a first sub-bank) and one vertical bank BNK3_V (or a second sub-bank). For example, the third bank BNK3_2 of the first sub-pixel SPXL1_6 shown in FIG. 19A may divide the emission area EMA into the sub-emission areas EMA_S1 to EMA_S4 described with reference to FIG. 14A (or four sub-areas corresponding to four series stages). According to an embodiment, the third bank BNK3_2 may extend to the non-emission area NEA.

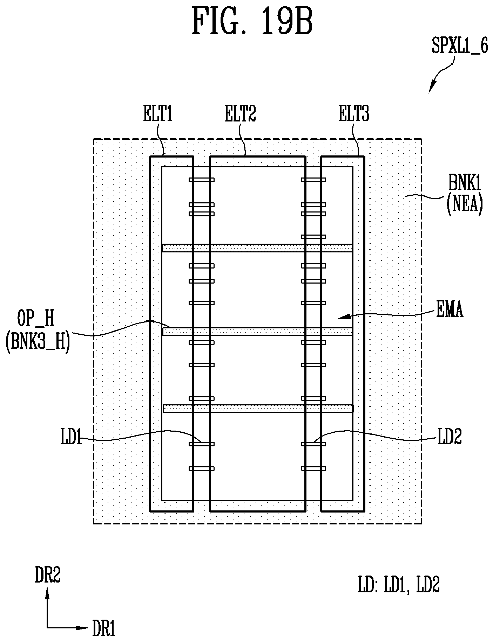

In an embodiment, as shown in FIG. 19B, the first sub-pixel SPXL1_6 may include only the horizontal opening OP_H. As shown in FIG. 7A or the like, the second electrode ELT2 may relatively protrude in a front surface direction, and thus an ink provided to a specific sub-area may not pass beyond the second electrode ELT2 and may not invade a sub-area adjacent in the second direction DR2.

In FIG. 19B, the horizontal opening OP_H may extend to cross the emission area EMA, but embodiments are not limited thereto. For example, similar to the description above with reference to FIG. 5, the horizontal opening OP_H may be divided into openings, or may include sub-openings spaced apart from each other.

In an embodiment, as shown in FIG. 19B, the first sub-pixel SPXL1_6 may include only the horizontal bank BNK3_H (or the first sub-bank).

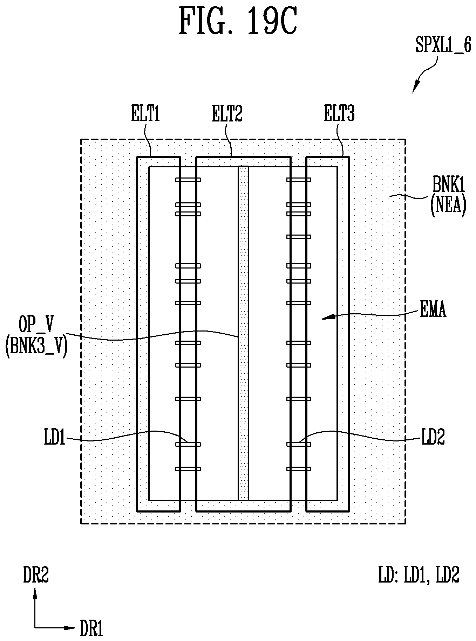

In an embodiment, as shown in FIG. 19C, the first sub-pixel SPXL1_6 may include only the vertical opening OP_V. For example, the vertical opening OP_V of the first sub-pixel SPXL1_6 shown in FIG. 19C may divide the emission area EMA into the two sub-areas described with reference to FIG. 6 (e.g., the sub-areas corresponding to the two series stages).

In an embodiment, as shown in FIG. 19C, the first sub-pixel SPXL1_6 may include only the vertical bank BNK3_V (or the second sub-bank).

According to an embodiment, the first sub-pixel SPXL1_6 may selectively include the horizontal opening OP_H, the vertical opening OP_V, the horizontal bank BNK3_H, and the vertical bank BNK3_V. For example, the first sub-pixel SPXL1_6 may include the horizontal opening OP_H shown in FIG. 19B and the vertical bank BNK3_V shown in FIG. 19C. In another example, the first sub-pixel SPXL1_6 may include the horizontal bank BNK3_H shown in FIG. 19B and the vertical opening OP_V shown in FIG. 19C.

As described above, the first sub-pixel SPXL1_6 may selectively include the opening OP_2 and the third bank BNK3_2. For example, a shape of the opening OP_2 and/or a shape of the third bank BNK3_2 included in the first sub-pixel SPXL1_6 may be variously changed.

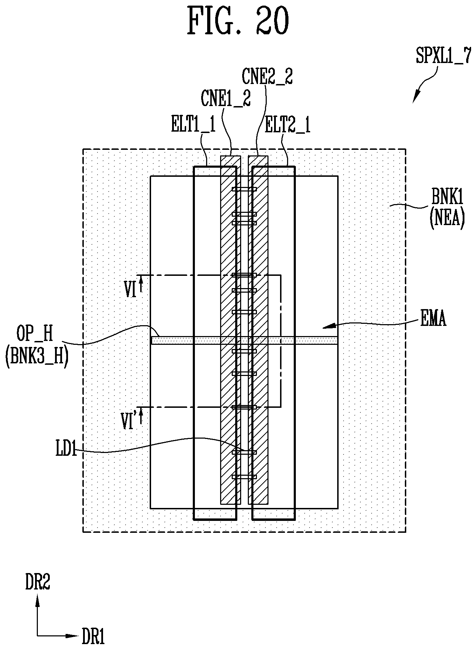

FIG. 20 is a schematic plan view illustrating an embodiment of the first sub-pixel included in the display device of FIG. 3. FIG. 20 may correspond to FIG. 5.

Referring to FIGS. 5 and 20, the first sub-pixel SPXL1_7 may include a first bank BNK1, first and second electrodes ELT1_1 and ELT2_1, and a first light emitting element LD1. For example, the first sub-pixel SPXL1_7 may include first and second contact electrodes CNE1_2 and CNE2_2.

Since the first bank BNK1, the first and second electrodes ELT1_1 and ELT2_1, the first light emitting element LD1, and the first contact electrode CNE1_2 may be substantially the same as or similar to the first bank BNK1, the first and second electrodes ELT1 and ELT2, the first light emitting element LD1, and the first contact electrode CNE1 described with reference to FIG. 6, a redundant description is omitted for descriptive convenience.

The first and second electrodes ELT1_1 and ELT2_1 are shown as being spaced apart from the first bank BNK1 in the first direction DR1, but embodiments are not limited thereto. For example, similar to the first and third electrodes ELT1 and ELT3 shown in FIG. 5, the first and second electrodes ELT1_1 and ELT2_1 may extend in the first direction DR1 and may partially overlap the first bank BNK1.

The second contact electrode CNE2_2 may overlap the second end portion of each of the first light emitting elements LD1 and the second electrode ELT2_1. According to an embodiment, the second contact electrode CNE2_2 may physically and/or electrically connect the second end portion of the first light emitting element LD1 and the second electrode ELT2_1. However, embodiments are not limited thereto, and for example, the second contact electrode CNE2_2 may be electrically separated from the second electrode ELT2_1. The second contact electrode CNE2_2 may be connected to the second power line PL2 (refer to FIG. 7A) through a contact hole or the like. The second contact electrode CNE2_2 may extend in the second direction DR2 in correspondence with the second electrode ELT2_1.

In embodiments, the first sub-pixel SPXL1_7 may include the horizontal opening OP_H and/or the horizontal bank BNK3_H (or the first sub-bank). Since the horizontal opening OP_H and the horizontal bank BNK3_H (or the first sub-bank) are described with reference to other embodiments, a redundant description is omitted for descriptive convenience.

The horizontal opening OP_H or the horizontal bank BNK3_H may divide a single emission area EMA (or a single series stage) into two sub-areas, and may prevent the first light emitting element LD1 from being concentrated on a specific sub-area, or may guide the number of the first light emitting elements LD1 to be uniform for each sub-area. For example, the first light emitting elements LD1 may be dispersed by additionally supplying the first light emitting elements LD1 to a sub-area in which the number of the first light emitting elements LD1 is relatively small.

In FIG. 20, the horizontal opening OP_H may extend to cross the emission area EMA, but embodiments are not limited thereto. For example, similar to the description above with reference to FIG. 5, the horizontal opening OP_H may be divided into openings, or may include sub-openings spaced apart from each other.

The horizontal opening OP_H and the horizontal bank BNK3_H are shown as being positioned only in the emission area EMA, but embodiments are not limited thereto. The horizontal opening OP_H and the horizontal bank BNK3_H may extend to the non-emission area NEA or may also be positioned in the non-emission area NEA.

Since a cross-section of the first sub-pixel SPXL1_7 taken along a line VI-VI' of FIG. 20 is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_7 is omitted for descriptive convenience.

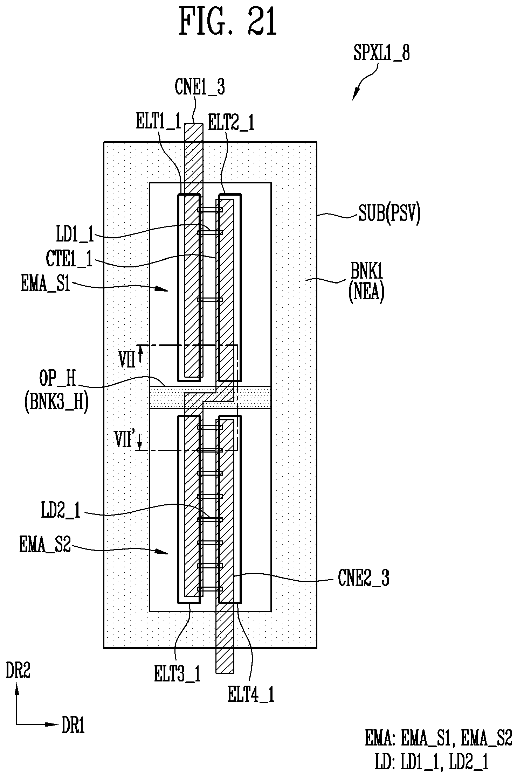

FIG. 21 is a schematic plan view illustrating an embodiment of the first sub-pixel included in the display device of FIG. 3.

Referring to FIGS. 20 and 21, the first sub-pixel SPXL1_8 may include a first bank BNK1, electrodes ELT1_1 to ELT4_1, and a light emitting element LD. The first sub-pixel SPXL1_8 may include first and second contact electrodes CNE1_3 and CNE2_3 and a first intermediate electrode CTE1_1. For example, the first sub-pixel SPXL1_8 may include a horizontal opening OP_H or a horizontal bank BNK3_H (or a first sub-bank).

Since the first bank BNK1, the first and second electrodes ELT1_1 and ELT2_1, the light emitting element LD, the horizontal opening OP_H, and the horizontal bank BNK3_H (or the first sub-bank) of FIG. 21 may be substantially the same as or similar to the first bank BNK1, the first and second electrodes ELT1_1 and ELT2_1, the first light emitting element LD1, the horizontal opening OP_H, and the horizontal bank BNK3_H (or the first sub-bank) of FIG. 20, respectively, a redundant description is omitted for descriptive convenience. For example, since the first contact electrode CNE1_3, the first intermediate electrode CTE1_1, and the second contact electrode CNE2_3 of FIG. 21 are substantially the same as or similar to the first contact electrode CNE1, the first intermediate electrode CTE1_1, and the second intermediate electrode CTE2_1 of FIG. 14A, respectively, a redundant description is omitted for descriptive convenience.

The horizontal opening OP_H or the horizontal bank BNK3_H may divide a single emission area EMA into first and second sub-emission areas EMA_S1 and EMA_S2 (or sub-areas).

A first electrode ELT1_1 and a second electrode ELT2_1 may be disposed in the first sub-emission area EMA_S1. A third electrode ELT3_1 and a fourth electrode ELT4_1 may be disposed in the second sub-emission area EMA_S2 and may be spaced apart from each other in the first direction DR1. The first electrode ELT1_1 and the third electrode ELT3_1 may be arranged along the second direction DR2, and the second electrode ELT2_1 and the fourth electrode ELT4_1 may be arranged along the second direction DR2. However, embodiments are not limited thereto. The third and fourth electrodes ELT3_1 and ELT4_1 and the first and second electrodes ELT1_1 and ELT2_1 may include the same material and may be simultaneously formed by the same process.

The first contact electrode CNE1_3 may overlap the first end portion of the first light emitting element LD1_1 and the first electrode ELT1_1 in the first sub-emission area EMA_S1.

The first intermediate electrode CTE1_1 may overlap the second end portion of the first light emitting element LD1_1 and the second electrode ELT2_1 in the first sub-emission area EMA_S1. For example, the first intermediate electrode CTE1_1 may overlap the first end portion of the second light emitting element LD2_1 and the third electrode ELT3_1 in the second sub-emission area EMA_S2. For example, a portion of the first intermediate electrode CTE1_1 may have a curved shape (or a bent shape) between the first and second sub-emission areas EMA_S1 and EMA_S2. The first intermediate electrode CTE1_1 may physically and/or electrically connect the second end portion of the first light emitting element LD1_1 and the first end portion of the second light emitting element LD2_1.

The second contact electrode CNE2_3 may overlap the second end portion of the second light emitting element LD2_1 and the fourth electrode ELT4_1 in the second sub-emission area EMA_S2.

The first and second light emitting elements LD1_1 and LD2_1 may be connected to each other in series between the first and second contact electrodes CNE1_3 and CNE2_3 through the first intermediate electrode CTE1_1. The first light emitting element LD1_1 may form a first series stage, and the second light emitting element LD2_1 may form a second series stage.

The first and second series stages may be distinguished from each other by the horizontal opening OP_H (or a portion of the organic insulating layer exposed by the horizontal opening OP_H and having liquid repellancy) or the horizontal bank BNK3_H. Therefore, the light emitting element LD may be independently supplied to each of the first and second series stages (or the first and second sub-emission areas EMA_S1 and EMA_S2) by using the horizontal opening OP_H or the horizontal bank BNK3_H, and the number of the light emitting elements LD may be uniformly controlled for each of series stages.

Since a cross-section of the first sub-pixel SPXL1_8 taken along a line VII-VII' of FIG. 21 is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_8 is omitted for descriptive convenience.

In FIG. 21, the first sub-pixel SPXL1_8 may include a single horizontal opening OP_H or a horizontal bank BNK3_H, but embodiments are not limited thereto. For example, similar to the description above with reference to FIG. 20, the first sub-pixel SPXL1_8 may further include the horizontal opening OP_H or the horizontal bank BNK3_H disposed in each of the first and second sub-emission areas EMA_S1 and EMA_S2.

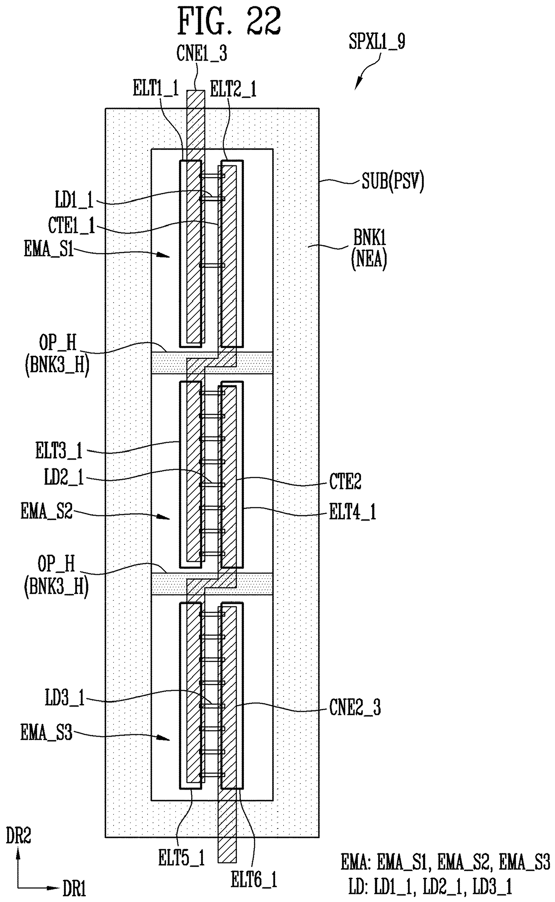

FIG. 22 is a schematic plan view illustrating an embodiment of the first sub-pixel included in the display device of FIG. 3.

Referring to FIGS. 21 and 22, the first sub-pixel SPXL1_9 may further include fifth and sixth electrodes ELT5_1 and ELT6_1 and a second intermediate electrode CTE2 disposed in a third sub-emission area EMA_S3.

The horizontal opening OP_H or the horizontal bank BNK3_H may divide a single emission area EMA into three sub-emission areas EMA_S1 to EMA_S3 (or sub-areas) along the second direction DR2.

The fifth electrode ELT5_1 and the sixth electrode ELT6_1 may be disposed in the third sub-emission area EMA_S3 and may be spaced apart from each other in the first direction DR1. The first electrode ELT1_1, the third electrode ELT3_1, and the fifth electrode ELT5_1 may be arranged along the second direction DR2, and the second electrode ELT2_1, the fourth electrode ELT4_1, and the sixth electrode ELT6_1 may be arranged along the second direction DR2. However, embodiments are not limited thereto. The electrodes ELT1_1 to ELT6_1 may include the same material and may be simultaneously formed by the same process.

The second intermediate electrode CTE2 may overlap the second end portion of the second light emitting element LD2_1 and the fourth electrode ELT4_1 in the second sub-emission area EMA_S2. For example, the second intermediate electrode CTE2 may overlap the first end portion of the third light emitting element LD3_1 and the fifth electrode ELT5_1 in the third sub-emission area EMA_S3. For example, a portion of the second intermediate electrode CTE2 may have a curved shape (or a bent shape) between the second and third sub-emission areas EMA_S2 and EMA_S3. The second intermediate electrode CTE2 may physically and/or electrically connect the second end portion of the second light emitting element LD2_1 and the first end portion of the third light emitting element LD3_1.

The second contact electrode CNE2_3 may overlap the second end portion of the third light emitting element LD3_1 and the sixth electrode ELT6_1 in the third sub-emission area EMA_S3.

The first, second, and third light emitting elements LD1_1, LD2_1, and LD3_1 may be connected to each other in series between the first and second contact electrodes CNE1_3 and CNE2_3 through the first and second intermediate electrodes CTE1_1 and CTE2. The first light emitting element LD1_1 may form a first series stage, the second light emitting element LD2_1 may form a second series stage, and the third light emitting element LD3_1 may form a third series stage.

The first, second, and third series stages may be distinguished from each other by the horizontal opening OP_H (or the partial area of the organic insulating layer exposed by the horizontal opening OP_H and having liquid repellancy) or the horizontal bank BNK3_H. Therefore, the light emitting element LD may be independently supplied to each of the first, second, and third series stages (or the first, second, and third sub-emission areas EMA_S1, EMA_S2, and EMA_S3) by using the horizontal opening OP_H or the horizontal bank BNK3_H), and the number of the light emitting elements LD may be uniformly controlled for each of series stages.

In FIG. 22, the first sub-pixel SPXL1_9 may include only the horizontal opening OP_H or the horizontal bank BNK3_H that divides the sub-emission areas EMA_S1 to EMA_S3, but embodiments are not limited thereto. For example, similar to the description above with reference to FIG. 20, the first sub-pixel SPXL1_9 may further include the horizontal opening OP_H or the horizontal bank BNK3_H disposed in each of the sub-emission areas EMA_S1 to EMA_S3.

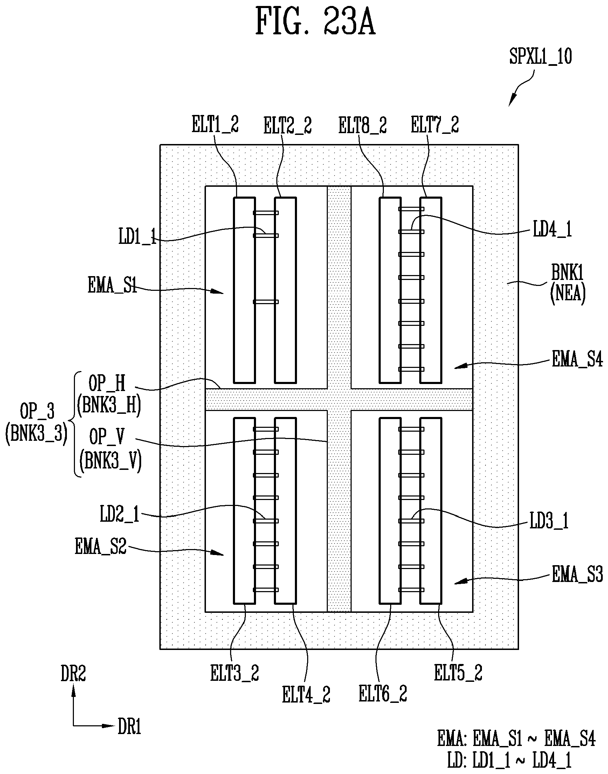

FIG. 23A is a schematic plan view illustrating an embodiment of the first sub-pixel included in the display device of FIG. 3.

Referring to FIGS. 5, 21, and 23A, except that electrodes ELT1_2 to ELT8_2 are separated from each other based on an opening OP_3 and/or a third bank BNK3_3, the first sub-pixel SPXL1_10 of FIG. 23A may be substantially the same as or similar to the first sub-pixel SPXL1 of FIG. 5 (or the first sub-pixel SPXL1_8 of FIG. 21). Therefore, a redundant description is omitted for descriptive convenience.

The opening OP_3 or the third bank BNK3_3 may divide a single emission area EMA into four sub-emission areas EMA_S1 to EMA_S4 (or sub-areas). For example, the horizontal opening OP_H or the horizontal bank BNK3_H may divide first and fourth sub-emission areas EMA_S1 and EMA_S4 and the second and third sub-emission areas EMA_S2 and EMA_S3, and the vertical opening OP_V or the vertical bank BNK3_V may divide the first and second sub-emission areas EMA_S1 and EMA_S2 and the third and fourth sub-emission areas EMA_S3 and EMA_S4.

A first electrode ELT1_2 and a second electrode ELT2_2 may be disposed in the first sub-emission area EMA_S1. A third electrode ELT3_2 and a fourth electrode ELT4_2 may be disposed in the second sub-emission area EMA_S2.

A fifth electrode ELT5_2 and a sixth electrode ELT6_2 may be disposed in the third sub-emission area EMA_S3 and may be spaced apart from each other in the first direction DR1. The fifth electrode ELT5_2 and the sixth electrode ELT6_2 may be spaced apart from the fourth electrode ELT4_2 in the first direction DR1.

A seventh electrode ELT7_2 and an eighth electrode ELT8_2 may be disposed in the fourth sub-emission area EMA_S4 and may be spaced apart from each other in the first direction DR1. The seventh electrode ELT7_2 and the eighth electrode ELT8_2 may be spaced apart from the second electrode ELT2_2 in the first direction DR1. The seventh electrode ELT7_2 and the fifth electrode ELT5_2 may be arranged along the second direction DR2, and the eighth electrode ELT8_2 and the sixth electrode ELT6_2 may be arranged along the second direction DR2. However, embodiments are not limited thereto. The electrodes ELT1_2 to ELT8_2 may include the same material and may be simultaneously formed by the same process.

The electrodes ELT1_2 to ELT8_2 may be spaced apart from the opening OP_3 or the third bank BNK3_3, but embodiments are not limited thereto. For example, mutually facing end portions or sides of the electrodes ELT1_2 to ELT8_2 may contact the opening OP_3 or the third bank BNK3_3. In another example, the opening OP_3 or the third bank BNK3_3 may partially overlap the electrodes ELT1_2 to ELT8_2.

In FIG. 23A, the opening OP_3 or the third bank BNK3_3 divides only the sub-emission areas EMA_S1 to EMA_S4, but embodiments are not limited thereto. For example, similar to the description above with reference to FIG. 20, the first sub-pixel SPXL1_10 may further include the horizontal opening OP_H or the horizontal bank BNK3_H disposed in each of the sub-emission areas EMA_S1 to EMA_S4.

For example, in FIG. 23A, the horizontal opening OP_H and the vertical opening OP_V of the opening OP_3 may be integral with each other, but embodiments are not limited thereto. Similar to the description above with reference to FIG. 5, the opening OP_3 may include a horizontal opening OP_H and a vertical opening OP_V that are spaced apart from each other.

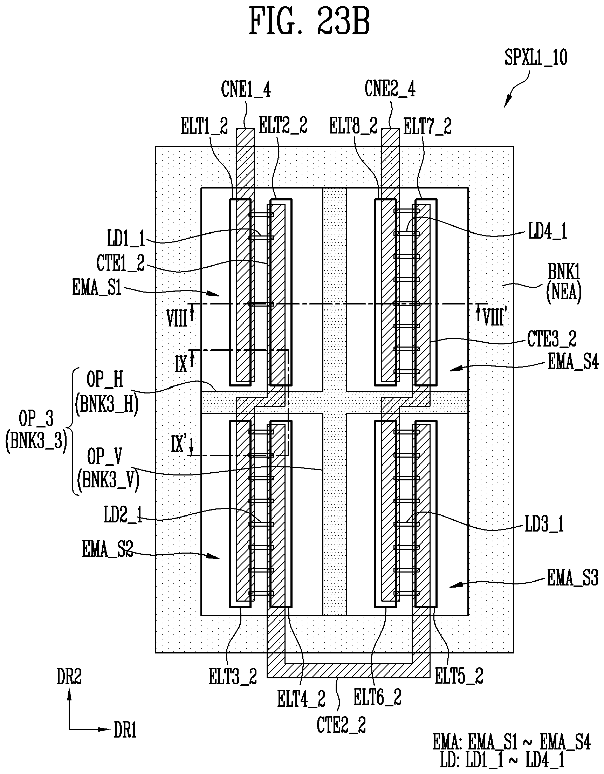

FIG. 23B is a schematic plan view illustrating an embodiment of the first sub-pixel included in the display device of FIG. 3.

Referring to FIGS. 5, 14A, 23A, and 23B, the first sub-pixel SPXL1_10 may further include first and second contact electrodes CNE1_4 and CNE2_4 and intermediate electrodes CTE1_2 to CTE3_2. Since the first and second contact electrodes CNE1_4 and CNE2_4 and the intermediate electrodes CTE1_2 to CTE3_2 of FIG. 23B are substantially the same as or similar to the first and second contact electrodes CNE1 and CNE2 and the intermediate electrodes CTE1_1 to CTE3_1 of FIG. 14A, a redundant description is omitted for descriptive convenience.

The first contact electrode CNE1_4 may overlap the first end portion of the first light emitting element LD1_1 and the first electrode ELT1_2 in the first sub-emission region EMA_S1.

A first intermediate electrode CTE1_2 may overlap the second end portion of the first light emitting element LD1_1 and the second electrode ELT2_2 in the first sub-emission area EMA_S1. For example, the first intermediate electrode CTE1_2 may overlap the first end portion of the second light emitting element LD2_1 and the third electrode ELT3_2 in the second sub-emission area EMA_S2. The first intermediate electrode CTE1_2 may physically and/or electrically connect the second end portion of the first light emitting element LD1_1 and the first end portion of the second light emitting element LD2_1.

A second intermediate electrode CTE2_2 may overlap the second end portion of the second light emitting element LD2_1 and the fourth electrode ELT4_2 in the second sub-emission area EMA_S2. For example, the second intermediate electrode CTE2_2 may overlap the first end portion of the third light emitting element LD3_1 and the fifth electrode ELT5_2 in the third sub-emission area EMA_S3. The second intermediate electrode CTE2_2 may physically and/or electrically connect the second end portion of the second light emitting element LD2_1 and the first end portion of the third light emitting element LD3_1.

A third intermediate electrode CTE3_2 may overlap the second end portion of the third light emitting element LD3_1 and the sixth electrode ELT6_2 in the third sub-emission area EMA_S3. For example, the third intermediate electrode CTE3_2 may overlap the first end portion of the fourth light emitting element LD4_1 and the seventh electrode ELT7_2 in the fourth sub-emission area EMA_S4. The third intermediate electrode CTE3_1 may physically and/or electrically connect the second end portion of the third light emitting element LD3_1 and the first end portion of the fourth light emitting element LD4_1.

The second contact electrode CNE2_4 may overlap the second end portion of the fourth light emitting element LD4_1 and the eighth electrode ELT8_2 in the fourth sub-emission area EMA_S4.

The first, second, third, and fourth light emitting elements LD1_1, LD2_1, LD3_1, and LD4_1 may be connected to each other in series between the first and second contact electrodes CNE1_4 and CNE2_4 through the intermediate electrodes CTE1_2 to CTE3_2. The first light emitting element LD1_1 may form a first series stage, the second light emitting element LD2_1 may form a second series stage, the third light emitting element LD3_1 may form a third series stage, and the fourth light emitting element LD4_1 may form a fourth series stage.

The first to fourth series stages (or the sub-emission areas EMA_S1 to EMA_S4) may be distinguished from each other by the opening OP_3 (and the partial area of the organic insulating layer exposed by the opening OP_3 and having liquid repellancy). Therefore, the light emitting element LD may be independently supplied to each of the first to fourth series stages by using the opening OP_3 (and the partial area), and the number of the light emitting elements LD may be uniformly controlled for each of series stages.

Since a cross-section of the first sub-pixel SPXL1_10 taken along a line VIII-VIII' of FIG. 23B and/or a cross-section of the first sub-pixel SPXL1_10 taken along a line IX-IX' of FIG. 23B is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_10 is be omitted for descriptive convenience.

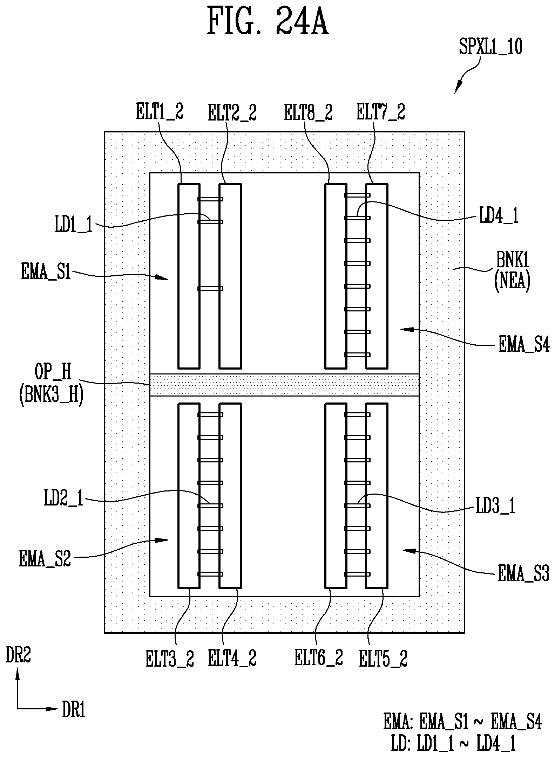

FIGS. 24A to 24C are schematic plan views illustrating an embodiment of the first sub-pixel included in the display device of FIG. 3. FIGS. 24A to 24C may correspond to FIG. 23A or 23B.

Referring to FIGS. 19B, 19C, 23A, 23B, and 24A to 24C, the first sub-pixel SPXL1_10 of FIGS. 24A to 24C may include the opening OP_3 and/or the third bank BNK3_3. However, a shape of the opening OP_3 and/or a shape of the third bank BNK3_3 may be variously changed.

In an embodiment, as shown in FIG. 24A, the first sub-pixel SPXL1_10 may include only the horizontal opening OP_H or the horizontal bank BNK3_H that divides the first and fourth sub-emission areas EMA_S1 and EMA_S4 and the second and third sub-emission areas EMA_S2 and EMA_S3.

In another example, as shown in FIG. 24B, the first sub-pixel SPXL1_10 may include horizontal openings OP_H and/or horizontal banks BNK3_H arranged along the second direction DR2.

In case that the horizontal opening OP_H overlaps the electrodes ELT1_2 to ELT8_2 or in case that the horizontal opening OP_H is formed in the electrodes ELT1_2 to ELT8_2, the electrodes ELT1_2 to ELT8_2 may be separated (or divided) into two sub-electrodes. However, embodiments are not limited thereto. For example, similar to the description above with reference to FIG. 5, the horizontal opening OP_H may include sub-openings spaced apart from each other so that each of the electrodes ELT1_2 to ELT8_2 may not be separated into sub-electrodes.

According to an embodiment, the first sub-pixel SPXL1_10 may include the horizontal opening OP_H and the horizontal bank BNK3_H. For example, the first sub-pixel SPXL1_10 may include horizontal bank BNK3_H dividing the sub-emission areas EMA_S1 to EMA_S4 and the horizontal opening OP_H dividing each of the sub-emission areas EMA_S1 to EMA_S4 into sub-areas. In another example, the first sub-pixel SPXL1_10 may include the horizontal opening OP_H dividing the sub-emission areas EMA_S1 to EMA_S4 and the horizontal bank BNK3_H dividing each of the sub-emission areas EMA_S1 to EMA_S4 into sub-areas.

In FIG. 24B, three horizontal openings OP_H or horizontal banks BNK3_H may be included, but embodiments are not limited thereto, and the number of the horizontal openings OP_H or the number of the horizontal banks BNK3_H may be variously changed.

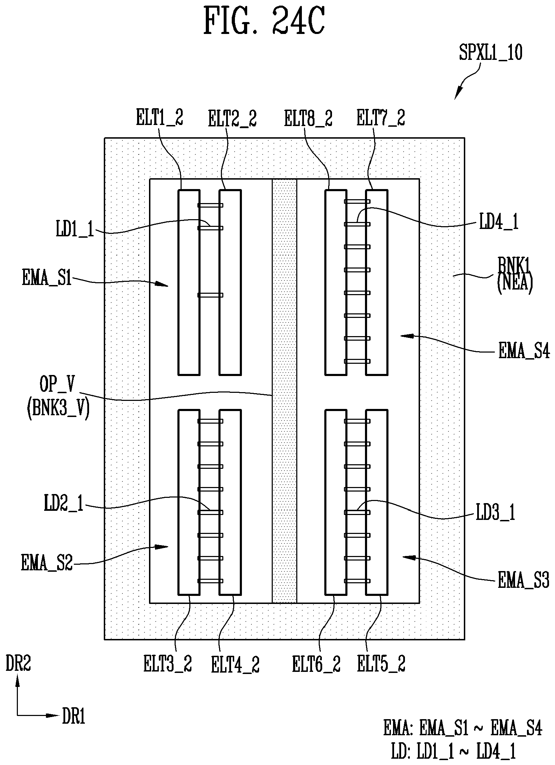

In another example, as shown in FIG. 24C, the first sub-pixel SPXL1_10 may include only the vertical opening OP_V or the vertical bank BNK3_V dividing the first and second sub-emission areas EMA_S1 and EMA_S2 and the third and fourth sub-emission areas EMA_S3 and EMA_S4.

According to an embodiment, the first sub-pixel SPXL1_10 may selectively include the horizontal opening OP_H, the vertical opening OP_V, the horizontal bank BNK3_H, and the vertical bank BNK3_V. For example, the first sub-pixel SPXL1_10 may include the horizontal opening OP_H shown in FIG. 24A or 24B and the vertical bank BNK3_V shown in FIG. 24C. In another example, the first sub-pixel SPXL1_10 may include the horizontal bank BNK3_H shown in FIG. 24A or 24B and the vertical opening OP_V shown in FIG. 24C.

As described above, the first sub-pixel SPXL1_10 may selectively include the opening OP_3 and the third bank BNK3_3. For example, the shape of the opening OP_3 and/or the shape of the third bank BNK3_3 included in the first sub-pixel SPXL1_10 may be variously changed.

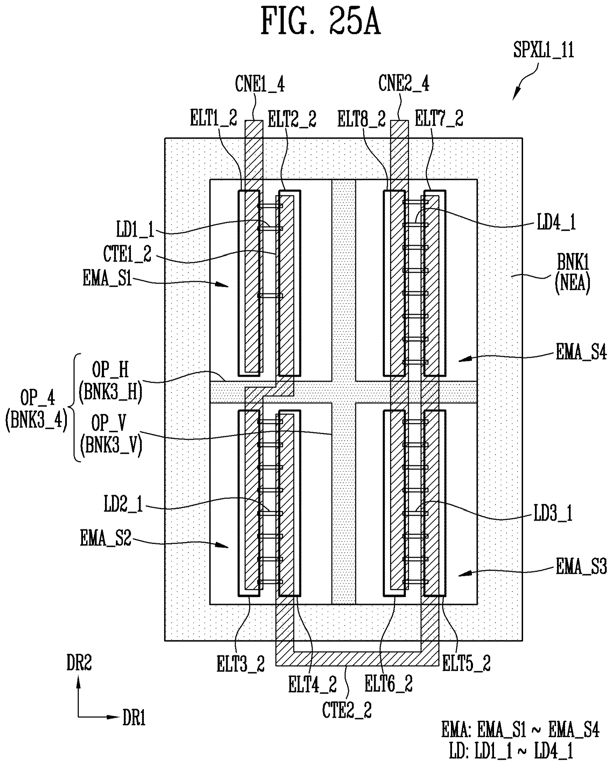

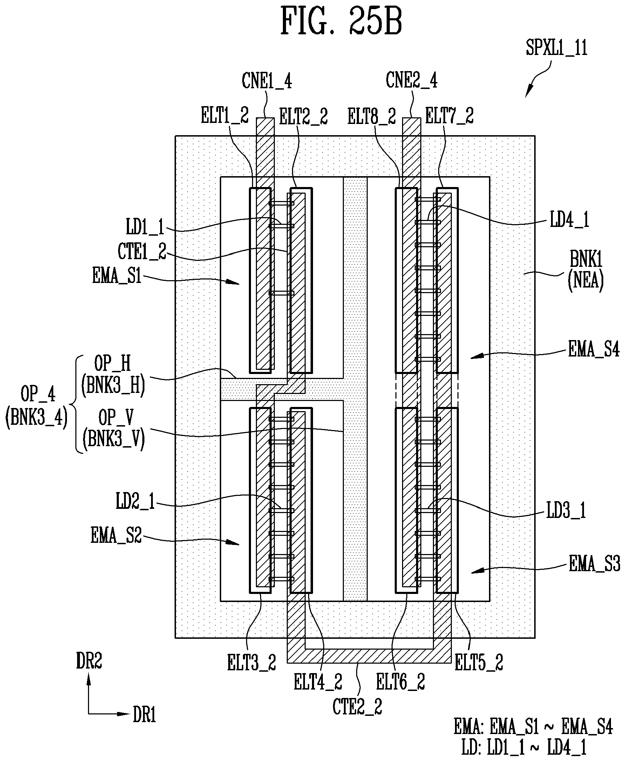

FIGS. 25A and 25B are schematic plan views illustrating an embodiment of the first sub-pixel included in the display device of FIG. 3. FIGS. 25A and 25B may correspond to FIG. 23B.

Referring to FIGS. 14B, 23B, 25A, and 25B, except for the second contact electrode CNE2_4, the second intermediate electrode CTE2_2, and an opening OP_4 (or a third bank BNK3_4), the first sub-pixel SPXL1_1 1 of FIGS. 25A and 25B may be substantially the same as or similar to the first sub-pixel SPXL1_10 of FIG. 23B. For example, the second contact electrode CNE2_4 and the second intermediate electrode CTE2_2 of FIGS. 25A and 25B may be substantially the same as or similar to the second contact electrode CNE2 and the second intermediate electrode CTE2_1 of FIG. 14B. Therefore, a redundant description is omitted for descriptive convenience.

The second intermediate electrode CTE2_2 may overlap the first end portion of the fourth light emitting element LD4_1 and the seventh electrode ELT7_2 in the fourth sub-emission area EMA_S4. The second intermediate electrode CTE2_2 may physically and/or electrically connect the second end portion of the second light emitting element LD2_1 and the first end portion of the fourth light emitting element LD4_1.

The second contact electrode CNE2_4 may overlap the second end portion of the third light emitting element LD3_1 and the sixth electrode ELT6_2 in the third sub-emission area EMA_S3.

The first light emitting element LD1_1, the second light emitting element LD2_1, and the third and fourth light emitting elements LD3_1 and LD4_1 may be connected to each other in series between the first and second contact electrodes CNE1_4 and CNE2_4 through the first and second intermediate electrodes CTE1_2 and CTE2_2. The first light emitting element LD1_1 may form a first series stage, the second light emitting element LD2_1 may form a second series stage, and the third and fourth light emitting elements LD3_1 and LD4_1 may form a third series stage.

According to an embodiment, as shown in FIG. 25B, the opening OP_4 or the third bank BNK3_4 may not be disposed between the third and fourth sub-emission areas EMA_S3 and EMA_S4. For example, the third and fourth sub-emission areas EMA_S3 and EMA_S4 may form one sub-emission area. The fifth electrode ELT5_2 and the seventh electrode ELT7_2 may be physically connected to each other, and may be integral with each other. For example, the sixth electrode ELT6_2 and the eighth electrode ELT8_2 may be physically connected to each other, and may be integral with each other.

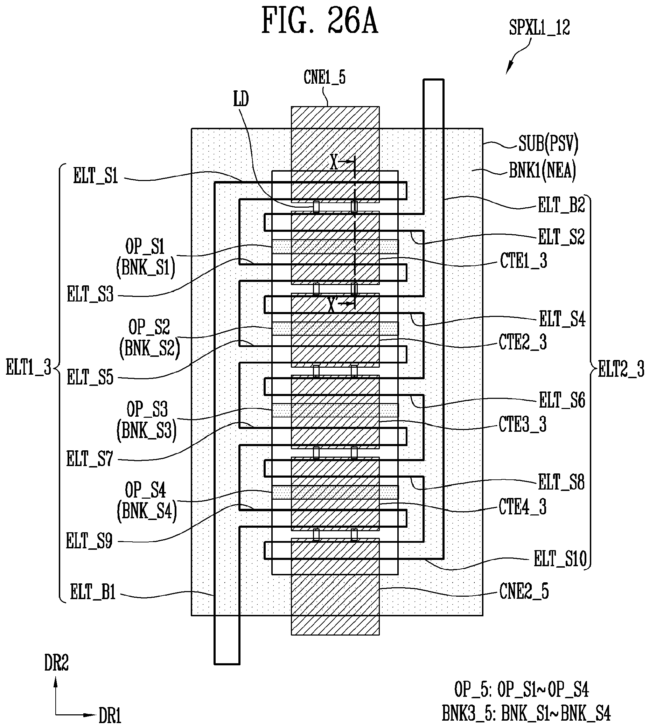

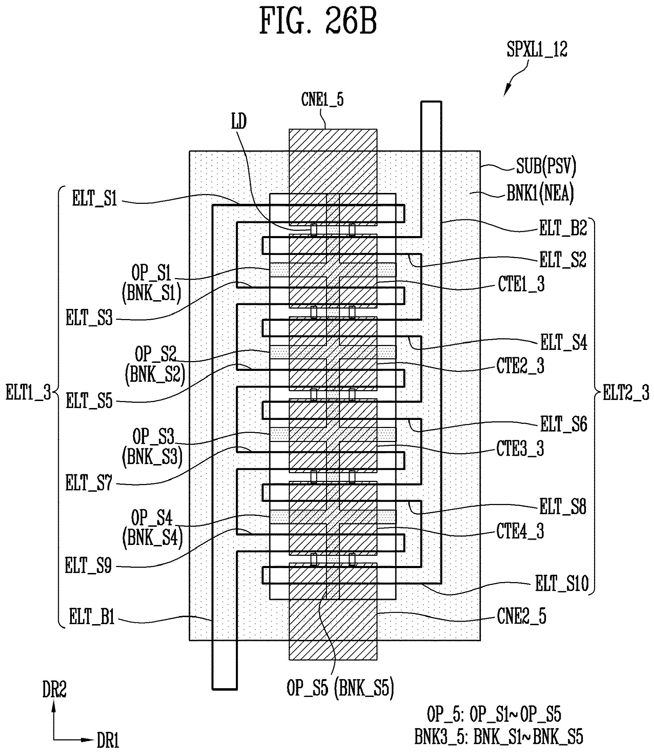

FIGS. 26A and 26B are schematic plan views illustrating an embodiment of the first sub-pixel included in the display device of FIG. 3.

Referring to FIGS. 3, 26A, and 26B, the first sub-pixel SPXL1_12 may include a first bank BNK1, first and second electrodes ELT1_3 and ELT2_3, and a light emitting element LD. For example, the first sub-pixel SPXL1_12 may include first and second contact electrodes CNE1_5 and CNE2_5 and intermediate electrodes CTE1_3 to CTE4_3.

Since the first bank BNK1, the first and second electrodes ELT1_3 and ELT2_3, the light emitting element LD, the first and second contact electrodes CNE1_5 and CNE2_5, and the intermediate electrodes CTE1_3 to CTE4_3 may be substantially the same or similar to the first bank BNK1, the electrodes ELT1 to ELT3, the light emitting element LD, the first and second contact electrodes CNE1 and CNE2, and the first intermediate electrode CTE1 of FIGS. 5 and 6, respectively, a redundant description is omitted for descriptive convenience.

The first electrode ELT1_3 may include a first body portion ELT_B1 and first, third, fifth, seventh, and ninth sub-electrodes ELT_S1, ELT_S3, ELT_S5, ELT_S7, and ELT_S9 (or electrodes). The first body portion ELT_B1 may extend in the second direction DR2. The first body portion ELT_B1 may overlap the first bank BNK1, but embodiments are not limited thereto. Each of the first, third, fifth, seventh, and ninth sub-electrodes ELT_S1, ELT_S3, ELT_S5, ELT_S7, and ELT_S9 may extend in the first direction DR1 from the first body portion ELT_B1, and may be sequentially arranged in the second direction DR2.

For example, the second electrode ELT2_3 may include a second body portion ELT_B2 and second, fourth, sixth, eighth, and tenth sub-electrodes ELT_S2, ELT_S4, ELT_S6, ELT_S8, ELT_S10 (or electrodes). The second body portion ELT_B2 may extend in the second direction DR2. The second body portion ELT_B2 may overlap the first bank BNK1, but embodiments are not limited thereto. Each of the second, fourth, sixth, eighth, and tenth sub-electrodes ELT_S2, ELT_S4, ELT_S6, ELT_S8, and ELT_S10 may extend in a direction opposite to the first direction DR1 from the second body portion ELT_B2, and may be sequentially arranged along the second direction DR2. The sub-electrodes ELT_S1 to ELT_S10 may be sequentially arranged along the second direction DR2. The first electrode ELT1_3 and the second electrode ELT2_3 may be symmetrical with respect to a center area of the opening (or the emission area) of the first bank BNK1. Sub-electrodes of the first electrode ELT1_3 and sub-electrodes of the second electrode ELT2_3 may be alternately arranged along the second direction DR2, and may provide a path (or a sub-emission area) where the light emitting element LD is positioned.

The first contact electrode CNE1_5 may overlap the first sub-electrode ELT_S1 and may be connected to the first end portion of the light emitting element LD adjacent to the first sub-electrode ELT_S1.

The first intermediate electrode CTE1_3 may overlap the second sub-electrode ELT_S2 and may be connected to the second end portion of the light emitting element LD adjacent to the second sub-electrode ELT_S2. For example, the first intermediate electrode CTE1_3 may overlap the third sub-electrode ELT_S3 and may be connected to the first end portion of the light emitting element LD adjacent to the third sub-electrode ELT_S3.

The second intermediate electrode CTE2_3 may overlap the fourth sub-electrode ELT_S4 and may be connected to the second end portion of the light emitting element LD adjacent to the fourth sub-electrode ELT_S4. For example, the second intermediate electrode CTE2_3 may overlap the fifth sub-electrode ELT_S5 and may be connected to the first end portion of the light emitting element LD adjacent to the fifth sub-electrode ELT_S5.

The third intermediate electrode CTE3_3 may overlap the sixth sub-electrode ELT_S6 and may be connected to the second end portion of the light emitting element LD adjacent to the sixth sub-electrode ELT_S6. For example, the third intermediate electrode CTE3_3 may overlap the seventh sub-electrode ELT_S7 and may be connected to the first end portion of the light emitting element LD adjacent to the seventh sub-electrode ELT_S7.

The fourth intermediate electrode CTE4_3 may overlap the eighth sub-electrode ELT_S8 and may be connected to the second end portion of the light emitting element LD adjacent to the eighth sub-electrode ELT_S8. For example, the fourth intermediate electrode CTE4_3 may overlap the ninth sub-electrode ELT_S9 and may be connected to the first end portion of the light emitting element LD adjacent to the ninth sub-electrode ELT_S9.

The second contact electrode CNE2_5 may overlap the tenth sub-electrode ELT_S10 and may be connected to the second end portion of the light emitting element LD adjacent to the tenth sub-electrode ELT_S10.

The light emitting elements LD may be connected to each other in series between the first and second contact electrodes CNE1_5 and CNE2_5 through the intermediate electrodes CTE1_3 to CTE4_3. The light emitting elements LD may form five series stages together with the intermediate electrodes CTE1_3 to CTE4_3 and the first and second contact electrodes CNE1_5 and CNE2_5.

According to an embodiment, the first sub-pixel SPXL1_12 may further include an opening OP_5 and/or a third bank BNK3_5. The opening OP_5 and/or the third bank BNK3_5 may divide sub-areas corresponding to the series stages.

In an embodiment, the opening OP_5 may include sub-openings OP_S1 to OP_S4. The sub-openings OP_S1 to OP_S4 may extend in the first direction DR1 and have a slit shape. The sub-openings OP_S1 to OP_S4 may correspond to the horizontal opening OP_H described with reference to FIG. 5 or the like. A first sub-opening OP_S1 may be formed between the second sub-electrode ELT_S2 and the third sub-electrode ELT_S3. A second sub-opening OP_S2 may be formed between the fourth sub-electrode ELT_S4 and the fifth sub-electrode ELT_S5. A third sub-opening OP_S3 may be formed between the sixth sub-electrode ELT_S6 and the seventh sub-electrode ELT_S7. A fourth sub-opening OP_S4 may be formed between the eighth sub-electrode ELT_S8 and the ninth sub-electrode ELT_S9.

In another example, the third bank BNK3_5 may include sub-banks BNK_S1 to BNK_S4. The sub-banks BNK_S1 to BNK_S4 may extend in the first direction DR1. The sub-banks BNK_S1 to BNK_S4 may correspond to the horizontal bank BNK3_H described with reference to FIG. 19A or the like.

A first sub-bank BNK_S1 may be formed between the second sub-electrode ELT_S2 and the third sub-electrode ELT_S3. The second sub-bank BNK_S2 may be formed between the fourth sub-electrode ELT_S4 and the fifth sub-electrode ELT_S5. The third sub-bank BNK_S3 may be formed between the sixth sub-electrode ELT_S6 and the seventh sub-electrode ELT_S7. The fourth sub-bank BNK_S4 may be formed between the eighth sub-electrode ELT_S8 and the ninth sub-electrode ELT_S9.

The light emitting element LD may be independently supplied to each of the five series stages by using the opening OP_5 (or a partial area of the organic insulating layer exposed by the opening OP_5 and having liquid repellancy) and/or the third bank BNK3_5, and the number of the light emitting elements LD may be uniformly controlled for each of series stages.

Since a cross-section of the first sub-pixel SPXL1_12 taken along a line X-X' of FIG. 26A is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_12 is omitted for descriptive convenience.

In an embodiment, the opening OP_5 may further include a fifth sub-opening OP_S5. As shown in FIG. 26B, the fifth sub-opening OP_S5 may extend in the second direction DR2. The fifth sub-opening OP_S5 may correspond to the vertical opening OP_V described with reference to FIG. 5 or the like. The fifth sub-opening OP_S5 may divide again each sub-area (e.g., the sub-area divided by the sub-openings OP_S1 to OP_S4).

In FIG. 26B, only a single fifth sub-opening OP_S5 is shown, but embodiments are not limited thereto. For example, the first sub-pixel SPXL1_12 may include fifth sub-openings OP_S5 arranged in the first direction DR1.

For example, in FIG. 26B, the sub-openings OP_S1 to OP_S4 may be integral with each other, but embodiments are not limited thereto. For example, similar to the horizontal opening OP_H described with reference to FIG. 5, the sub-openings OP_S1 to OP_S4 may be discontinuous in an area overlapping the sub-electrodes ELT_S1 to ELT_S10 or may include pattern layers spaced apart from each other. For example, the fifth sub-opening OP_S5 (or the opening OP_5) may extend as long as the sub-electrodes ELT_S1 to ELT_S10 are not physically separated.

For example, the third bank BNK3_5 may further include a fifth sub-bank BNK_S5. Since a disposition position and a function of the fifth sub-bank BNK_S5 are substantially the same as or similar to a disposition position and a function of the fifth sub-opening OP_S5, a redundant description is omitted for descriptive convenience.

In FIGS. 26A and 26B, each of the first and second electrodes ELT1_3 and ELT2_3 may include five sub-electrodes. For example, a total of five pairs of sub-electrodes are shown (therefore, the first sub-pixel SPXL1_12 is described as having five series stages), but embodiments are not limited thereto. For example, each of the first and second electrodes ELT1_3 and ELT2_3 may include two, three, four, six or more sub-electrodes, and the first sub-pixel SPXL1_12 may include two, three, four, six or more series stages corresponding thereto.

FIGS. 27A to 27C are schematic plan views illustrating an embodiment of the first sub-pixel included in the display device of FIG. 3.

Referring to FIGS. 3 and 27A to 27C, the first sub-pixel SPXL1_13 may include a first bank BNK1, electrodes ELT1_4 to ELT4_4, and a light emitting element LD. According to an embodiment, the first sub-pixel SPXL1_13 may include first and second contact electrodes CNE1_6 and CNE2_6 and first and second intermediate electrodes CTE1_6 and CTE2_6.

Since basic characteristics of the first bank BNK1, the electrodes ELT1_4 to ELT4_4, the light emitting element LD, the first and second contact electrodes CNE1_6 and CNE2_6, and the first and second intermediate electrodes CTE1_6 and CTE2_6 may be substantially the same as or similar to those of the first bank BNK1, the electrodes ELT1 to ELT3, the light emitting element LD, the first and second contact electrodes CNE1 and CNE2, and the first intermediate electrode CTE1 of FIGS. 5 and 6, respectively, except for a disposition thereof, a redundant description is omitted for descriptive convenience.

The first bank BNK1 may include a circular opening and may define a circular emission area EMA, but a shape of the opening of the first bank BNK1 is not limited thereto. For example, the opening of the first bank BNK1 may have a planar shape of a quadrangle, a rectangle, or the like.

A first electrode ELT1_4 may have a shape corresponding to the first bank BNK1.

A second electrode ELT2_4 may be positioned in an opening of the first electrode ELT1_4 and may be spaced apart from the first electrode ELT1_4 at a certain distance. The distance may correspond to a length of the light emitting element LD. The second electrode ELT2_4 may have a circular ring or a donut shape corresponding to the opening of the first electrode ELT1_4. However, embodiments are not limited thereto. For example, in case that the opening of the first electrode ELT1_4 has a quadrangular planar shape, the second electrode ELT2_4 may have a quadrangular planar shape. For example, the second electrode ELT2_4 is shown as having a closed loop, but embodiments are not limited thereto. A portion of the second electrode ELT2_4 may be cut, or the second electrode ELT2_4 may include sub-electrodes separated from each other.

The third electrode ELT3_4 may be positioned in an opening of the second electrode ELT2_4 and may be spaced apart from the second electrode ELT2_4 at a certain distance. The third electrode ELT3_4 may have a circular ring or a donut shape corresponding to the opening of the second electrode ELT2_4. However, embodiments are not limited thereto.

The fourth electrode ELT4_4 may be positioned in an opening of the third electrode ELT3_4 and may be spaced apart from the third electrode ELT3_4 at a certain distance. The fourth electrode ELT4_4 may have a circular planar shape corresponding to the opening of the third electrode ELT3_4.

The light emitting element LD may be positioned between adjacent electrodes among the electrodes ELT1_4 to ELT4_4.

The first contact electrode CNE1_6 may overlap the first electrode ELT1_4 and may be connected to the first end portion of the light emitting element LD adjacent to the first electrode ELT1_4.

The first intermediate electrode CTE1_6 may overlap the second electrode ELT2_4 and may be connected to the second end portion of the light emitting element LD between the first electrode ELT1_4 and the second electrode ELT2_4. For example, the first intermediate electrode CTE1_6 may be connected to the first end portion of the light emitting element LD between the second electrode ELT2_4 and the third electrode ELT3_4.

The second intermediate electrode CTE2_6 may overlap the third electrode ELT3_4 and may be connected to the second end portion of the light emitting element LD between the second electrode ELT2_4 and the third electrode ELT3_4. For example, the second intermediate electrode CTE2_6 may be connected to the first end portion of the light emitting element LD between the third electrode ELT3_4 and the fourth electrode ELT4_4.

The second contact electrode CNE2_6 may overlap the fourth electrode ELT4_4 and may be connected to the second end portion of the light emitting element LD adjacent to the fourth electrode ELT4_4.

The light emitting elements LD may be connected to each other in series between the first and second contact electrodes CNE1_6 and CNE2_6 through the first and second intermediate electrodes CTE1_6 and CTE2_6. The light emitting elements LD may form three series stages together with the first and second intermediate electrodes CTE1_6 and CTE2_6 and the first and second contact electrodes CNE1_6 and CNE2_6.

According to an embodiment, the first sub-pixel SPXL1_13 may include an opening OP_6 and/or a third bank BNK3_6. The opening OP_6 and/or the third bank BNK3_6 may divide the emission area EMA into first, second, and third sub-emission areas EMA_S1, EMA_S2, and EMA_S3 corresponding to the series stages.

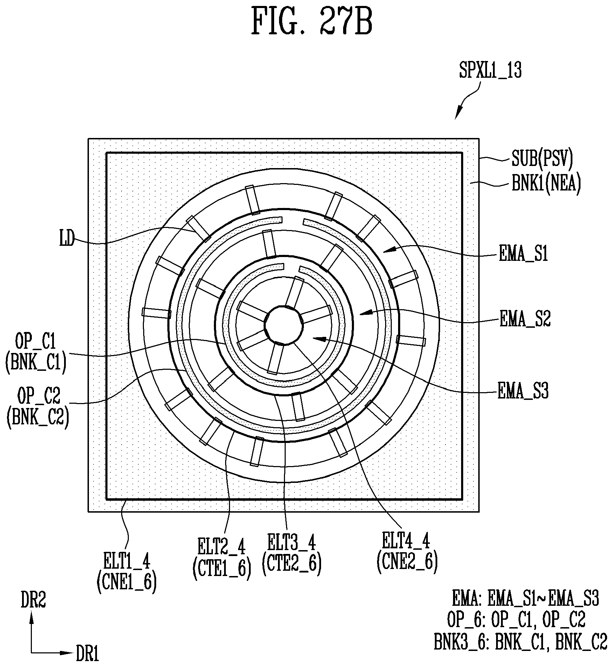

In an embodiment, the opening OP_6 may include first and second sub-openings OP_C1 and OP_C2 (or an opening of a ring shape). As shown in FIG. 27A, the first and second sub-openings OP_C1 and OP_C2 may extend in an extension direction of the second and third electrodes ELT2_4 and ELT3_4. The first sub-opening OP_C1 may overlap the second electrode ELT2_4, and the second sub-opening OP_C2 may overlap the third electrode ELT3_4. As shown in FIG. 27B, the opening OP_6 may include first sub-openings OP_C1 and/or second sub-openings OP_C2. For example, the first and second sub-openings OP_C1 and OP_C2 (or the opening OP_6) may extend as long as the second and third electrodes ELT2_4 and ELT3_4 are not physically separated.

In another example, the third bank BNK3_6 may include first and second sub-banks BNK_C1 and BNK_C2 (or a bank of a ring shape). Since a disposition position and a function of the first and second sub-banks BNK_C1 and BNK_C2 may be substantially the same as or similar to a disposition position and a function of the first and second sub-openings OP_C1 and OP_C2, a redundant description is omitted for descriptive convenience.

For example, a cross-section of the first sub-pixel SPXL1_13 taken along a line XII-XI' of FIG. 27A is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_13 is omitted for descriptive convenience.

In FIGS. 27A and 27B, a shape of the opening OP_6 and the third bank BNK3_6 is described as being substantially the same as a shape of the second and third electrodes ELT2_4 and ELT3_4, but embodiments are not limited thereto. The opening OP_6 and the third bank BNK3_6 may have a shape unrelated to the second and third electrodes ELT2_4 and ELT3_4.

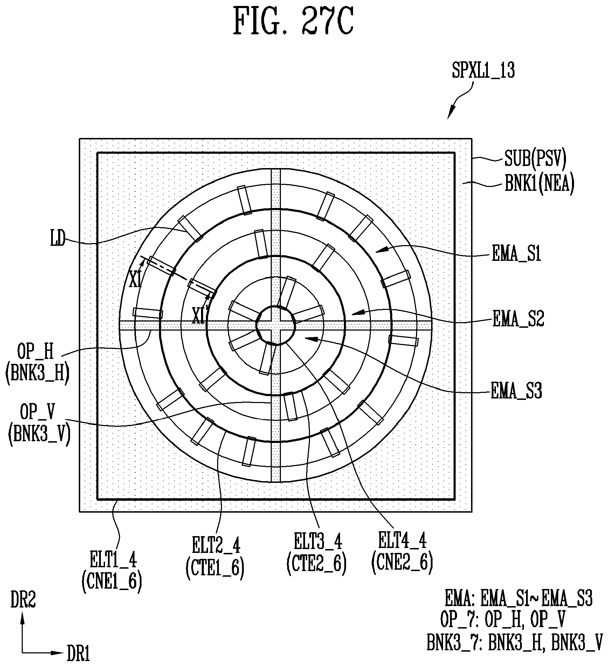

In embodiments, as shown in FIG. 27C, the first sub-pixel SPXL1_13 may include an opening OP_7 and/or a third bank BNK3_7. The opening OP_7 and/or the third bank BNK3_7 may divide the emission area EMA into sub-areas unrelated to series stages.

In an embodiment, the opening OP_7 may include a horizontal opening OP_H and/or a vertical opening OP_V. Since the horizontal opening OP_H and the vertical opening OP_V are described with reference to FIG. 5 or the like, a redundant description is omitted for descriptive convenience.

In FIG. 27C, the horizontal opening OP_H and/or the vertical opening OP_V may be integral with each other, but embodiments are not limited thereto. For example, similar to the description above with reference to FIG. 5, the horizontal opening OP_H and/or the vertical opening OP_V may be discontinuous in an area overlapping the electrodes ELT1_4 to ELT4_4, or may include pattern layers spaced apart from each other. For example, the opening OP_7 may extend as long as the electrodes ELT1_4 to ELT4_4 are not physically separated.

For example, the third bank BNK3_7 may include a horizontal bank BNK3_H and/or a vertical bank BNK3_V. Since the horizontal bank BNK3_H and/or the vertical bank BNK3_V are described with reference to FIG. 19A or the like, a redundant description is omitted for descriptive convenience.

In FIG. 27A and FIG. 27C, the first sub-pixel SPXL1_13 may include four electrodes ELT1_4 to ELT4_4 (and three series stages corresponding thereto), but embodiments are not limited thereto. For example, at least one of the third and fourth electrodes ELT3_4 and ELT4_4 may be omitted, or the first sub-pixel SPXL1_13 may further include at least one electrode (or at least one series stage) in addition to the four electrodes ELT1_4 to ELT4_4.

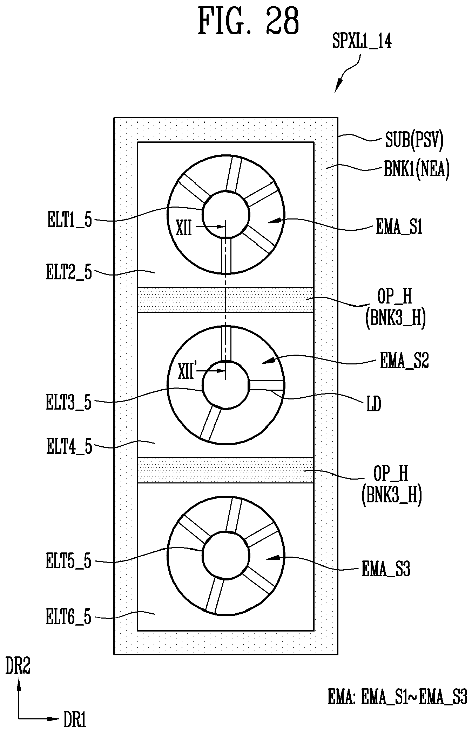

FIG. 28 is a schematic plan view illustrating an embodiment of the first sub-pixel included in the display device of FIG. 3.

Referring to FIGS. 22, 27A, and 28, except for a disposition of electrodes ELT1_5 to ELT6_5, the first sub-pixel SPXL1_14 of FIG. 28 may be substantially the same as or similar to the first sub-pixel SPXL1_9 of FIG. 22. Therefore, a redundant description is omitted for descriptive convenience.

The horizontal opening OP_H or the horizontal bank BNK3_H may divide a single emission area EMA into three sub-emission areas EMA_S1 to EMA_S3 (or sub-areas) along the second direction DR2.

A first electrode ELT1_5 may be disposed in the first sub-emission area EMA_S1. The first electrode ELT1_5 may be positioned in an opening of a second electrode ELT2_5 and may be spaced apart from the first electrode ELT1_5 by a certain distance. The first electrode ELT1_5 may have a circular planar shape corresponding to the opening of the second electrode ELT2_5. However, embodiments are not limited thereto. For example, in case that the opening of the second electrode ELT2_5 has a quadrangular planar shape, the first electrode ELT1_5 may have a quadrangular planar shape.

A third electrode ELT3_5 and a fourth electrode ELT4_5 may be disposed in the second sub-emission area EMA_S2. A third electrode ELT3_5 and a fourth electrode ELT4_5 may be substantially the same as the first electrode ELT1_5 and the second electrode ELT2_5.

A fifth electrode ELT5_5 and a sixth electrode ELT6_5 may be disposed in the third sub-emission area EMA_S3. The fifth electrode ELT5_5 and the sixth electrode ELT6_5 may be substantially the same as the first electrode ELT1_5 and the second electrode ELT2_5.

Since the first, second, and third sub-emission areas EMA_S1, EMA_S2, and EMA_S3 are distinguished from each other by the horizontal opening OP_H (or the partial area of the organic insulating layer exposed by the horizontal opening OP_H and having liquid repellancy) or the horizontal bank BNK3_H, the light emitting element LD may be independently supplied to each of the first, second, and third sub-emission areas EMA_S1, EMA_S2, and EMA_S3, and the number of the light emitting element LD may be uniformly controlled for each of sub-emission areas.

Since a cross-section of the first sub-pixel SPXL1_14 taken along a line XII-XII' of FIG. 28 is substantially the same as or similar to the cross-section of at least one of FIGS. 7A, 7B, 8A to 8D, 9A, 9B, 13C, 16A, 16B, and 18, a description of the cross-section (or a stack structure) of the first sub-pixel SPXL1_14 is omitted for descriptive convenience.

In FIG. 28, the first sub-pixel SPXL1_14 may include only the horizontal opening OP_H or the horizontal bank BNK3_H dividing the sub-emission areas EMA_S1 to EMA_S3, but embodiments are not limited thereto. For example, the embodiments described with reference to FIGS. 27A to 27C may be applied to each of the sub-emission areas EMA_S1 to EMA_S3 of FIG. 28.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

The present invention may be defined by reference to the following clauses:
Clause 1. A display device comprising:
   an organic layer;
   a first electrode and a second electrode disposed on the organic layer and spaced apart from each other;
   a first insulating layer disposed on the first electrode and the second electrode; and
   first light emitting elements positioned between the first electrode and the second electrode on the first insulating layer,
   wherein an opening passing through the first insulating layer and at least one of the first electrode and the second electrode to expose the organic layer is formed.
Clause 2. The display device according to clause 1, wherein the opening passes through at least one of the first electrode and the second electrode and the first insulating layer between the first electrode and the second electrode.
Clause 3. The display device according to clause 1 or clause 2, further comprising:
   a first contact electrode covering a first end of the first light emitting elements; and
   a second contact electrode covering a second end of the first light emitting elements.
Clause 4. The display device according to any one of clauses 1 to 3, wherein a surface of the organic layer exposed by the opening is liquid repellant.
Clause 5. The display device according to clause 4, wherein the surface of the organic layer includes a fluoro group.
Clause 6. The display device according to any one of clauses 1 to 5, further comprising:
   a bank defining an emission area,
   wherein the opening divides the emission area into a plurality of sub-areas.
Clause 7. The display device according to any one of clauses 1 to 6, wherein a first opening exposing the organic layer is formed in the second electrode,
   wherein a second opening overlapping the first opening is formed in the first insulating layer, and
   wherein the opening is defined by an overlap of the first opening and the second opening.
Clause 8. The display device according to clause 7, wherein a side surface of the second electrode and a side surface of the first insulating layer are aligned in the opening.
Clause 9. The display device according to clause 7 or clause 8, further comprising:
   a second insulating pattern disposed on the first light emitting elements,
   wherein the second insulating pattern contacts the organic layer in the opening.
Clause 10. The display device according to any one of clauses 7 to 9, wherein the second opening of the first insulating layer is less than the first opening of the second electrode, and
   the first insulating layer covers the second electrode in the opening.
Clause 11. The display device according to any one of clauses 7 to 10, wherein the second electrode is partially exposed by the second opening of the first insulating layer.
Clause 12. The display device according to any one of clauses 7 to 11, wherein the first light emitting elements are arranged along an extension direction of the first and second electrodes, and
   wherein the first opening of the second electrode includes at least one slit that extends in a direction crossing the extension direction and partially cuts the second electrode.
Clause 13. The display device according to clause 12, wherein the at least one slit of the second electrode is positioned on a side facing the first electrode.
Clause 14. The display device according to clause 12 or clause 13, wherein the opening includes a plurality of slits formed in the second electrode along the extension direction.
Clause 15. The display device according to any one of clauses 1 to 14, further comprising:
   a first bank pattern disposed between the organic layer and the first electrode; and
   a second bank pattern disposed between the organic layer and the second electrode,
   wherein at least one of the first and second bank patterns is further exposed by the opening.
Clause 16. The display device according to clause 15, wherein a surface of at least one of the first and second bank patterns exposed by the opening is liquid repellant.
Clause 17. The display device according to any one of clauses 1 to 16, further comprising:
   a third electrode disposed on the organic layer and spaced apart from the second electrode; and
   second light emitting elements positioned between the second electrode and the third electrode.
Clause 18. The display device according to clause 17, wherein the opening includes a second slit extending along an extension direction of the first to third electrodes and passing through the second electrode.
Clause 19. The display device according to any one of clauses 1 to 18, further comprising:
   a color conversion layer disposed on the first light emitting elements and emitting light by converting a wavelength band of light incident from the first light emitting elements; and
   a color filter disposed on the color conversion layer.
Clause 20. A display device comprising:
   a bank defining an emission area;
   a first electrode and a second electrode spaced apart from each other in the emission area;
   an auxiliary bank disposed across the first electrode and the second electrode and dividing the emission area into at least two sub-areas;
   first light emitting elements positioned between the first electrode and the second electrode;
   a first contact electrode covering a first end of the first light emitting elements in the at least two sub-areas; and
   a second contact electrode covering a second end of the first light emitting elements in the at least two sub-areas.
Clause 21. The display device according to clause 20, wherein a height of an upper surface of the auxiliary bank is equal to a height of an upper surface of the bank.
Clause 22. The display device according to clause 20 or clause 21, wherein a height of an upper surface of the auxiliary bank is different from a height of an upper surface of the bank.
Clause 23. The display device according to clause 22, wherein the height of the upper surface of the auxiliary bank is lower than the height of the upper surface of the bank.
Clause 24. The display device according to any one of clauses 20 to 23, wherein the auxiliary bank is disposed on the bank.
Clause 25. A display device comprising:
   an organic layer;
   a first electrode, a second electrode, a third electrode, and a fourth electrode disposed on the organic layer, extending in a first direction, and sequentially arranged in a second direction;
   a first insulating layer disposed on the first to fourth electrodes;
   first light emitting elements positioned between the first electrode and the second electrode on the first insulating layer; and
   second light emitting elements positioned between the third electrode and the fourth electrode on the first insulating layer,
   wherein an opening passing through the first insulating layer to expose the organic layer between the second electrode and the third electrode is formed.

## Claims

1. A display device comprising:
an organic layer;
a first electrode and a second electrode disposed on the organic layer and spaced apart from each other;
a first insulating layer disposed on the first electrode and the second electrode; and
first light emitting elements disposed on the first insulating layer and disposed between the first electrode and the second electrode,
wherein an opening is formed by passing through the first insulating layer and at least one of the first electrode and the second electrode and exposes the organic layer.

2. The display device according to claim 1, wherein the opening passing through the first insulating layer and the at least one of the first electrode extends between the first electrode and the second electrode in a plan view.

3. The display device according to claim 1 or claim 2, further comprising:
a first contact electrode covering first end portions of the first light emitting elements; and
a second contact electrode covering second end portions of the first light emitting elements.

4. The display device according to any one of claims 1 to 3, further comprising:
a bank defining an emission area,
wherein the opening divides the emission area into a plurality of sub-areas,
wherein a surface of the organic layer exposed by the opening is liquid repellant, and
wherein the surface of the organic layer includes a fluoro group.

5. The display device according to any one of claims 1 to 4, wherein the opening includes:
a first opening formed in the second electrode and exposing the organic layer, and
a second opening formed in the first insulating layer and overlapping the first opening.

6. The display device according to claim 5, wherein a side surface of the second electrode and a side surface of the first insulating layer are aligned with each other in the opening.

7. The display device according to claim 5 or claim 6, further comprising:
a second insulating pattern layer disposed on the first light emitting elements,
wherein the second insulating pattern layer contacts the organic layer in the opening.

8. The display device according to any one of claims 5 to 7, wherein
a width of the second opening of the first insulating layer is smaller than a width of the first opening of the second electrode, and
the first insulating layer covers a side surface of the second electrode in the opening.

9. The display device according to any one of claims 5 to 8, wherein the second electrode is partially exposed by the second opening of the first insulating layer.

10. The display device according to any one of claims 5 to 9, wherein the first light emitting elements are arranged along an extension direction of the first and second electrodes,
wherein the first opening of the second electrode includes at least one slit that extends in a direction intersecting the extension direction of the first and second electrodes and is formed by partially cutting the second electrode,
wherein the at least one slit of the second electrode is disposed on a side of the second electrode facing the first electrode, and
wherein the opening includes a plurality of slits formed in the second electrode along the extension direction.

11. The display device according to any one of claims 1 to 10, wherein the organic layer further comprises:
a first bank pattern layer disposed between a protective layer and the first electrode; and
a second bank pattern layer disposed between the protective layer and the second electrode,
wherein at least one of the first and second bank pattern layers is further exposed by the opening, and
wherein a surface of at least one of the first and second bank pattern layers exposed by the opening is liquid repellant.

12. The display device according to any one of claims 1 to 11, further comprising:
a third electrode disposed on the organic layer and spaced apart from the second electrode; and
second light emitting elements disposed between the second electrode and the third electrode,
wherein the opening includes a second slit extending along an extension direction of the first to third electrodes and passing through the second electrode.

13. The display device according to any one of claims 1 to 12, further comprising:
a color conversion layer disposed on the first light emitting elements and emitting light by converting a wavelength band of light incident from the first light emitting elements; and
a color filter disposed on the color conversion layer.

14. A display device comprising:
a bank defining an emission area;
a first electrode and a second electrode spaced apart from each other in the emission area;
an auxiliary bank disposed across the first electrode and the second electrode and dividing the emission area into at least two sub-areas;
first light emitting elements disposed between the first electrode and the second electrode;
a first contact electrode covering first end portions of the first light emitting elements in the at least two sub-areas; and
a second contact electrode covering second end portions of the first light emitting elements in the at least two sub-areas.

15. The display device according to claim 14, wherein the auxiliary bank is disposed on the bank.
